# EUROPEAN PATENT APPLICATION

(11) **EP 4 636 051 A1**
(43) Date of publication of application: **22.10.2025**
(21) Application number: 23903484.6
(22) Date of filing: 11.12.2023
(51) Int. Cl.: C09K 3/00, C09J 7/30, C09J 7/40, C09J 161/06, C09J 163/00, C09J 201/00, H01L 21/02, H01L 21/301, H01L 21/304, H01L 21/683

(54) **RELEASER COMPOSITION FOR PHOTOIRRADIATION RELEASE, AND ADHESIVE COMPOSITION FOR PHOTOIRRADIATION RELEASE**

(30) Priority: 14.12.2022 JP 2022199431; 13.09.2023 JP 2023148736
(71) Applicant: Nissan Chemical Corporation, Tokyo 103-6119 (JP)
(72) Inventor: YANAI Masaki, Toyama-shi, Toyama 939-2792 (JP); SHINJO Tetsuya, Toyama-shi, Toyama 939-2792 (JP); OKUNO Takahisa, Toyama-shi, Toyama 939-2792 (JP)
(74) Representative: Hoffmann Eitle
(86) International application number: PCT/JP2023/044256
(87) International publication number: WO 2024/128199

(57) **Abstract**

A release agent composition for light irradiation release or an adhesive composition for light irradiation release, contains
a Novolac resin having at least one of a hydroxy group directly bonded to an aromatic ring and a carboxy group directly bonded to an aromatic ring, and
a siloxane backbone-containing epoxy resin, and
a solvent.

## Description

### Technical Field

The present invention relates to a release agent composition for light irradiation release, an adhesive composition for light irradiation release, a laminate, and a method for manufacturing a processed semiconductor substrate or electronic device layer.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technology of integrating multiple layer while connecting the layers by a through silicon via (TSV). At the time of multilayer integration, respective wafers to be integrated are thinned by polishing on the side opposite to the formed circuit surface (that is, the back surface), and the thinned semiconductor wafers are laminated.

A pre-thinned semiconductor wafer (also referred to herein simply as a wafer) is adhered to a support in order to be polished with a polishing apparatus. The adhesion at that time need to be easily released after polishing, and therefore is referred to as temporary adhesion. This temporary adhesion must allow for easy removal from the support. Otherwise, the thinned semiconductor wafer may be cut or deformed when a large force is applied for the removal. The removal is easily performed such that such a situation does not occur. On the other hand, at the time of polishing the back surface of the semiconductor wafer, it is not preferable that the semiconductor wafer is detached or displaced due to polishing stress. Therefore, the performance required for temporary adhesion is to withstand the stress during polishing and to allow for easy removal after polishing.

For example, there is a demand for a performance having a high stress (strong adhesion force) in the planar direction at the time of polishing and a low stress (weak adhesion force) in the longitudinal direction at the time of removal.

Although methods by irradiation with a laser has been disclosed for such adhesion and separation processes (for example, refer to Patent Literatures 1 and 2), new technologies related to release by irradiation with light such as a laser is always required with further progress in the recent semiconductor field.

The present applicant has proposed a laminate for allowing for processing of a workpiece, the laminate including an intermediate layer adhered between a support and the workpiece to be releasable, in which the intermediate layer includes at least a release layer in contact with the support side, and the release layer includes a Novolac resin that is altered by absorbing light having a wavelength of 190 nm to 600 nm emitted through the support (refer to Patent Literature 3).

### Citation List

### Patent Literature

Patent Literature 1: JP 2004-64040 A
Patent Literature 2: JP 2012-106486 A
Patent Literature 3: WO 2019/088103 A

### Summary of Invention

### Technical Problem

In a method for release by irradiation with light, after a semiconductor substrate such as a semiconductor wafer is processed, a release agent layer is altered by irradiation with light to facilitate release of the semiconductor substrate from a support substrate. Since foreign matter such as an adhesive layer, a release agent layer, and residues thereof may attach to the surface of the semiconductor substrate and/or the support substrate after release, the semiconductor substrate and/or the support substrate is cleaned. However, depending on the type of the release agent layer, foreign matter on the semiconductor substrate and the support substrate is hardly removed, and thus cleaning may be difficult.

In addition, according to the technology of Patent Literature 3, the release agent layer is altered by irradiation with light to facilitate release of the semiconductor substrate from the support substrate.

However, it has not been studied to alter the adhesive layer by irradiation with light to facilitate the release of the semiconductor substrate from the support substrate. However, depending on the type of the adhesive layer, foreign matter on the semiconductor substrate and the support substrate is hardly removed, and thus cleaning may be difficult.

The present invention has been made in view of the above circumstances, and an object thereof is to provide a release agent composition for light irradiation release in which a release agent layer having not only excellent releasability but also excellent cleanability can be formed, a laminate using the release agent composition, and a method for manufacturing a processed semiconductor substrate or electronic device layer.

In addition, the present invention has been made in view of the above circumstances, and an object thereof is to provide an adhesive composition for light irradiation release in which an adhesive layer having not only excellent releasability but also excellent cleanability can be formed, a laminate using the adhesive composition, and a method for manufacturing a processed semiconductor substrate or electronic device layer.

### Solution to Problem

As a result of intensive studies to solve the above-mentioned problems, the present inventors found that the above-mentioned problems can be solved, and completed the present invention having the following gist.

That is, the present invention includes the following.
[1] A release agent composition for light irradiation release or an adhesive composition for light irradiation release, contains
   a Novolac resin having at least one of a hydroxy group directly bonded to an aromatic ring and a carboxy group directly bonded to an aromatic ring, and
   a siloxane backbone-containing epoxy resin, and
   a solvent.
[2] The release agent composition or the adhesive composition according to [1], in which the Novolac resin contains at least one of a structural unit represented by Formula (C1-1) below, a structural unit represented by Formula (1-2) below, and a structural unit represented by Formula (C1-3) below, 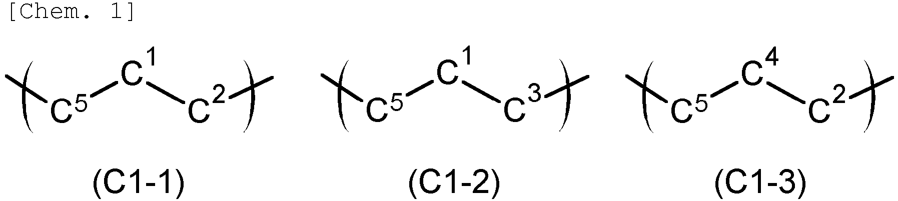
   in the formula, C¹ represents a group derived from an aromatic compound containing a nitrogen atom,
   C² represents a group containing a tertiary carbon atom or a quaternary carbon atom having at least one selected from the group consisting of a secondary carbon atom, a quaternary carbon atom, and an aromatic ring in a side chain, or represents a methylene group,
   C³ represents a group derived from an aliphatic polycyclic compound,
   C⁴ represents a group derived from phenol, a group derived from bisphenol, a group derived from naphthol, a group derived from biphenyl, or a group derived from biphenol,
   C⁵ represents a single bond or a group having a structure derived from styrene,
   in Formula (C1-1), at least one of C¹, C², and C⁵ has at least one of a hydroxy group directly bonded to an aromatic ring and a carboxy group directly bonded to an aromatic ring,
   in Formula (C1-2), at least one of C¹, C³, and C⁵ has at least one of a hydroxy group directly bonded to an aromatic ring and a carboxy group directly bonded to an aromatic ring, and
   in Formula (C1-3), at least one of C², C⁴, and C⁵ has at least one of a hydroxy group directly bonded to an aromatic ring and a carboxy group directly bonded to an aromatic ring.
[3] The release agent composition or the adhesive composition according to [2], in which the Novolac resin contains, as the structural unit represented by the Formula (C1-1), at least one of a structural unit represented by Formula (C1-1-1) below and a structural unit represented by Formula (C1-1-2) below, 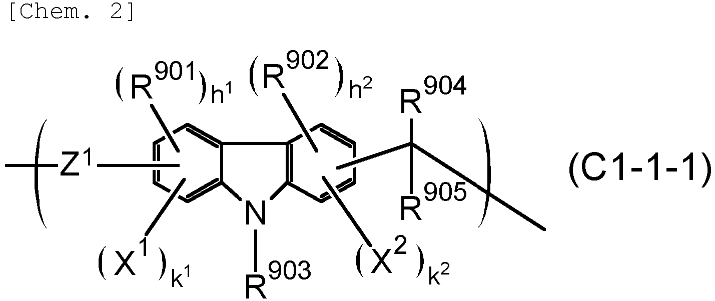 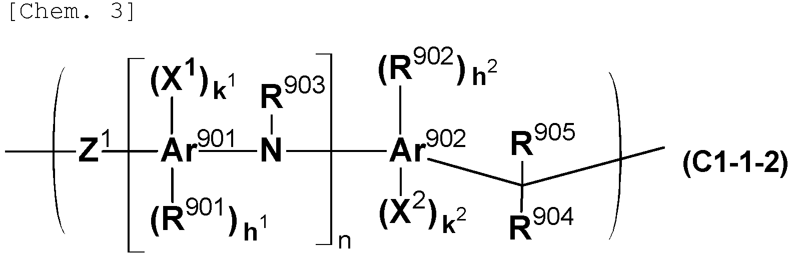
   in Formulas (C1-1-1) and (C1-1-2), R⁹⁰¹ and R⁹⁰² represent a substituent substituted with a ring, and each independently represent a halogen atom, a nitro group, a cyano group, an amino group, an optionally substituted alkyl group, an optionally substituted alkenyl group, or an optionally substituted aryl group,
   R⁹⁰³ represents a hydrogen atom, an optionally substituted alkyl group, an optionally substituted alkenyl group, or an optionally substituted aryl group,
   R⁹⁰⁴ represents a hydrogen atom, an optionally substituted aryl group, or an optionally substituted heteroaryl group,
   R⁹⁰⁵ represents an optionally substituted alkyl group, an optionally substituted aryl group, or an optionally substituted heteroaryl group,
   the group of R⁹⁰⁴ and the group of R⁹⁰⁵ may be bonded to each other to form a divalent group,
   Ar⁹⁰¹ and Ar⁹⁰² each independently represent an aromatic ring,
   X¹ and X² each independently represent a hydroxy group or a carboxy group,
   Z¹ represents a single bond or a group having a structure derived from styrene,
   h¹ and h² each independently represent an integer of 0 to 3,
   k¹ and k² each independently represent an integer of 0 to 3,
   the sum of h¹ and k¹ is 3 or less, and the sum of h² and k² is 3 or less,
   n represents an integer of 1 or 2, and
   here, the structural unit represented by Formula (C1-1-1) and the structural unit represented by Formula (C1-1-2) each independently have at least one of a hydroxy group directly bonded to an aromatic ring and a carboxy group directly bonded to an aromatic ring.
[4] The release agent composition or the adhesive composition according to [2], in which the Novolac resin contains a structural unit represented by Formula (C1-3-1) below as the structural unit represented by the Formula (C1-3), 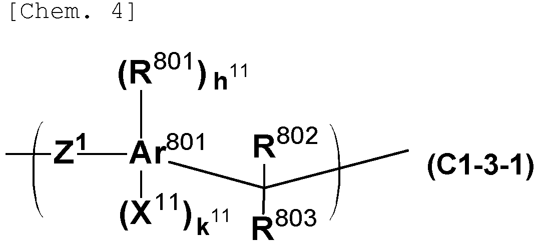
   in Formula (C1-3-1), R⁸⁰¹ represents a substituent substituted with a ring, and each independently represents a halogen atom, a nitro group, a cyano group, an amino group, an optionally substituted alkyl group, an optionally substituted alkenyl group, or an optionally substituted aryl group,
   R⁸⁰² represents a hydrogen atom, an optionally substituted aryl group, or an optionally substituted heteroaryl group,
   R⁸⁰³ represents a hydrogen atom, an optionally substituted alkyl group, an optionally substituted aryl group, or an optionally substituted heteroaryl group,
   the group of R⁸⁰² and the group of R⁸⁰³ may be bonded to each other to form a divalent group,
   Ar⁸⁰¹ represents a benzene ring, a naphthalene ring, or a biphenyl structure,
   X¹¹ represents a hydroxy group or a carboxy group,
   Z¹ represents a single bond or a group having a structure derived from styrene,
   h¹¹ each independently represents an integer of 0 to 4,
   k¹¹ each independently represents an integer of 0 to 4,
   when Ar⁸⁰¹ is a benzene ring, the sum of h¹¹ and k¹¹ is 4 or less, when Ar⁸⁰¹ is a naphthalene ring, the sum of h¹¹ and k¹¹ is 6 or less, and when Ar⁸⁰¹ has a biphenyl structure, the sum of h¹¹ and k¹¹ is 8 or less, and
   here, the structural unit represented by Formula (C1-3-1) has at least one of a hydroxy group directly bonded to an aromatic ring and a carboxy group directly bonded to an aromatic ring.
[5] The release agent composition or the adhesive composition according to any one of [1] to [4], in which the siloxane backbone-containing epoxy resin has a structure represented by Formula (A) below, 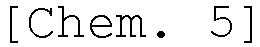 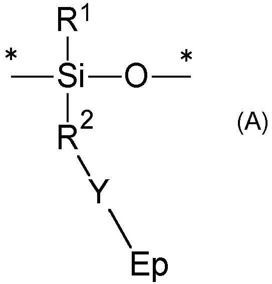 in Formula (A), R¹ represents a substituted or unsubstituted alkyl group, a substituted or unsubstituted alkenyl group, or a substituted or unsubstituted aryl group, R² represents an alkylene group having 1 to 10 carbon atoms, Y represents a single bond or -O-, Ep represents a group represented by Formula (A-1) or (A-2) below, and * represents a bond, and 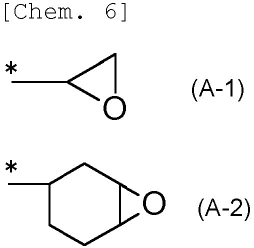 in Formula (A-1) and Formula (A-2), * represents a bond.
[6] The release agent composition or the adhesive composition according to any one of [1] to [4], in which the siloxane backbone-containing epoxy resin is represented by any one of Formulas (SE1) to (SE3) below, 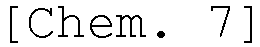 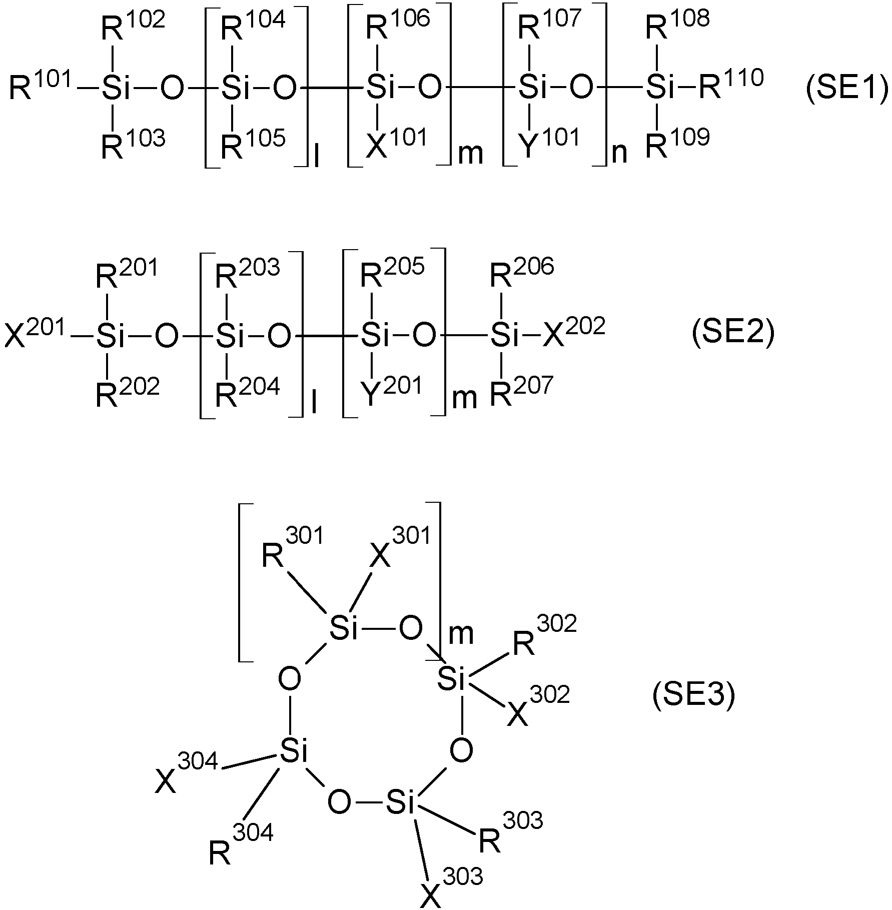 in Formula (SE1), R¹⁰¹ to R¹¹⁰ each independently represent a substituted or unsubstituted alkyl group, a substituted or unsubstituted alkenyl group, or a substituted or unsubstituted aryl group, X¹⁰¹ represents a group represented by Formula (EA) below, Y¹⁰¹ represents a hydrogen atom, a hydroxy group, or a monovalent group having 1 to 30 carbon atoms (here, Y¹⁰¹ is different from X¹⁰¹), l represents 0 or an integer of 1 or more, m represents an integer of 1 or more, and n represents 0 or an integer of 1 or more,
   in Formula (SE2), R²⁰¹ to R²⁰⁷ each independently represent a substituted or unsubstituted alkyl group, a substituted or unsubstituted alkenyl group, or a substituted or unsubstituted aryl group, X²⁰¹ and X²⁰² each independently represent a group represented by Formula (EA) below, Y²⁰¹ represents a hydrogen atom, a hydroxy group, or a monovalent group having 1 to 30 carbon atoms, l represents 0 or an integer of 1 or more, and m represents 0 or an integer of 1 or more,
   in Formula (SE3), R³⁰¹ to R³⁰⁴ each independently represent a substituted or unsubstituted alkyl group, a substituted or unsubstituted alkenyl group, or a substituted or unsubstituted aryl group, X³⁰¹ to X³⁰⁴ each independently represent a group represented by Formula (EA) below, and m represents an integer of 1 to 3, 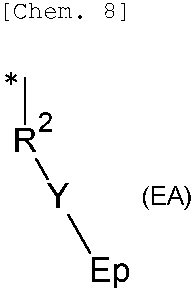
   in Formula (EA), R² represents an alkylene group having 1 to 10 carbon atoms, Y represents a single bond or -O-, Ep represents a group represented by Formula (A-1) or (A-2) below, and * represents a bond, and 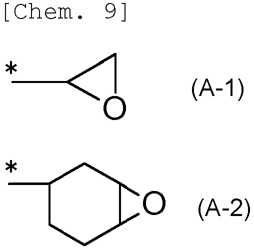
   in Formula (A-1) and Formula (A-2), * represents a bond.
[7] The release agent composition or the adhesive composition according to any one of [1] to [6], in which a content of the siloxane backbone-containing epoxy resin is 5% by mass to 40% by mass with respect to the Novolac resin.
[8] A laminate including:
   a semiconductor substrate or an electronic device layer;
   a light-transmissive support substrate; and
   a release agent layer provided between the semiconductor substrate or the electronic device layer and the support substrate, in which
   the release agent layer is a release agent layer formed from the release agent composition according to any one of [1] to [7].
[9] The laminate according to [8], further including an adhesive layer provided between the semiconductor substrate or the electronic device layer and the support substrate.
[10] A method for manufacturing a processed semiconductor substrate or electronic device layer, the method including:
   Step 5A of processing the semiconductor substrate of the laminate according to claim 8, or Step 5B of processing the electronic device layer of the laminate according to [8]; and
   Step 6A of separating the semiconductor substrate processed in the Step 5A and the support substrate from each other, or Step 6B of separating the electronic device layer processed in the Step 5B and the support substrate from each other.
[11] The method for manufacturing a processed semiconductor substrate or electronic device layer according to [10], in which the Step 6A or Step 6B includes a step of irradiating the laminate with a laser from the support substrate side.
[12] A laminate including:
   a semiconductor substrate or an electronic device layer;
   a light-transmissive support substrate; and
   an adhesive layer provided between the semiconductor substrate or the electronic device layer and the support substrate, in which
   the adhesive layer is an adhesive layer formed from the adhesive composition according to any one of [1] to [7].
[13] A method for manufacturing a processed semiconductor substrate or electronic device layer, the method including:
   Step 5A of processing the semiconductor substrate of the laminate according to [12], or Step 5B of processing the electronic device layer of the laminate according to [12]; and
   Step 6A of separating the semiconductor substrate processed in the Step 5A and the support substrate from each other, or Step 6B of separating the electronic device layer processed in the Step 5B and the support substrate from each other.
[14] The method for manufacturing a processed semiconductor substrate or electronic device layer according to [13], in which the Step 6A or Step 6B includes a step of irradiating the laminate with a laser from the support substrate side.

### Advantageous Effects of Invention

According to the present invention, it is possible to provide a release agent composition for light irradiation release in which a release agent layer having not only excellent releasability but also excellent cleanability can be formed, a laminate using the release agent composition, and a method for manufacturing a processed semiconductor substrate or electronic device layer.

In addition, according to the present invention, it is possible to provide an adhesive composition for light irradiation release in which an adhesive layer having not only excellent releasability but also excellent cleanability can be formed, a laminate using the adhesive composition, and a method for manufacturing a processed semiconductor substrate or electronic device layer.

### Brief Description of Drawings

Fig. 1 is a schematic cross-sectional view of an example of a laminate according to a first embodiment A.
Fig. 2A is a schematic cross-sectional view for describing a method for manufacturing a laminate showing an example according to the first embodiment A (part 1).
Fig. 2B is a schematic cross-sectional view for describing a method for manufacturing a laminate showing an example according to the first embodiment A (part 2).
Fig. 2C is a schematic cross-sectional view for describing a method for manufacturing a laminate showing an example according to the first embodiment A (part 3).
Fig. 3 is a schematic cross-sectional view of an example of a laminate according to a second embodiment A.
Fig. 4 is a schematic cross-sectional view of another example of the laminate according to the second embodiment A.
Fig. 5A is a schematic cross-sectional view for describing a method for manufacturing a laminate showing an example according to the second embodiment A (part 1).
Fig. 5B is a schematic cross-sectional view for describing a method for manufacturing a laminate showing an example according to the second embodiment A (part 2).
Fig. 5C is a schematic cross-sectional view for describing a method for manufacturing a laminate showing an example according to the second embodiment A (part 3).
Fig. 5D is a schematic cross-sectional view for describing a method for manufacturing a laminate showing an example according to the second embodiment A (part 4).
Fig. 6A is a schematic cross-sectional view for describing a method for processing a laminate showing an example according to the first embodiment A (part 1).
Fig. 6B is a schematic cross-sectional view for describing a method for processing a laminate showing an example according to the first embodiment A (part 2).
Fig. 6C is a schematic cross-sectional view for describing a method for processing a laminate showing an example according to the first embodiment A (part 3).
Fig. 6D is a schematic cross-sectional view for describing a method for processing a laminate showing an example according to the first embodiment A (part 4).
Fig. 7A is a schematic cross-sectional view for describing a method for processing a laminate showing an example according to the second embodiment A (part 1).
Fig. 7B is a schematic cross-sectional view for describing a method for processing a laminate showing an example according to the second embodiment A (part 2).
Fig. 7C is a schematic cross-sectional view for describing a method for processing a laminate showing an example according to the second embodiment A (part 3).
Fig. 7D is a schematic cross-sectional view for describing a method for processing a laminate showing an example according to the second embodiment A (part 4).
Fig. 7E is a schematic cross-sectional view for describing a method for processing a laminate showing an example according to the second embodiment A (part 5).
Fig. 7F is a schematic cross-sectional view for describing a method for processing a laminate showing an example according to the second embodiment A (part 6).
Fig. 8 is a schematic cross-sectional view of an example of a laminate according to a first embodiment B.
Fig. 9A is a schematic cross-sectional view for describing a method for manufacturing a laminate showing an example according to the first embodiment B (part 1).
Fig. 9B is a schematic cross-sectional view for describing a method for manufacturing a laminate showing an example according to the first embodiment B (part 2).
Fig. 10 is a schematic cross-sectional view of an example of a laminate according to a second embodiment B.
Fig. 11A is a schematic cross-sectional view for describing a method for manufacturing a laminate showing an example according to the second embodiment B (part 1).
Fig. 11B is a schematic cross-sectional view for describing a method for manufacturing a laminate showing an example according to the second embodiment B (part 2).
Fig. 11C is a schematic cross-sectional view for describing a method for manufacturing a laminate showing an example according to the second embodiment B (part 3).
Fig. 12A is a schematic cross-sectional view for describing a method for processing a laminate showing an example according to the first embodiment B (part 1).
Fig. 12B is a schematic cross-sectional view for describing a method for processing a laminate showing an example according to the first embodiment B (part 2).
Fig. 12C is a schematic cross-sectional view for describing a method for processing a laminate showing an example according to the first embodiment B (part 3).
Fig. 12D is a schematic cross-sectional view for describing a method for processing a laminate showing an example according to the first embodiment B (part 4).
Fig. 13A is a schematic cross-sectional view for describing a method for processing a laminate showing an example according to the second embodiment B (part 1).
Fig. 13B is a schematic cross-sectional view for describing a method for processing a laminate showing an example according to the second embodiment B (part 2).
Fig. 13C is a schematic cross-sectional view for describing a method for processing a laminate showing an example according to the second embodiment B (part 3).
Fig. 13D is a schematic cross-sectional view for describing a method for processing a laminate showing an example according to the second embodiment B (part 4).
Fig. 13E is a schematic cross-sectional view for describing a method for processing a laminate showing an example according to the second embodiment B (part 5).
Fig. 13F is a schematic cross-sectional view for describing a method for processing a laminate showing an example according to the second embodiment B (part 6).

### Description of Embodiments

### (Release Agent Composition for Light Irradiation Release and Adhesive Composition for Light Irradiation Release)

The release agent composition for light irradiation release (hereinafter may be referred to as a "release agent composition") of the present invention contains a Novolac resin, a siloxane backbone-containing epoxy resin, and a solvent.

The adhesive composition for light irradiation release (hereinafter may be referred to as a "adhesive composition") of the present invention contains a Novolac resin, a siloxane backbone-containing epoxy resin, and a solvent.

Hereinafter, each component of the release agent composition and the adhesive composition will be described.

### <Novolac Resin>

A Novolac resin has at least one of a hydroxy group directly bonded to an aromatic ring and a carboxy group directly bonded to an aromatic ring.

The Novolac resin is, for example, a resin obtained by condensation reaction of at least one of a phenolic compound, a carbazole compound, and an aromatic amine compound, at least one of an aldehyde compound, a ketone compound, and a divinyl compound, and an optional styrene compound, under an acid catalyst.

Examples of the phenolic compound include phenols, naphthols, anthrols, hydroxypyrenes, and the like. Examples of the phenols include phenol, cresol, xylenol, resorcinol, bisphenol A, p-tert-butylphenol, p-octylphenol, 9,9-bis(4-hydroxyphenyl) fluorene, and 1,1,2,2-tetrakis(4-hydroxyphenyl) ethane. Examples of the naphthols include 1-naphthol, 2-naphthol, 1,5-dihydroxynaphthalene, 2,7-dihydroxynaphthalene, and 9,9-bis(6-hydroxynaphthyl) fluorene. Examples of the anthrols include 9-anthrol. Examples of the hydroxypyrenes include 1-hydroxypyrene and 2-hydroxypyrene.

Examples of the carbazole compound include carbazole, 1,3,6,8-tetranitrocarbazole, 3,6-diaminocarbazole, 3,6-dibromo-9 ethylcarbazole, 3,6-dibromo-9-phenylcarbazole, 3,6-dibromocarbazole, 3,6-dichlorocarbazole, 3-amino-9-ethylcarbazole, 3-bromo-9-ethylcarbazole, 4,4'bis(9H-carbazole-9-yl)biphenyl, 4-glycidylcarbazole, 4-hydroxycarbazole, 9-(1H-benzotriazole-1-ylmethyl)-9H-carbazole, 9-acetyl-3,6-diiodocarbazole, 9-benzoylcarbazole, 9-benzoylcarbazole-6-dicarboxyaldehyde, 9-benzylcarbazole-3-carboxyaldehyde, 9-methylcarbazole, 9-phenylcarbazole, 9-vinylcarbazole, carbazole potassium, carbazole-N-carbonyl chloride, N-ethylcarbazole-3-carboxaldehyde, and N-((9-ethylcarbazole-3-yl)methylene)-2-methyl-1-indolinylamine.

Examples of the aromatic amine compound include diphenylamine and N-phenyl-1-naphthylamine.

These can be used alone or in combination of two or more thereof.

These may have a substituent. For example, these may have a substituent in the aromatic ring.

Examples of the aldehyde compound include saturated aliphatic aldehydes, unsaturated aliphatic aldehydes, heterocyclic aldehydes, and aromatic aldehydes. Examples of the saturated aliphatic aldehydes include formaldehyde, paraformaldehyde, acetaldehyde, propylaldehyde, butyraldehyde, isobutyraldehyde, valeraldehyde, capronaldehyde, 2-methylbutyraldehyde, hexylaldehyde, undecanaldehyde, 7-methoxy-3,7-dimethyloctylaldehyde, cyclohexanaldehyde, 3-methyl-2-butyraldehyde, 2-ethylhexylaldehyde, glyoxal, malonaldehyde, succinaldehyde, glutaraldehyde, and adipine aldehyde. Examples of the unsaturated aliphatic aldehydes include acrolein and methacrolein. Examples of the heterocyclic aldehydes include furfural and pyridine aldehyde. Examples of the aromatic aldehydes include benzaldehyde, naphthylaldehyde, anthrylaldehyde, phenanthrylaldehyde, salicylaldehyde, phenylacetaldehyde, 3-phenylpropionaldehyde, tolylaldehyde, (N,N-dimethylamino)benzaldehyde, and acetoxybenzaldehyde. Among them, saturated aliphatic aldehydes and aromatic aldehydes are preferable.

Examples of the ketone compound include a diaryl ketone compound. Examples of the diaryl ketone compound include diphenyl ketone, phenyl naphthyl ketone, dinaphthyl ketone, phenyl tolyl ketone, and ditolyl ketone.

Examples of the divinyl compound include divinylbenzene, dicyclopentadiene, tetrahydroindene, 4-vinylcyclohexene, 5-vinylnoborna-2-ene, divinylpyrene, limonene, and 5-vinylnorbornadiene.

These can be used alone or in combination of two or more thereof.

The styrene compound is not particularly limited as long as the styrene compound is a compound having a styrene structure, and examples thereof include styrene, α-methylstyrene, hydroxystyrene (vinylphenol), carboxystyrene (vinylbenzoic acid), alkylstyrene, and tertiary butoxystyrene.

These can be used alone or in combination of two or more thereof.

The novolac resin is, for example, a novolac resin that absorbs light and is altered. The alteration is, for example, photolysis.

The Novolac resin contains, for example, at least one of a structural unit represented by the following Formula (C1-1), a structural unit represented by the following Formula (1-2), and a structural unit represented by the following Formula (C1-3).

For example, at least one structural unit among the structural unit represented by the following Formula (C1-1), the structural unit represented by the following Formula (1-2), and the structural unit represented by the following Formula (C1-3), which is contained in the Novolac resin, may be at least one unit.

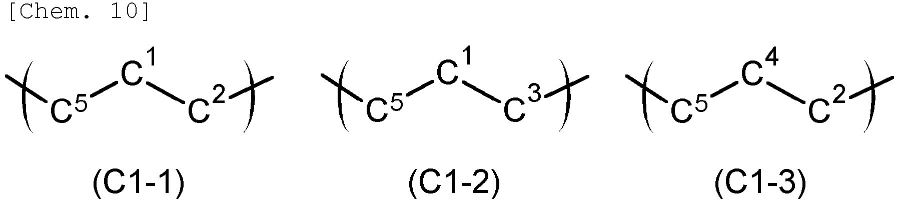

In the formula, C¹ represents a group derived from an aromatic compound containing a nitrogen atom.

C² represents a group containing a tertiary carbon atom or a quaternary carbon atom having at least one selected from the group consisting of a secondary carbon atom, a quaternary carbon atom, and an aromatic ring in a side chain, or represents a methylene group.

C³ represents a group derived from an aliphatic polycyclic compound.

C⁴ represents a group derived from phenol, a group derived from bisphenol, a group derived from naphthol, a group derived from biphenyl, or a group derived from biphenol.

C⁵ represents a single bond or a group having a structure derived from styrene.

In Formula (C1-1), at least one of C¹, C², and C⁵ has at least one of a hydroxy group directly bonded to an aromatic ring and a carboxy group directly bonded to an aromatic ring.

In Formula (C1-2), at least one of C¹, C³, and C⁵ has at least one of a hydroxy group directly bonded to an aromatic ring and a carboxy group directly bonded to an aromatic ring.

In Formula (C1-3), at least one of C², C⁴, and C⁵ has at least one of a hydroxy group directly bonded to an aromatic ring and a carboxy group directly bonded to an aromatic ring.

That is, the Novolac resin contains, for example, one or more types of the following structural units.
· A structural unit having a bond of a group derived from an aromatic compound containing a nitrogen atom, a group containing a tertiary carbon atom or a quaternary carbon atom having at least one selected from the group consisting of a secondary carbon atom, a quaternary carbon atom, and an aromatic ring in a side chain or a methylene group, and an optional group having a structure derived from styrene (Formula (C1-1))
· A structural unit having a bond of a group derived from an aromatic compound containing a nitrogen atom, a group derived from an aliphatic polycyclic compound, and an optional group having a structure derived from styrene (Formula (C1-2))
· A structural unit having a bond of a group derived from phenol, a group derived from bisphenol, a group derived from naphthol, a group derived from biphenyl, or a group derived from biphenol, a group containing a tertiary carbon atom or a quaternary carbon atom having at least one selected from the group consisting of a quaternary carbon atom and an aromatic ring in the side chain or a methylene group, and an optional group having a structure derived from styrene ((Formula (C1-3))

The group derived from the aromatic compound containing the nitrogen atom of C¹ can be, for example, a group derived from carbazole, a group derived from N-phenyl-1-naphthylamine, a group derived from N-phenyl-2-naphthylamine, N,N'-diphenyl-1,4-phenylenediamine, or the like, but is not limited thereto.

The group containing a tertiary carbon atom or a quaternary carbon atom having at least one selected from the group consisting of a secondary carbon atom, a quaternary carbon atom, and an aromatic ring in the side chain or the methylene group of C² can be, for example, a group derived from 1-naphthaldehyde, a group derived from 1-pyrenecarboxaldehyde, a group derived from 4-(trifluoromethyl)benzaldehyde, a group derived from 2-ethylhexylaldehyde, a group derived from acetaldehyde, or the like, but is not limited thereto.

The group derived from the aliphatic polycyclic compound of C³ can be, but is not limited to, a group derived from dicyclopentadiene.

C⁴ represents a group derived from phenol, a group derived from bisphenol, a group derived from naphthol, a group derived from biphenyl, or a group derived from biphenol.

C⁵ represents a single bond or a group having a structure derived from styrene.

When C⁵ is a group having a structure derived from styrene, C⁵ may have at least one of a hydroxy group directly bonded to an aromatic ring and a carboxy group directly bonded to an aromatic ring.

In a preferred aspect, the Novolac resin contains, for example, a structural unit represented by the following Formula (C1-1-1) as the structural unit represented by Formula (C1-1).

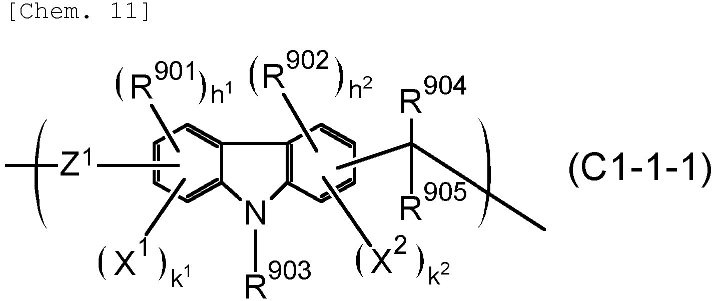

In Formula (C1-1-1), R⁹⁰¹ and R⁹⁰² represent a substituent substituted with a ring, and each independently represent a halogen atom, a nitro group, a cyano group, an amino group, an optionally substituted alkyl group, an optionally substituted alkenyl group, or an optionally substituted aryl group.

R⁹⁰³ represents a hydrogen atom, an optionally substituted alkyl group, an optionally substituted alkenyl group, or an optionally substituted aryl group.

R⁹⁰⁴ represents a hydrogen atom, an optionally substituted aryl group, or an optionally substituted heteroaryl group.

R⁹⁰⁵ represents an optionally substituted alkyl group, an optionally substituted aryl group, or an optionally substituted heteroaryl group.

The group of R⁹⁰⁴ and the group of R⁹⁰⁵ may be bonded to each other to form a divalent group.

Examples of the substituent of the alkyl group and the alkenyl group include a halogen atom, a nitro group, a cyano group, an amino group, a hydroxy group, a carboxy group, an aryl group, and a heteroaryl group.

Examples of the substituent of the aryl group and the heteroaryl group include a halogen atom, a nitro group, a cyano group, an amino group, a hydroxy group, a carboxy group, an alkyl group, and an alkenyl group.

X¹ and X² each independently represent a hydroxy group or a carboxy group.

Z¹ represents a single bond or a group having a structure derived from styrene.

h¹ and h² each independently represent an integer of 0 to 3.

k¹ and k² each independently represent an integer of 0 to 3.

The sum of h¹ and k¹ is 3 or less. The sum of h² and k² is 3 or less.

Here, the structural unit represented by Formula (C1-1-1) has at least one of a hydroxy group directly bonded to an aromatic ring and a carboxy group directly bonded to an aromatic ring.

For example, in Formula (C1-1-1), when at least one of R⁹⁰⁴, R⁹⁰⁵, and Z¹ has a hydroxy group or a carboxy group, k¹ and k² may be 0.

For example, in Formula (C1-1-1), k¹ and k² may be 0 when at least one of R⁹⁰⁴ and R⁹⁰⁵ is an aryl group having a hydroxy group or a carboxy group, or when Z¹ has at least one of a hydroxy group directly bonded to an aromatic ring and a carboxy group directly bonded to an aromatic ring.

For example, in Formula (C1-1-1), when k¹ and k² are 0, at least one of R⁹⁰⁴, R⁹⁰⁵, and Z¹ preferably has a hydroxy group or a carboxy group.

For example, in Formula (C1-1-1), when k¹ and k² are 0, it is preferable that at least one of R⁹⁰⁴ and R⁹⁰⁵ is an aryl group having a hydroxy group or a carboxy group, or Z¹ has at least one of a hydroxy group directly bonded to an aromatic ring and a carboxy group directly bonded to an aromatic ring.

In the present specification, the number of carbon atoms of the optionally substituted alkyl group and the optionally substituted alkenyl group is usually 40 or less, and from the viewpoint of solubility, the number of carbon atoms is preferably 30 or less, and more preferably 20 or less.

In the present specification, the number of carbon atoms of the optionally substituted aryl group and heteroaryl group is usually 40 or less, and from the viewpoint of solubility, the number of carbon atoms is preferably 30 or less, and more preferably 20 or less.

In the present description, examples of a halogen atom include a fluorine atom, a chlorine atom, a bromine atom, and an iodine atom.

In the present specification, examples of the substituent of the optionally substituted alkyl group include a halogen atom, an alkoxy group, and a halogenated alkoxy group.

In the present specification, examples of the substituent of the optionally substituted alkenyl group include a halogen atom, an alkoxy group, and a halogenated alkoxy group.

In the present specification, examples of the substituent of the optionally substituted aryl group include a halogen atom, a hydroxy group, a carboxy group, a cyano group, an alkyl group, a halogenated alkyl group, an alkoxy group, and a halogenated alkoxy group.

In the present specification, examples of the substituent of the optionally substituted heteroaryl group include a halogen atom, a hydroxy group, a carboxy group, a cyano group, an alkyl group, a halogenated alkyl group, an alkoxy group, and a halogenated alkoxy group.

Specific examples of the optionally substituted alkyl group include a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, and a 2-ethylhexyl group, but are not limited thereto.

Specific examples of the optionally substituted alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4 pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-tertiary butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group, but are not limited thereto.

Specific examples of the optionally substituted aryl group include a phenyl group, a 2-methylphenyl group, a 3-methylphenyl group, a 4-methylphenyl group, a 2-chlorophenyl group, a 3-chlorophenyl group, a 4-chlorophenyl group, a 2-fluorophenyl group, a 3-fluorophenyl group, a 4-fluorophenyl group, a 4-methoxyphenyl group, a 4-ethoxyphenyl group, a 4-nitrophenyl group, a 4-cyanophenyl group, a 2-hydroxyphenyl group, a 3-hydroxyphenyl group, a 4-hydroxyphenyl group, a 2-carboxyphenyl group, a 3-carboxyphenyl group, a 4-carboxyphenyl group, a 4-amyloxyphenyl group, a 1-naphthyl group, a 2-naphthyl group, a biphenyl-4-yl group, a biphenyl-3-yl group, a biphenyl-2-yl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group, but are not limited thereto.

Specific examples of the optionally substituted heteroaryl group include a 2-thienyl group, a 3-thienyl group, a 2-furanyl group, a 3-furanyl group, a 2-oxazolyl group, a 4-oxazolyl group, a 5-oxazolyl group, a 3-isoxazolyl group, a 4-isoxazolyl group, a 5-isoxazolyl group, a 2-thiazolyl group, a 4-thiazolyl group, a 5-thiazolyl group, a 3-isothiazolyl group, a 4-isothiazolyl group, and a 5-isothiazolyl group, but are not limited thereto.

Examples of Z¹ include a group represented by the following Formula (Z).

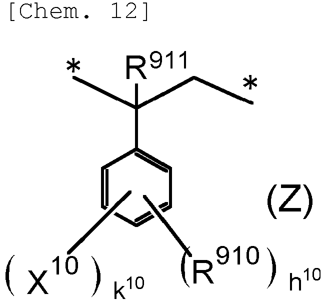

In Formula (Z), R⁹¹⁰ represents a halogen atom, a nitro group, a cyano group, an amino group, an optionally substituted alkyl group, an optionally substituted alkenyl group, or an optionally substituted aryl group.

R⁹¹¹ represents a hydrogen atom or a methyl group.

X¹⁰ represents a hydroxy group or a carboxy group.

h¹⁰ and k¹⁰ each independently represent an integer of 0 to 3. The sum of h¹⁰ and k¹⁰ is 5 or less.

* represents a bond.

Specific examples of R⁹¹⁰ include the specific examples mentioned in the description of R⁹⁰¹ and R⁹⁰².

Hereinafter, specific examples of the structural unit represented by Formula (C1-1-1) will be given, but the structural unit is not limited thereto. In addition, the substitution position of the hydroxy group or the carboxy group on the aromatic ring is not limited.

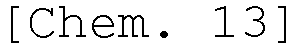

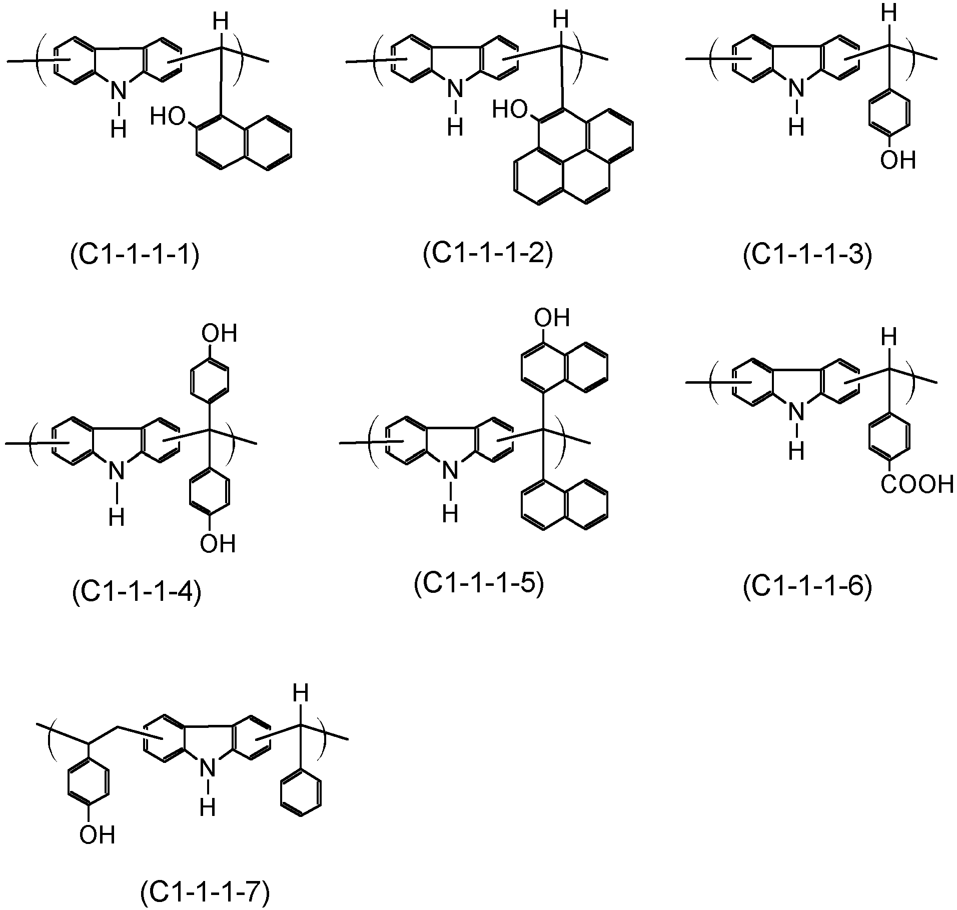

In a preferred aspect, the Novolac resin contains, for example, a structural unit represented by the following Formula (C1-1-2) as the structural unit represented by Formula (C1-1).

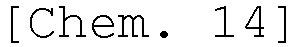

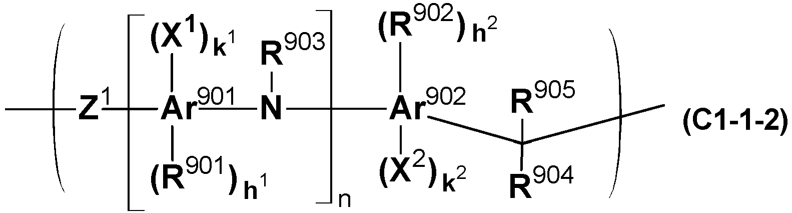

In Formula (C1-1-2), Ar⁹⁰¹ and Ar⁹⁰² each independently represent an aromatic ring, and R⁹⁰¹ to R⁹⁰⁵, X¹ and X², Z¹, h¹ and h², and k¹ and k² represent the same meaning as described above.

The sum of h¹ and k¹ is 3 or less. The sum of h² and k² is 3 or less.

n represents an integer of 1 or 2.

Here, the structural unit represented by Formula (C1-1-2) has at least one of a hydroxy group directly bonded to an aromatic ring and a carboxy group directly bonded to an aromatic ring.

Examples of the aromatic ring include a benzene ring and a naphthalene ring.

For example, in Formula (C1-1-2), when at least one of R⁹⁰⁴, R⁹⁰⁵, and Z¹ has a hydroxy group or a carboxy group, k¹ and k² may be 0.

For example, in Formula (C1-1-2), k¹ and k² may be 0 when at least one of R⁹⁰⁴ and R⁹⁰⁵ is an aryl group having a hydroxy group or a carboxy group, or when Z¹ has at least one of a hydroxy group directly bonded to an aromatic ring and a carboxy group directly bonded to an aromatic ring.

For example, in Formula (C1-1-2), when k¹ and k² are 0, at least one of R⁹⁰⁴, R⁹⁰⁵, and Z¹ preferably has a hydroxy group or a carboxy group.

For example, in Formula (C1-1-2), when k¹ and k² are 0, it is preferable that at least one of R⁹⁰⁴ and R⁹⁰⁵ is an aryl group having a hydroxy group or a carboxy group, or Z¹ has at least one of a hydroxy group directly bonded to an aromatic ring and a carboxy group directly bonded to an aromatic ring.

Hereinafter, specific examples of the structural unit represented by Formula (C1-1-2) will be given, but the structural unit is not limited thereto. In addition, the substitution position of the hydroxy group or the carboxy group on the aromatic ring is not limited.

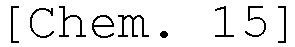

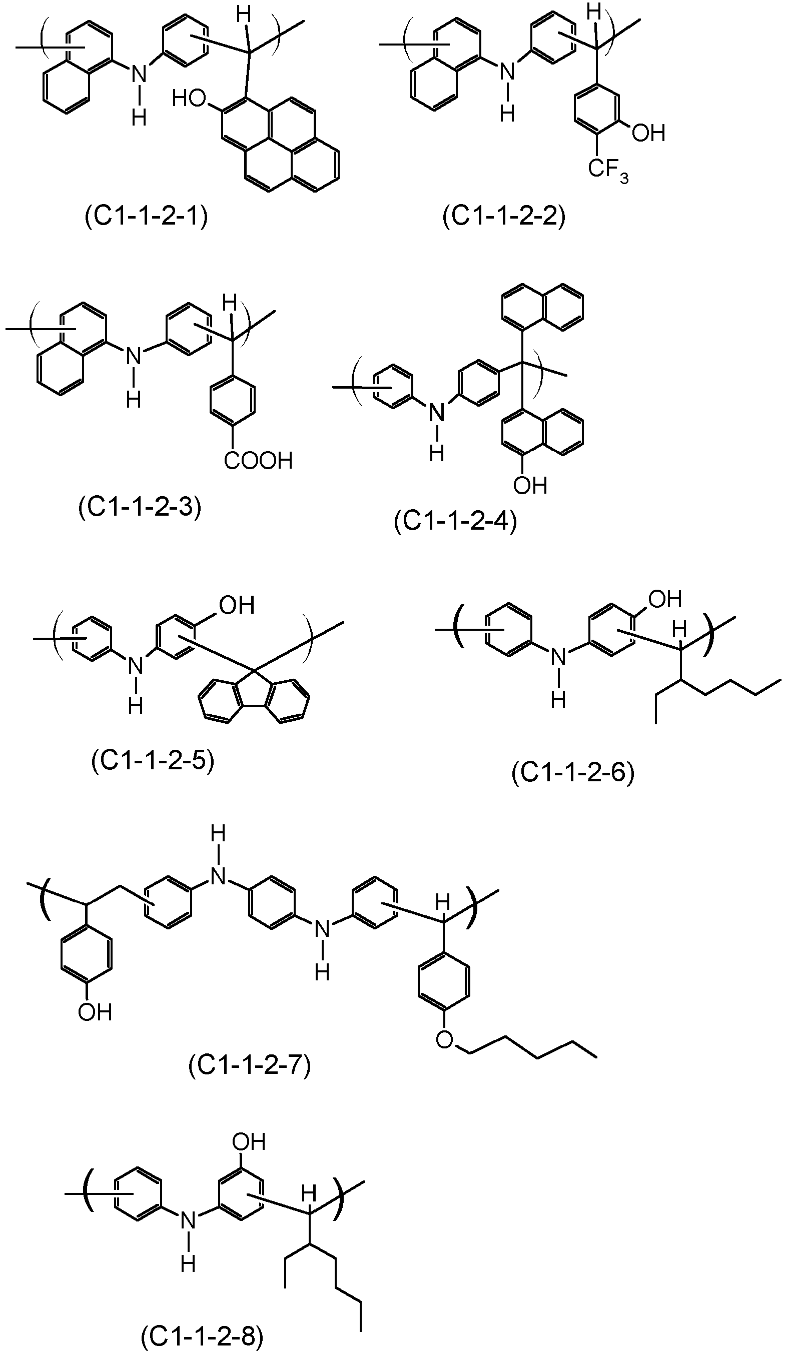

In a preferred aspect, the Novolac resin contains, for example, a structural unit represented by the following Formula (C1-2-1) or (1-2-2) as the structural unit represented by Formula (C1-2).

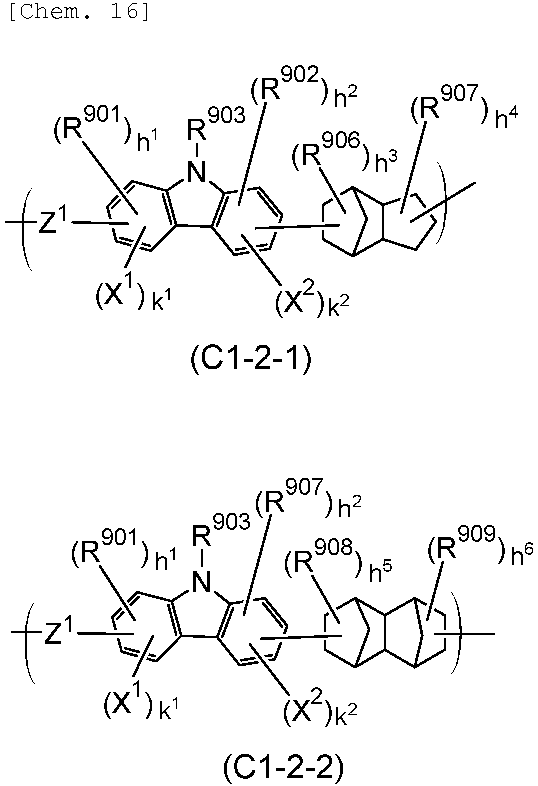

In the above formula, R⁹⁰⁶ to R⁹⁰⁹ are substituents bonded to a ring, and each independently represent a halogen atom, a nitro group, a cyano group, an amino group, a hydroxy group, a carboxy group, an optionally substituted alkyl group, an optionally substituted alkenyl group, or an optionally substituted aryl group. Specific examples and suitable numbers of carbon atoms of the halogen atom, the optionally substituted alkyl group, the optionally substituted alkenyl group, and the optionally substituted aryl group are the same as those described above, and h³ to h⁶ each independently represent an integer of 0 to 3.

R⁹⁰¹ to R⁹⁰⁵, X¹ and X², Z¹, h¹ and h², and k¹ and k² have the same meaning as described above.

The sum of h¹ and k¹ is 3 or less. The sum of h² and k² is 3 or less.

Here, the structural unit represented by Formula (C1-2-1) and the structural unit represented by Formula (C1-2-2) each independently have at least one of a hydroxy group directly bonded to an aromatic ring and a carboxy group directly bonded to an aromatic ring.

Specific examples of the structural units represented by Formulas (C1-2-1) and (C1-2-2) will be given below, but the structural units are not limited thereto. In addition, the substitution position of the hydroxy group or the carboxy group on the aromatic ring is not limited.

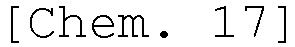

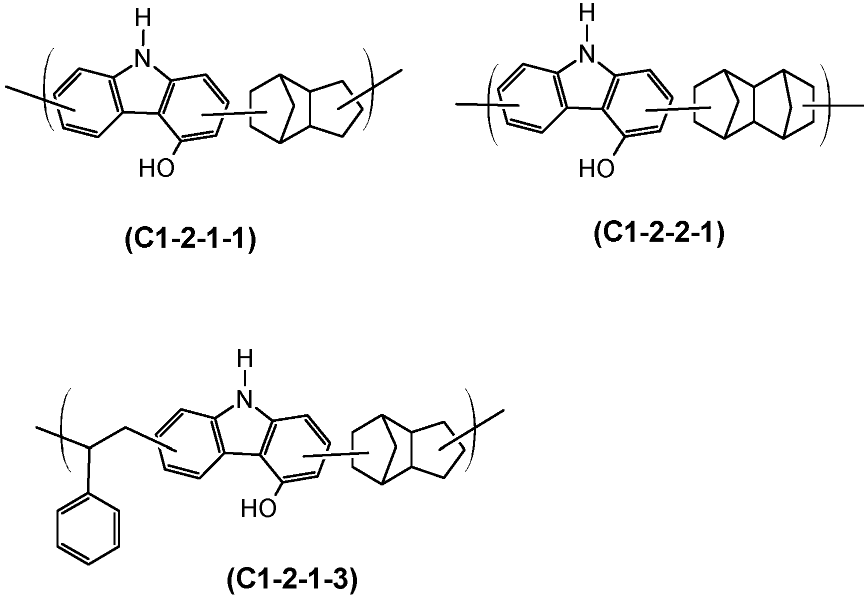

In a preferred aspect, the Novolac resin contains, for example, a structural unit represented by the following Formula (C1-3-1) as the structural unit represented by Formula (C1-3).

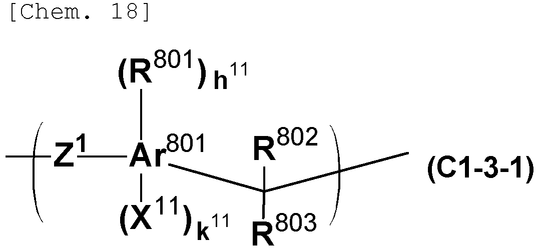

In Formula (C1-3-1), R⁸⁰¹ represents a substituent substituted with a ring, and each independently represents a halogen atom, a nitro group, a cyano group, an amino group, an optionally substituted alkyl group, an optionally substituted alkenyl group, or an optionally substituted aryl group.

R⁸⁰² represents a hydrogen atom, an optionally substituted aryl group, or an optionally substituted heteroaryl group.

R⁸⁰³ represents a hydrogen atom, an optionally substituted alkyl group, an optionally substituted aryl group, or an optionally substituted heteroaryl group.

The group of R⁸⁰² and the group of R⁸⁰³ may be bonded to each other to form a divalent group.

Examples of the substituent of the aryl group and the heteroaryl group include a halogen atom, a nitro group, a cyano group, an amino group, a hydroxy group, a carboxy group, an alkyl group, and an alkenyl group.

Ar⁸⁰¹ represents a benzene ring, a naphthalene ring, or a biphenyl structure.

X¹¹ represents a hydroxy group or a carboxy group.

Z¹ represents a single bond or a group having a structure derived from styrene.

h¹¹ each independently represents an integer of 0 to 4.

k¹¹ each independently represents an integer of 0 to 4.

When Ar⁸⁰¹ is a benzene ring, the total of h¹¹ and k¹¹ is 4 or less, when Ar⁸⁰¹ is a naphthalene ring, the total of h¹¹ and k¹¹ is 6 or less, and when Ar⁸⁰¹ has a biphenyl structure, the total of h¹¹ and k¹¹ is 8 or less.

Here, the structural unit represented by Formula (C1-3-1) has at least one of a hydroxy group directly bonded to an aromatic ring and a carboxy group directly bonded to an aromatic ring.

For example, in Formula (C1-3-1), when at least one of R⁸⁰², R⁸⁰³, and Z¹ has a hydroxy group or a carboxy group, k¹¹ may be 0.

For example, in Formula (C1-3-1), k¹¹ may be 0 when at least one of R⁸⁰² and R⁸⁰³ is an aryl group having a hydroxy group or a carboxy group, or when Z¹ has at least one of a hydroxy group directly bonded to an aromatic ring and a carboxy group directly bonded to an aromatic ring.

For example, in Formula (C1-3-1), when k¹¹ is 0, at least one of R⁸⁰² and R⁸⁰³ is an aryl group having a hydroxy group or a carboxy group, or a heteroaryl group having a hydroxy group or a carboxy group.

Hereinafter, specific examples of the structural unit represented by Formula (C1-3) will be given, but the structural unit is not limited thereto.

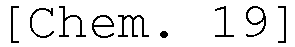

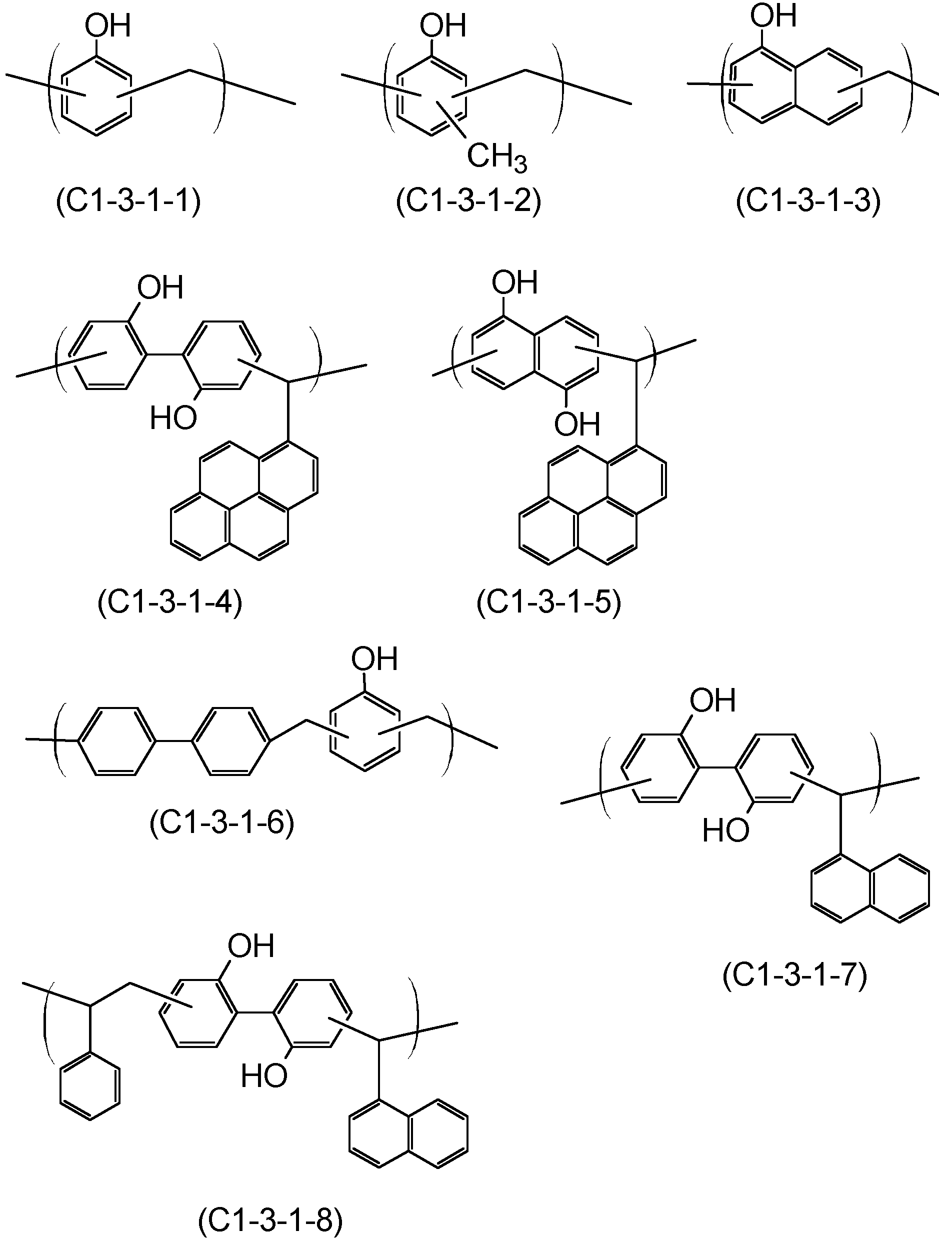

As described above, the Novolac resin is, for example, a resin obtained by condensation reaction of at least one of a phenolic compound, a carbazole compound, and an aromatic amine compound, at least one of an aldehyde compound, a ketone compound, and a divinyl compound, and an optional styrene compound, under an acid catalyst.

In this condensation reaction, for example, an aldehyde compound or a ketone compound is usually used in a ratio of 0.1 to 10 equivalents to 1 equivalent of a benzene ring constituting a ring of a carbazole compound.

When at least one of a hydroxy group directly bonded to an aromatic ring and a carboxy group directly bonded to an aromatic ring is introduced into a Novolac resin using a styrene compound, the styrene compound as a reaction raw material may have a protecting group. Examples of the styrene compound having a protecting group include tertiary butoxystyrene.

In the condensation reaction, an acid catalyst is usually used.

Examples of the acid catalyst include mineral acids such as sulfuric acid, phosphoric acid, and perchloric acid, organic sulfonic acids such as p-toluenesulfonic acid and p-toluenesulfonic acid monohydrate, and carboxylic acids such as formic acid and oxalic acid, but are not limited thereto.

The amount of the acid catalyst is appropriately determined depending on the type of the acid to be used and the like, and thus cannot be generally defined, but is usually appropriately determined from the range of 0.001 to 10,000 parts by mass with respect to 100 parts by mass of the carbazole compound.

When either the raw material compound or the acid catalyst to be used is a liquid, the condensation reaction can be performed without using a solvent in some cases, but is usually performed using a solvent.

Such a solvent is not particularly limited as long as the reaction is not inhibited, but typically includes an ether compound, an ether ester compound, and the like.

Examples of the ether compound include cyclic ether compounds such as tetrahydrofuran and dioxane.

Examples of the ether ester compound include methyl cellosolve acetate, ethyl cellosolve acetate, butyl cellosolve acetate, propylene glycol monomethyl ether acetate (PGMEA), propylene glycol monoethyl ether acetate, propylene glycol monopropyl ether acetate, propylene glycol monomethyl ether propionate, propylene glycol monoethyl ether propionate, and propylene glycol monopropyl ether propionate.

The reaction temperature is usually appropriately determined from the range of 40°C to 200°C, and the reaction time cannot be generally specified because the reaction time varies depending on the reaction temperature, but is usually appropriately determined from the range of 30 minutes to 50 hours.

After completion of the reaction, if necessary, purification and isolation are performed according to a conventional method, and the obtained Novolac resin is used for preparation of a release agent composition and an adhesive composition.

Those skilled in the art can determine the manufacturing conditions of the Novolac resin without an excessive burden based on the above description and the common general technical knowledge, and therefore can produce the Novolac resin.

The weight average molecular weight of the Novolac resin is usually 500 to 200,000, and is preferably 100,000 or less, more preferably 50,000 or less, still more preferably 10,000 or less, further preferably 5,000 or less, and even more preferably 3,000 or less from the viewpoint of securing solubility in a solvent and the like, and is preferably 600 or more, more preferably 700 or more, still more preferably 800 or more, further preferably 900 or more, and even more preferably 1,000 or more from the viewpoint of improving the strength of the film and the like.

In the present invention, the weight average molecular weight, the number average molecular weight, and the dispersibility of the Novolac resin can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (elution solvent), at a flow rate of 0.35 mL/min, and using polystyrene (manufactured by Sigma-Aldrich) as a standard sample.

The content of the Novolac resin in the release agent composition is not particularly limited, but is preferably 50% by mass to 100% by mass, more preferably 60% by mass to 99% by mass, and particularly preferably 70% by mass to 95% by mass with respect to the film constituent component in the release agent composition.

The content of the Novolac resin in the adhesive composition is not particularly limited, and is preferably 50% by mass to 100% by mass, more preferably 60% by mass to 99% by mass, and particularly preferably 70% by mass to 95% by mass with respect to the amount of the film constituent components of the adhesive composition.

In the present invention, the film constituent component means a component other than the solvent contained in the composition.

### <Siloxane Backbone-Containing Epoxy Resin>

The siloxane backbone-containing epoxy resin has a siloxane bond and an epoxy group.

The siloxane backbone-containing epoxy resin has, for example, two or more silicon atoms, preferably four or more silicon atoms.

The siloxane backbone-containing epoxy resin may be chain or cyclic.

The siloxane backbone-containing epoxy resin preferably has a structure represented by the following Formula (A). 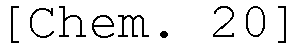 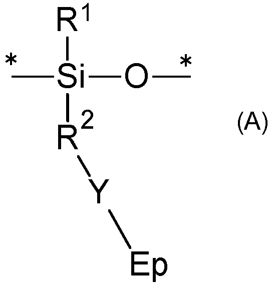 (In Formula (A), R¹ represents a substituted or unsubstituted alkyl group, a substituted or unsubstituted alkenyl group, or a substituted or unsubstituted aryl group. R² represents an alkylene group having 1 to 10 carbon atoms. Y represents a single bond or -CO-. Ep represents a group represented by Formula (A-1) or (A-2) below. * represents a bond.) 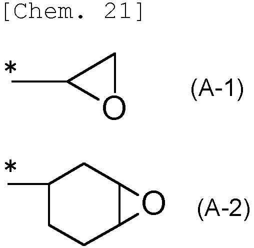 (In Formula (A-1) and Formula (A-2), * represents a bond.)

The "alkyl group" in the "substituted or unsubstituted alkyl group" of R¹ in Formula (A) is preferably an alkyl group having 1 to 10 carbon atoms. Examples of the "alkyl group" include a methyl group, an ethyl group, a propyl group, an isopropyl group, a butyl group, an isobutyl group, a sec-butyl group, a tert-butyl group, a pentyl group, an isopentyl group, a neopentyl group, a sec-pentyl group, a tert-pentyl group, a cyclopentyl group, a cyclohexyl group, a cyclopentylmethyl group, a 2-cyclohexylmethyl group, a 2-cyclopentylethyl group, and a 2-cyclohexylethyl group.

The "alkenyl group" in the "substituted or unsubstituted alkenyl group" of R¹ in Formula (A) is preferably an alkenyl group having 2 to 10 carbon atoms. Examples of the "alkenyl group" include a vinyl group, a 1-propenyl group, a 2-propenyl group, a 2-methyl-1-propenyl group, a 1-butenyl group, a 2-butenyl group, a 3-butenyl group, a 3-methyl-2-butenyl group, a 1-pentenyl group, a 2-pentenyl group, a 3-pentenyl group, a 4-pentenyl group, a 4-methyl-3-pentenyl group, a 1-hexenyl group, a 3-hexenyl group, a 5-hexenyl group, and a 2-cyclohexenyl group.

The substituent of the alkyl group in the "substituted or unsubstituted alkyl group" of R¹ in Formula (A) and the substituent of the alkenyl group in the "substituted or unsubstituted alkenyl group" are not particularly limited, and examples thereof include a halogen atom, a cyano group, a nitro group, an alkyl-oxy group, an alkyl-carbonyl group, an alkyl-oxy-carbonyl group, an alkyl-carbonyl-oxy group, an alkenyl-oxy group, an alkenyl-carbonyl group, an alkenyl-oxy-carbonyl group, an alkenyl-carbonyl-oxy group, an aryl group, an aryl-oxy group, an aryl-carbonyl group, an aryl-oxy-carbonyl group, an aryl-carbonyl-carbonyl group, and an aryl-carbonyl-oxy group, and combinations thereof. The number of substituents is preferably 1 to 3, and more preferably 1.

The "aryl group" in the "substituted or unsubstituted aryl group" of R¹ in Formula (A) is preferably an aryl group having 6 to 14 carbon atoms. Examples of the "aryl group" include a phenyl group, a 1-naphthyl group, and a 2-naphthyl group.

The substituent of the aryl group in the "substituted or unsubstituted aryl group" of R¹ is not particularly limited, and examples thereof include a halogen atom, a cyano group, a nitro group, an alkyl group, an alkyl-oxy group, an alkyl-carbonyl group, an alkyl-oxy-carbonyl group, an alkyl-carbonyl-oxy group, an alkenyl group, an alkenyl-oxy group, an alkenyl-carbonyl group, an alkenyl-oxy-carbonyl group, an alkenyl-carbonyl-oxy group, an aryl group, an aryl-alkyl group, an aryl-alkenyl group, an aryl-oxy group, an aryl-carbonyl group, an aryl-oxy-carbonyl group, an aryl-carbonyl-oxy group, or a combination thereof. The number of substituents is preferably 1 to 3, and more preferably 1.

Examples of the halogen atom include fluorine atom, chlorine atom, and bromine atom.

R¹ in Formula (A) is preferably a substituted or unsubstituted alkyl group, more preferably a (unsubstituted) alkyl group, still more preferably a methyl group, an ethyl group, a propyl group, or an isopropyl group, and particularly preferably a methyl group.

The siloxane backbone-containing epoxy resin is preferably represented by any one of the following Formulas (SE1) to (SE3), for example. In the siloxane backbone-containing epoxy resin represented by the following Formulas (SE1) to (SE3), the repeating units may be randomly arranged. 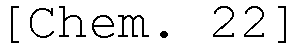 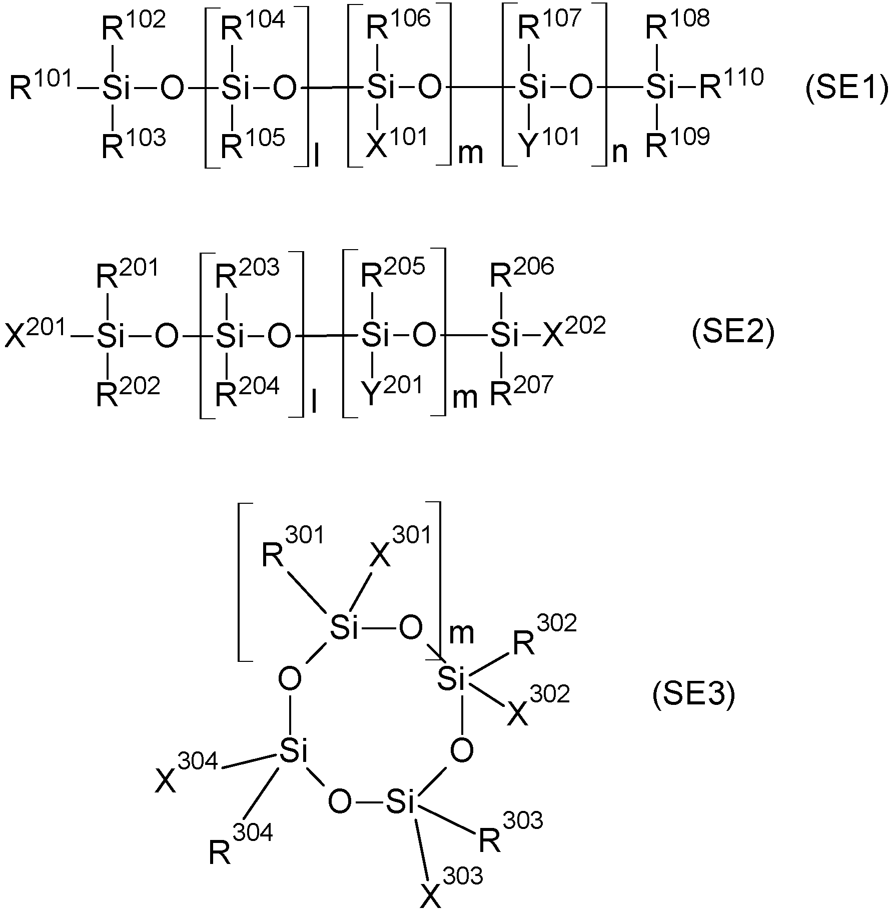 (In Formula (SE1), R¹⁰¹ to R¹¹⁰ each independently represent a substituted or unsubstituted alkyl group, a substituted or unsubstituted alkenyl group, or a substituted or unsubstituted aryl group. X¹⁰¹ represents a group represented by Formula (EA) below. Y¹⁰¹ represents a hydrogen atom, a hydroxy group, or a monovalent group having 1 to 30 carbon atoms (here, Y¹⁰¹ is different from X¹⁰¹). l represents 0 or an integer of 1 or more. m represents an integer of 1 or more. n represents 0 or an integer of 1 or more.

In Formula (SE2), R²⁰¹ to R²⁰⁷ each independently represent a substituted or unsubstituted alkyl group, a substituted or unsubstituted alkenyl group, or a substituted or unsubstituted aryl group. X²⁰¹ and X²⁰² each independently represent a group represented by Formula (EA) below. Y²⁰¹ represents a hydrogen atom, a hydroxy group, or a monovalent group having 1 to 30 carbon atoms. l represents 0 or an integer of 1 or more. m represents 0 or an integer of 1 or more.

In Formula (SE3), R³⁰¹ to R³⁰⁴ each independently represent a substituted or unsubstituted alkyl group, a substituted or unsubstituted alkenyl group, or a substituted or unsubstituted aryl group. X³⁰¹ to X³⁰⁴ each independently represent a group represented by Formula (EA) below. m represents an integer of 1 to 3.) 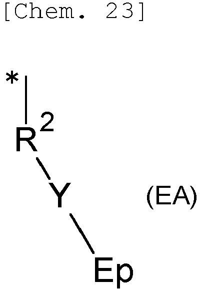 (In Formula (EA), R² represents an alkylene group having 1 to 10 carbon atoms. Y represents a single bond or -CO-. Ep represents a group represented by Formula (A-1) or (A-2) below. * represents a bond.) 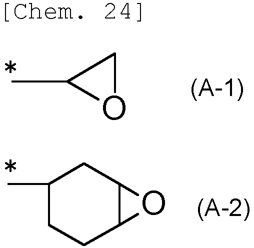 (In Formula (A-1) and Formula (A-2), * represents a bond.)

Specific examples and preferable examples of the substituted or unsubstituted alkyl group, the substituted or unsubstituted alkenyl group, and the substituted or unsubstituted aryl group of R¹⁰¹ to R¹¹⁰ in Formula (SE1), R²⁰¹ to R²⁰⁷ in Formula (SE2), and R³⁰¹ to R³⁰⁴ in Formula (SE3) include, for example, specific examples and preferable examples in the description of R¹ in Formula (A) .

Examples of the monovalent group having 1 to 30 carbon atoms for Y¹⁰¹ and Y²⁰¹ in Formula (SE1) include monovalent groups represented by any one of the following (i) to (iv).
(i) A hydrocarbon group having 7 to 30 carbon atoms
(ii) A monovalent hydrocarbon group having 2 to 30 carbon atoms, in which at least one of an ether bond, a thioether bond, an amide bond, a urethane bond, and an ester bond is inserted between carbon-carbon bonds of the hydrocarbon group
(iii) A monovalent hydrocarbon group having 1 to 30 carbon atoms in which at least one hydrogen atom in the hydrocarbon group is substituted with a halogen atom, a hydroxy group, a nitro group, or a cyano group
(iv) A monovalent hydrocarbon group having 2 to 30 carbon atoms, which is configured by inserting at least one of an ether bond, a thioether bond, an amide bond, a urethane bond, and an ester bond between carbon-carbon bonds of a hydrocarbon group, and in which at least one hydrogen atom in the hydrocarbon group is substituted with a halogen atom, a hydroxy group, a nitro group, or a cyano group

The carbon having "1 to 30 carbon atoms" in the "monovalent group having 1 to 30 carbon atoms" does not include carbon atoms in a cyano group, an amide bond, a urethane bond, or an ester bond.

Specific examples of the siloxane backbone-containing epoxy resin are as follows.
· Linear siloxane backbone-containing epoxy resin such as 1,3,5-tris(2-(3,4-epoxycyclohexyl)ethyl)-1,1,3,5,5-pentamethyltrisiloxane
· Cyclic siloxane backbone-containing epoxy resin such as 2,4,6,8-tetrakis(4-(3,4-epoxycyclopentyl)butyl)-2,4,6,8-tetramethylcyclotetrasiloxane, 2,4,6,8-tetrakis(3-(3,4-epoxycyclopentyl)propyl)-2,4,6,8-tetramethylcyclotetrasiloxane, 2,4,6,8-tetrakis(2-(3,4-epoxycyclohexyl)ethyl)-2,4,6,8-tetramethylcyclotetrasiloxane, and 2,4,6,8,10-pentaxis(2-(3,4-epoxycyclohexyl)ethyl)-2,4,6,8,10-pentamethylcyclopentasiloxane

The molecular weight of the siloxane backbone-containing epoxy resin is not particularly limited, but the upper limit is preferably 15,000 or less, more preferably 10,000 or less, still more preferably 8,000 or less, and particularly preferably 5,000 or less. The lower limit may be, for example, 200 or more, 400 or more, 600 or more, or the like.

The epoxy equivalent of the siloxane backbone-containing epoxy resin is not particularly limited, but the upper limit is preferably 1,000 g/eq. or less, more preferably 500 g/eq. or less, still more preferably 300 g/eq. or less, and particularly preferably 250 g/eq. or less. The lower limit is preferably 50 g/eq. or more, more preferably 100 g/eq. or more, still more preferably 130 g/eq. or more, and particularly preferably 150 g/eq. or more.

The siloxane backbone-containing epoxy resin may be a commercially available product. Examples of the commercially available product include "KF-105", "KF-1005", "KR-470" (main component: 2,4,6,8-tetrakis(2-(3,4-epoxycyclohexyl)ethyl)-2,4,6,8-tetramethylcyclotetrasiloxane), "X-40-2667" (main component: 1,3,5-tris(2-(3,4-epoxycyclohexyl)ethyl)-1,1,3,5,5-pentamethyltrisiloxane) manufactured by Shin-Etsu Chemical Co., Ltd., and "EP-3400L" manufactured by ADEKA Corporation.

The viscosity (25°C) of the siloxane backbone-containing epoxy resin is not particularly limited, but is preferably 100 mPa·s to 10,000 mPa·s, and more preferably 1,000 mPa·s to 5,000 mPa·s.

The content of the siloxane backbone-containing epoxy resin in the release agent composition is not particularly limited, but is preferably 1% by mass to 70% by mass, more preferably 3% by mass to 55% by mass, and particularly preferably 5% by mass to 40% by mass with respect to the Novolac resin in the release agent composition.

The content of the siloxane backbone-containing epoxy resin in the adhesive composition is not particularly limited, but is preferably 1% by mass to 70% by mass, more preferably 3% by mass to 55% by mass, and particularly preferably 5% by mass to 40% by mass with respect to the Novolac resin in the adhesive composition.

### <Curing Catalyst>

For the purpose of, for example, promoting the curing reaction, the release agent composition may contain a curing catalyst.

For the purpose of, for example, promoting the curing reaction, the adhesive composition may contain a curing catalyst.

The curing catalyst is not particularly limited, and examples thereof include amines, imidazoles, organic phosphines, and Lewis acids.

Examples of the amines include tertiary amines. Examples of the tertiary amines include 1,8-diazabicyclo(5.4.0)undec-7-ene(DBU), triethylenediamine, benzyldimethylamine, triethanolamine, dimethylaminoethanol, and tris(dimethylaminomethyl) phenol.

Examples of the imidazoles include 2-methylimidazole, 2-phenylimidazole, 2-ethyl-4 methylimidazole, 4-methyl-2-phenylimidazole, 2-heptadecylimidazole, and 2-phenyl-1-benzyl-1H-imidazole.

Examples of the organophosphines include tributylphosphine, methyldiphenylphosphine, triphenylphosphine, diphenylphosphine, and phenylphosphine.

Examples of other curing catalysts include tetra-substituted phosphonium tetra substituted borates such as tetraphenylphosphonium tetraphenylborate, tetraphenylphosphonium ethyltriphenylborate, and tetrabutylphosphonium tetrabutylborate; tetraphenylboron salts such as 2-ethyl-4-methylimidazole tetraphenylborate, and N-methylmorpholine tetraphenylborate; and tetrabutylphosphonium O,O-diethylphosphorodithioate.

The amount of the curing catalyst contained in the release agent composition is not particularly limited, but is preferably 1% by mass to 20% by mass with respect to the siloxane backbone-containing epoxy resin in the release agent composition.

The amount of the curing catalyst contained in the adhesive composition is not particularly limited, but is preferably 1% by mass to 20% by mass with respect to the siloxane backbone-containing epoxy resin in the adhesive composition.

### <Surfactant>

The release agent composition and the adhesive composition may contain a surfactant for the purpose of, for example, adjusting the liquid physical properties of the composition itself or the film physical properties of the obtained film, or preparing a release agent composition and an adhesive composition having high uniformity with high reproducibility.

Examples of the surfactant may include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl allyl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine surfactants such as EFTOP EF301, EF303, and EF352 (manufactured by Tohkemy Corporation, trade name), MEGAFACE F171, F173, R-30, and R-30N (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by AGC Inc., trade name); and organosiloxane polymer KP341 (manufactured by Shin-Etsu Chemical Co., Ltd.).

Surfactants can be used alone or in combination of two or more thereof.

The amount of the surfactant in the release agent composition is usually 2% by mass or less with respect to the film constituent components of the release agent composition.

The amount of the surfactant in the adhesive composition is usually 2% by mass or less with respect to the film constituent components of the adhesive composition.

### <Solvent>

The release agent composition contains a solvent.

The adhesive composition contains a solvent.

As the solvent, for example, a high-polarity solvent capable of satisfactorily dissolving film constituent components such as the above-described Novolac resin and siloxane backbone-containing epoxy resin can be used, and if necessary, a low-polarity solvent may be used for the purpose of adjusting viscosity, surface tension, and the like. Note that in the present invention, the low-polarity solvent is defined as a solvent having a relative permittivity of less than 7 at a frequency of 100 kHz, and the high-polarity solvent is defined as a solvent having a relative permittivity of 7 or more at a frequency of 100 kHz. The solvents can be used alone or in combination of two or more thereof.

Examples of the high-polarity solvent include amide-based solvents such as N,N-dimethylformamide, N,N-dimethylacetamide, N,N-dimethylisobutyramide, N-methylpyrrolidone, and 1,3-dimethyl-2 imidazolidinone; ketone-based solvent such as ethyl methyl ketone, isophorone, or cyclohexanone; cyano solvents such as acetonitrile and 3-methoxypropionitrile; polyhydric alcohol-based solvent such as ethylene glycol, diethylene glycol, triethylene glycol, dipropylene glycol, 1,3-butanediol, or 2,3-butanediol;
a monohydric alcohol-based solvent, other than aliphatic alcohols (for example, propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol); and sulfoxide-based solvents such as dimethyl sulfoxide.

Examples of the low-polarity solvent include chlorine-based solvents such as chloroform and chlorobenzene; aromatic hydrocarbon-based solvents such as alkylbenzenes (for example, toluene, xylene, tetralin, cyclohexylbenzene, and decylbenzene); aliphatic alcohol-based solvents such as 1-octanol, 1-nonanol, and 1-decanol; ether-based solvent such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, or triethylene glycol butyl methyl ether; and ester-based solvents such as methyl benzoate, ethyl benzoate, butyl benzoate, isoamyl benzoate, bis(2-ethylhexyl)phthalate, dibutyl maleate, dibutyl oxalate, hexyl acetate, propylene glycol monomethyl ether acetate, diethylene glycol monoethyl ether acetate, and diethylene glycol monobutyl ether acetate.

The content of the solvent is appropriately determined in consideration of the viscosity of the desired composition, the coating method to be adopted, the thickness of the film to be prepared, and the like, but is 99% by mass or less with respect to the entire composition, preferably 70 to 99% by mass with respect to the entire composition, more preferably 85 to 97% by mass with respect to the entire composition, that is, the amount of the film constituent component in that case is preferably 1 to 30% by mass with respect to the entire composition, and more preferably 3 to 15% by mass with respect to the entire composition.

The viscosity and surface tension of the release agent composition and the adhesive composition are appropriately adjusted by changing the type of the solvent to be used, the ratio thereof, the concentration of the film constituent component, and the like in consideration of various factors such as the coating method to be used and the desired film thickness.

In an aspect of the present invention, the release agent composition and the adhesive composition contains a glycol-based solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like. Note that the "glycol-based solvent" as used herein is a generic term for glycols, glycol monoethers, glycol diethers, glycol monoesters, glycol diesters, and glycol ester ethers.

An example of a preferred glycol-based solvent is represented by Formula (G).

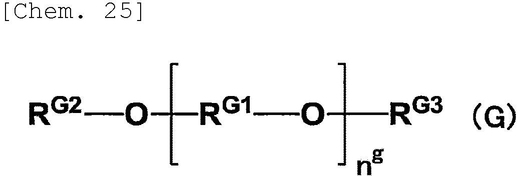

In Formula (G), R^{G1} each independently represents a linear or branched alkylene group having 2 to 4 carbon atoms, R^{G2} and R^{G3} each independently represent a hydrogen atom, a linear or branched alkyl group having 1 to 8 carbon atoms, or an alkylacyl group in which the alkyl portion is a linear or branched alkyl group having 1 to 8 carbon atoms, and n^{g} is an integer of 1 to 6.

Specific examples of the linear or branched alkylene group having 2 to 4 carbon atoms include an ethylene group, a trimethylene group, a 1-methylethylene group, a tetramethylene group, a 2-methylpropane-1,3-diyl group, a pentamethylene group, and a hexamethylene group, but are not limited thereto.

Among them, a linear or branched alkylene group having 2 to 3 carbon atoms is preferable, and a linear or branched alkylene group having 3 carbon atoms is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms include a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto.

Among them, a methyl group and an ethyl group are preferable, and a methyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms in the alkylacyl group in which the alkyl portion is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

n^{g} is preferably 4 or less, more preferably 3 or less, still more preferably 2 or less, most preferably 1 from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In Formula (G), preferably, at least one of R^{G2} and R^{G3} is a linear or branched alkyl group having 1 to 8 carbon atoms, more preferably, one of R^{G2} and R^{G3} is a linear or branched alkyl group having 1 to 8 carbon atoms, and the other is an alkylacyl group in which a hydrogen atom or an alkyl portion is a linear or branched alkyl group having 1 to 8 carbon atoms from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The content of the glycol-based solvent in the release agent composition is preferably 50% by mass or more, more preferably 70% by mass or more, still more preferably 80% by mass or more, further preferably 90% by mass or more, and even more preferably 95% by mass or more with respect to the solvent contained in the release agent composition from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the release agent composition, the film constituent component is uniformly dispersed or dissolved, preferably dissolved in the solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The content of the glycol-based solvent in the adhesive composition is preferably 50% by mass or more, more preferably 70% by mass or more, still more preferably 80% by mass or more, further preferably 90% by mass or more, and even more preferably 95% by mass or more with respect to the solvent contained in the release agent composition from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the adhesive composition, the film constituent component is uniformly dispersed or dissolved, preferably dissolved in the solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the present invention, for the purpose of removing foreign matter, a solvent, a solution, or the like to be used may be filtered using a filter or the like during the manufacturing of the release agent composition and the adhesive composition or after mixing all the components.

### (Laminate <Embodiment A>)

Embodiment A of the laminate according to the present invention includes a semiconductor substrate or an electronic device layer, a support substrate, and a release agent layer for light irradiation release.

The embodiment A of the laminate according to the present invention preferably further includes an adhesive layer, and includes a semiconductor substrate or an electronic device layer, a support substrate, a release agent layer for light irradiation release, and an adhesive layer.

Note that when the release agent layer according to the present invention is formed to have not only a release function of releasing the semiconductor substrate or the electronic device layer from the support substrate by irradiation with light but also an adhesion function of adhering the semiconductor substrate or the electronic device layer to the support substrate (that is, when the release agent layer is formed using a release agent composition containing a component that exhibits both functions), the laminate may be formed not in a two-layer configuration of the release agent layer and the adhesive layer but in a one-layer configuration of the release agent layer having adhesive performance.

The support substrate has light transmissivity.

The release agent layer for light irradiation release is provided between the semiconductor substrate or the electronic device layer and the support substrate.

Embodiment A of the laminate is used for release of the semiconductor substrate or the electronic device layer from the support substrate after the release agent layer absorbs light emitted from the support substrate side.

The release agent layer for light irradiation release is a layer formed of the release agent composition for light irradiation release of the present invention described above.

Embodiment A of the laminate of the present invention is used for temporary adhesion for processing the semiconductor substrate or the electronic device layer, and can be suitably used for processing such as thinning of the semiconductor substrate or the electronic device layer.

While the semiconductor substrate is subjected to processing such as thinning, the semiconductor substrate is supported by the support substrate. On the other hand, after the processing of the semiconductor substrate, the release agent layer is irradiated with light, and thereafter, the support substrate and the semiconductor substrate are separated from each other. Due to the Novolac resin contained in the release agent composition for light irradiation release of the present invention, in the release agent layer formed from the release agent composition, the Novolac resin absorbs light (for example, laser light) to alter (for example, separates or decomposes) the release agent layer. As a result, after the release agent layer is irradiated with light, the semiconductor substrate is easily released from the support substrate.

In addition, while the electronic device layer is subjected to processing such as thinning, the electronic device layer is supported by the support substrate. On the other hand, after the processing of the electronic device layer, the release agent layer is irradiated with light, and thereafter, the support substrate and the electronic device layer are separated from each other.

Owing to the release agent layer according to the present invention, the semiconductor substrate or the electronic device layer is easily released from the support substrate after being irradiated with light. Furthermore, after the semiconductor substrate or the electronic device layer is released from the support substrate, residues of the release agent layer or the adhesive layer remaining on the semiconductor substrate, the electronic device layer, or the support substrate can be removed by, for example, a cleaning agent composition for cleaning the semiconductor substrate and the like.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable alteration, for example, decomposition of the Novolac resin.

The light used for release may be laser light or non-laser light emitted from a light source such as an ultraviolet lamp.

Hereinafter, a case where the laminate includes a semiconductor substrate and a case where the laminate includes an electronic device layer will be described in detail separately.

The case where the laminate includes a semiconductor substrate will be described in the following <First Embodiment A>, and the case where the laminate includes an electronic device layer will be described in the following <Second Embodiment A>.

### <First Embodiment A>

The laminate having a semiconductor substrate is used for processing the semiconductor substrate. While the semiconductor substrate is processed, the semiconductor substrate is adhered to the support substrate. After processing the semiconductor substrate, the release agent layer is irradiated with light, and then the semiconductor substrate is separated from the support substrate.

### <<Semiconductor Substrate>>

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 µm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be composed of only a single component or may be composed of a plurality of components. More specific examples thereof include alloy plate mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 µm.

### <<Support Substrate>>

The support substrate is not particularly limited as long as the support substrate is a member that is light-transmissive to light emitted to the release agent layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined depending on the size of the semiconductor substrate and the like, and is not particularly limited, but is, for example, 500 to 1,000 µm.

The diameter of the disk-shaped support substrate may be appropriately determined depending on the size of the semiconductor substrate and the like, and is not particularly limited, but is, for example, 100 to 1,000 mm.

An example of the support substrate is a glass wafer having a diameter of about 300 mm and a thickness of about 700 µm.

### <<Release Agent Layer>>

The release agent layer is a layer formed of a release agent composition.

The release agent layer is provided between the semiconductor substrate and the support substrate.

The release agent layer may be in contact with the support substrate or may be in contact with the semiconductor substrate.

The release agent layer is formed using the release agent composition for light irradiation release of the present invention described above.

The release agent composition of the present invention can be suitably used for forming the release agent layer of a laminate including a semiconductor substrate, a support substrate, and a release agent layer provided between the semiconductor substrate and the support substrate. The laminate is used for release of the semiconductor substrate from the support substrate after the release agent layer absorbs light emitted from the support substrate side.

One of the characteristics of the release agent layer obtained from the release agent composition of the present invention is that the semiconductor substrate can be easily released from the support substrate after irradiation with light.

It is considered that the Novolac resin reacts with the siloxane backbone-containing epoxy resin when the release agent layer is formed from the release agent composition.

The thickness of the release agent layer is not particularly limited, and is ordinarily 0.05 to 3 µm, and is preferably 0.07 µm or more, more preferably 0.1 µm or more, and still more preferably 0.2 µm or more from the viewpoint of maintaining the film strength, and is preferably 2 µm or less, more preferably 1 µm or less, still more preferably 0.8 µm or less, and further preferably 0.5 µm or less from the viewpoint of avoiding non-uniformity caused by a thick film.

The method for forming the release agent layer from the release agent composition will be described in detail in the description of <<Method for Manufacturing One Example of Laminate in First Embodiment A>> described below.

### <<Adhesive Layer>>

The adhesive layer is provided between the support substrate and the semiconductor substrate.

The adhesive layer is in contact with, for example, the semiconductor substrate. The adhesive layer may be in contact with, for example, the support substrate.

The adhesive layer is not particularly limited, but is preferably a layer formed of an adhesive composition.

### <<Adhesive Composition>>

Examples of the adhesive composition (hereinafter referred to as "adhesive composition used in the present invention") include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, a polysiloxane-based adhesive is preferable as the adhesive composition because the adhesive composition exhibits suitable adhesive function during processing of the semiconductor substrate or the like, can be suitably released after processing, is further excellent in heat resistance, and can be suitably removed by the cleaning agent composition.

The adhesive composition here is usually not the adhesive composition for light irradiation release of the present invention.

In a preferred aspect, the adhesive composition contains a polyorganosiloxane.

In another preferred aspect, the adhesive composition contains a component that cures by a hydrosilylation reaction.

For example, the adhesive composition used in the present invention contains a curable component (A) to be an adhesive component. The adhesive composition used in the present invention may contain a component (A) to be cured to be an adhesive component and a component (B) that does not cause a curing reaction. Here, examples of the component (B) that does not cause a curing reaction include a polyorganosiloxane. Note that in the present invention, the expression "does not cause a curing reaction" does not mean not causing any curing reaction, but means not causing a curing reaction occurring in the curable component (A).

In a preferred aspect, the component (A) may be a component to be cured by a hydrosilylation reaction or a polyorganosiloxane component (A') to be cured by a hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having an Si-H group, and a platinum group metal-based catalyst (A2). Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferred aspect, the polyorganosiloxane component (A') that is cured by hydrosilylation reaction includes a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2). The polysiloxane (A1) includes: a polyorganosiloxane (al') containing one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'SiO_{2/2}, and a siloxane unit (T' unit) represented by R⁶'SiO_{3/2}, and also containing at least one selected from the group consisting of M' units, D' units, and T' units; and a polyorganosiloxane (a2') containing one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and also containing at least one selected from the group consisting of M" units, D" units, and T" units.

Note that (al') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹'to R⁶' are each a group bonded to a silicon atom, and each independently represent an optionally substituted alkyl group or an optionally substituted alkenyl group, but at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹"to R⁶" are each a group or atom bonded to a silicon atom and each independently represent an optionally substituted alkyl group or a hydrogen atom, and at least one of R¹"to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, and still more preferably 10 or less.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 to 6.

The alkenyl group may be linear or branched, and the number of carbon atoms thereof is not particularly limited, but is usually 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is usually 4 to 14, preferably 5 to 10, and more preferably 5 to 6.

As described above, the polysiloxane (A1) contains a polyorganosiloxane (al') and a polyorganosiloxane (a2'), and an alkenyl group contained in the polyorganosiloxane (al') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (al') contains one or two or more units selected from the group consisting of Q' units, M' units, D' units, and T' units, and also contains at least one selected from the group consisting of M' units, D' units, and T' units. As the polyorganosiloxane (a1'), two or more polyorganosiloxanes satisfying such conditions may be used in combination.

Examples of the referred combination of two or more units selected from the group consisting of Q' units, M' units, D' units, and T' units include, but are not limited to, (Q' units and M' units), (D' units and M' units), (T' units and M' units), or (Q' units, T' units, and M' units).

When the polyorganosiloxane (al') contains two or more polyorganosiloxanes, a combination of (Q' unit and M' unit) and D' unit and M' unit), a combination of (T' unit and M' unit) and (D' unit and M' unit), and a combination of (Q' unit, T' unit, and M' unit) and (T' unit and M' unit) are preferable, but the combination is not limited thereto.

The polyorganosiloxane (a2') contains one or two or more units selected from the group consisting of Q" units, M" units, D" units, and T" units, and contains at least one selected from the group consisting of M" units, D" units, and T" units. As the polyorganosiloxane (a2'), two or more polyorganosiloxanes satisfying such conditions may be used in combination.

Preferred combinations of two or more selected from the group consisting of Q" unit, M" unit, D" unit, and T" unit include, but are not limited to, (M" unit and D" unit), (Q" unit and M" unit), and (Q" unit, T" unit, and M" unit).

The polyorganosiloxane (al') is composed of siloxane units in which alkyl groups and/or alkenyl groups are bonded to silicon atoms thereof, and the proportion of alkenyl groups in the total substituents represented by R¹' to R⁶' is preferably 0.1 to 50.0% by mol and more preferably 0.5 to 30.0% by mol, and the remaining R¹' to R⁶' may be alkyl groups.

The polyorganosiloxane (a2') is composed of siloxane units in which alkyl groups and/or hydrogen atoms are bonded to silicon atoms thereof, and the proportion of hydrogen atoms among all the substituents and substituted atoms represented by R¹" to R⁶" is preferably 0.1 to 50.0% by mol and more preferably 10.0 to 40.0% by mol, and the remaining R¹" to R⁶" may be alkyl groups.

When the component (A) contains (a1) and (a2), in a preferred aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight average molecular weight of the polysiloxane such as the polyorganosiloxane (a1) or the polyorganosiloxane (a2) is not particularly limited, but each is typically 500 to 1,000,000, and is preferably 5,000 to 50,000 from the viewpoint of achieving the effects of the present invention with good reproducibility.

Note that in the present invention, the weight average molecular weight, the number average molecular weight, and the dispersibility of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (eluent solvent), at a flow rate of 0.35 mL/min, and using polystyrene (Shodex manufactured by Showa Denko K.K.) as a standard sample.

The viscosity of the polyorganosiloxane (a1) and the polyorganosiloxane (a2) is not particularly limited, but each is usually 10 to 1,000,000 (mPa·s), and is preferably 50 to 10,000 (mPa·s) from the viewpoint of achieving the effects of the present invention with good reproducibility. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Accordingly, the mechanism of curing is different from a mechanism, for example, through silanol groups, and therefore, any siloxane does not need to contain a silanol group or a functional group that forms a silanol group by hydrolysis, such as an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, second platinum chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, but is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it is possible to suppress the progress of the hydrosilylation reaction, and specific examples thereof include an alkynyl alcohol (for example, 1-ethynyl-1 cyclohexanol and 1,1-diphenyl-2 propion-1-ol).

The amount of the polymerization inhibitor is not particularly limited, but is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

An example of the adhesive composition used in the present invention may include the component (A) that cures and the component (B) that does not cause a curing reaction to be a release agent component. By including such a component (B) in the adhesive composition, the obtained adhesive layer can be suitably released with good reproducibility.

Typical examples of the component (B) include a noncurable polyorganosiloxane, and specific examples thereof include, but are not limited to, an epoxy group-containing polyorganosiloxane, a methyl group-containing polyorganosiloxane, and a phenyl group-containing polyorganosiloxane.

Examples of the component (B) include polydimethylsiloxane. The polydimethylsiloxane may be modified. Examples of the optionally modified polydimethylsiloxane includes, but are not limited to, an epoxy group-containing polydimethylsiloxane, an unmodified polydimethylsiloxane, or a phenyl group-containing polydimethylsiloxane.

Preferred examples of the polyorganosiloxane as the component (B) include, but are not limited to, an epoxy group-containing polyorganosiloxane, a methyl group-containing polyorganosiloxane, and a phenyl group-containing polyorganosiloxane.

The weight average molecular weight of the polyorganosiloxane as the component (B) is not particularly limited, but is usually 100,000 to 2,000,000, and is preferably 200,000 to 1,200,000, more preferably 300,000 to 900,000 from the viewpoint of achieving the effects of the present invention with good reproducibility. In addition, the dispersibility is not particularly limited, but is usually 1.0 to 10.0, and is preferably 1.5 to 5.0, and more preferably 2.0 to 3.0 from the viewpoint of, for example, achieving suitable release with good reproducibility. Note that the weight average molecular weight and the dispersibility can be measured by the above-described method related to the polyorganosiloxane.

The viscosity of the polyorganosiloxane as the component (B) is not particularly limited, but is usually 1,000 to 2,000,000 mm²/s. Note that the value of the viscosity of the polyorganosiloxane as the component (B) is expressed by kinematic viscosity, and centistokes (cSt) = mm²/s. The value can also be determined by dividing the viscosity (mPa·s) by the density (g/cm³). That is, the value can be determined from the viscosity and density measured with an E-type rotational viscometer at 25°C, and can be calculated from the equation: kinematic viscosity (mm²/s) = viscosity (mPa·s)/density (g/cm³).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group can include the above-described examples.

The epoxy group in the organic group containing an epoxy group may be an independent epoxy group without being fused with another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane may include, but are not limited to, an epoxy group-containing polydimethylsiloxane.

The epoxy group-containing polyorganosiloxane contains the above-described siloxane unit (D¹⁰ unit), but may contain, in addition to D¹⁰ unit, Q units, M units, and/or T units.

In a preferred aspect of the present invention, specific examples of the epoxy group-containing polyorganosiloxane include a polyorganosiloxane composed only of D¹⁰ units, a polyorganosiloxane containing D¹⁰ units and Q units, a polyorganosiloxane containing D¹⁰ units and M units, a polyorganosiloxane containing D¹⁰ units and T units, a polyorganosiloxane containing D¹⁰ units, Q units, and M units, a polyorganosiloxane containing D¹⁰ units, M units, and T units, or a polyorganosiloxane containing D¹⁰ units, Q units, M units, and T units.

The epoxy group-containing polyorganosiloxane is preferably an epoxy group-containing polydimethylsiloxane having an epoxy value of 0.1 to 5. In addition, the weight average molecular weight is not particularly limited, but is usually from 1,500 to 500,000, and is preferably 100,000 or less from the viewpoint of suppressing precipitation in the composition.

Specific examples of the epoxy group-containing polyorganosiloxane include, but are not limited to, those represented by Formulas (E1) to (E3). 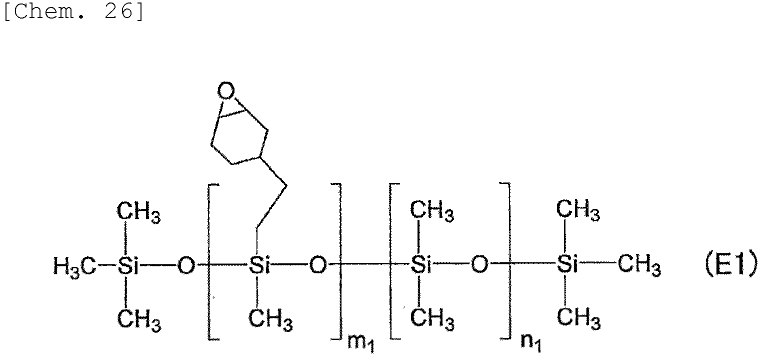 (m₁ and n₁ represent the number of respective repeating units, and are positive integers.) 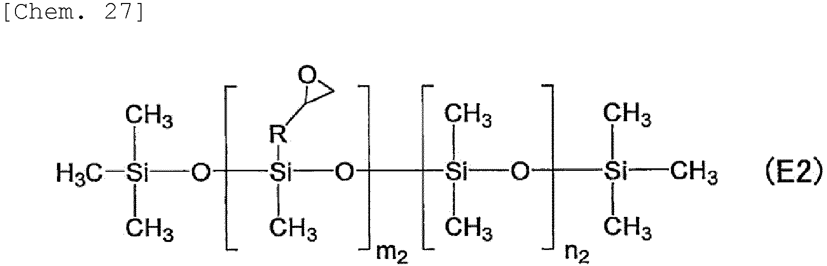 (m₂ and n₂ represent the number of respective repeating units, and are positive integers, and R is an alkylene group having 1 to 10 carbon atoms.) 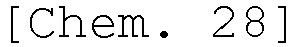 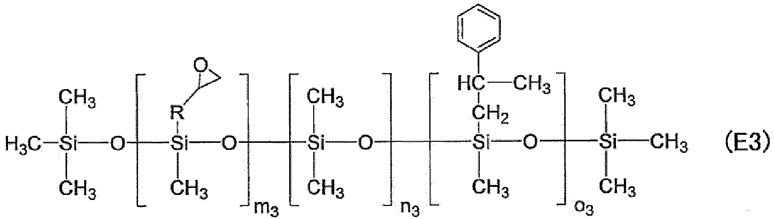 (m₃, n₃, and o₃ represent the number of respective repeating units, and are positive integers, and R is an alkylene group having 1 to 10 carbon atoms.)

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are groups bonded to silicon atoms, and each independently represent an alkyl group, with at least one of R²¹⁰ and R²²⁰ being a methyl group, and specific examples of the alkyl group may include the above-described examples.

R²¹ is a group bonded to a silicon atom and represents an alkyl group, and specific examples of the alkyl group may include the above-described examples. Among them, a methyl group is preferable as R²¹.

In the present invention, preferred examples of the methyl group-containing polyorganosiloxane may include, but are not limited to, a polydimethylsiloxane.

The methyl group-containing polyorganosiloxane contains the above-described siloxane unit (D²⁰⁰ unit or D²⁰ unit), but may contain, in addition to D²⁰⁰ unit and D²⁰ unit, Q units, M units, and/or T units.

In an aspect of the present invention, specific examples of the methyl group-containing polyorganosiloxane include a polyorganosiloxane composed only of D²⁰⁰ units, a polyorganosiloxane containing D²⁰⁰ units and Q units, a polyorganosiloxane containing D²⁰⁰ units and M units, a polyorganosiloxane containing D²⁰⁰ units and T units, a polyorganosiloxane containing D²⁰⁰ units, Q units, and M units, a polyorganosiloxane containing D²⁰⁰ units, M units, and T units, or a polyorganosiloxane containing D²⁰⁰ units, Q units, M units, and T units.

In a preferred aspect of the present invention, specific examples of the methyl group-containing polyorganosiloxane include a polyorganosiloxane composed only of D²⁰ units, a polyorganosiloxane containing D²⁰ units and Q units, a polyorganosiloxane containing D²⁰ units and M units, a polyorganosiloxane containing D²⁰ units and T units, a polyorganosiloxane containing D²⁰ units, Q units, and M units, a polyorganosiloxane containing D²⁰ units, M units, and T units, or a polyorganosiloxane containing D²⁰ units, Q units, M units, and T units.

Specific examples of the methyl group-containing polyorganosiloxane include, but are not limited to, those represented by Formula (M1).

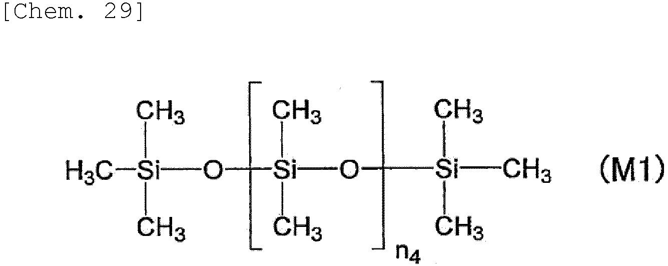

(n₄ represents the number of repeating units, and is a positive integer.)

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group may include the above-described examples, but a methyl group is preferable.

The phenyl group-containing polyorganosiloxane contains the above-described siloxane unit (D³⁰ unit), but may contain, in addition to D³⁰ unit, Q units, M units, and/or T units.

In a preferred aspect of the present invention, specific examples of the phenyl group-containing polyorganosiloxane include a polyorganosiloxane composed only of D³⁰ units, a polyorganosiloxane containing D³⁰ units and Q units, a polyorganosiloxane containing D³⁰ units and M units, a polyorganosiloxane containing D³⁰ units and T units, a polyorganosiloxane containing D³⁰ units, Q units, and M units, a polyorganosiloxane containing D³⁰ units, M units, and T units, or a polyorganosiloxane containing D³⁰ units, Q units, M units, and T units.

Specific examples of the phenyl group-containing polyorganosiloxane include, but are not limited to, those represented by Formula (P1) or (P2). 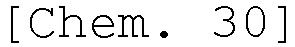 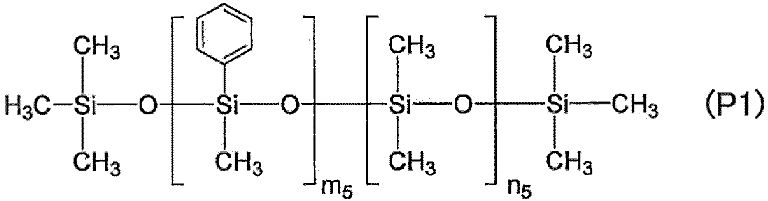 (m₅ and n₅ represent the number of respective repeating units, and are positive integers.) 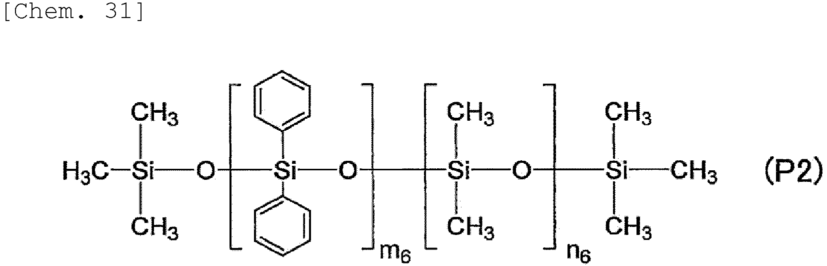 (m₆ and n₆ represent the number of respective repeating units, and are positive integers.)

The polyorganosiloxane as the release agent component (B) may be a commercially available product or a synthetic product.

Examples of commercially available products of the polyorganosiloxane include, but are not limited to, Wacker Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995:0.005 to 30:70, and more preferably 99.9:0.1 to 75:25 in mass ratio [(A): (B)].

That is, when the polyorganosiloxane component (A') cured by a hydrosilylation reaction is contained, the ratio of the component (A') and the component (B) is preferably 99.995:0.005 to 30:70, and more preferably 99.9:0.1 to 75:25 in mass ratio [(A'):(B)].

The viscosity of the adhesive composition used in the present invention is not particularly limited, but is usually 500 to 20,000 mPa·s, and preferably 1,000 to 10,000 mPa·s at 25°C.

An example of the adhesive composition used in the present invention can be manufactured by mixing the component (A) and the component (B) when used with a solvent.

The mixing order is not particularly limited, but examples of the method for easily and reproducibly manufacturing the adhesive composition include, but are not limited to, a method in which the component (A) and the component (B) are dissolved in a solvent, and a method in which a part of the component (A) and the component (B) is dissolved in a solvent, the rest is dissolved in a solvent, and the obtained solution is mixed. Note that when the adhesive composition is prepared, the components may be heated, if appropriate, as long as the components are not decomposed or altered.

In the present invention, for the purpose of removing foreign matter, a solvent, a solution, or the like to be used may be filtered using a filter or the like during the manufacturing of the adhesive composition or after mixing all the components.

The thickness of the adhesive layer included in the laminate of the present invention is not particularly limited, but is usually 5 to 500 µm, and is preferably 10 µm or more, more preferably 20 µm or more, and still more preferably 30 µm or more from the viewpoint of maintaining the film strength, and is preferably 200 µm or less, more preferably 150 µm or less, still more preferably 120 µm or less, and further preferably 70 µm or less from the viewpoint of avoiding nonuniformity caused by a thick film.

The method for forming the adhesive layer from the adhesive composition will be described in detail in the description of <<Method for Manufacturing One Example of Laminate in First Embodiment A>> described below.

Hereinafter, an example of the configuration of the laminate of the first embodiment A will be described with reference to the drawings.

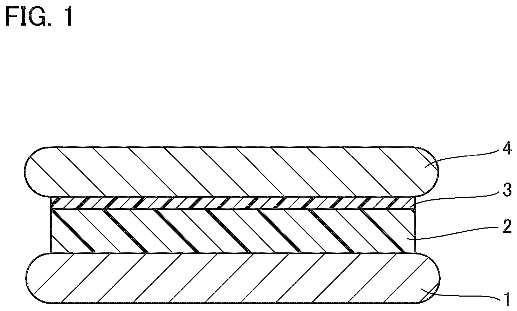

The laminate of Fig. 1 includes a semiconductor substrate 1, an adhesive layer 2, a release agent layer 3, and a support substrate 4 in this order.

The adhesive layer 2 and the release agent layer 3 are provided between the semiconductor substrate 1 and the support substrate 4. The adhesive layer 2 is in contact with the semiconductor substrate 1. The release agent layer 3 is in contact with the adhesive layer 2 and the support substrate 4.

### <<Method for Manufacturing One Example of Laminate in First Embodiment A>>

A method for manufacturing a laminate will be described below, using an example of the laminate shown in Fig. 1 among the laminates in the first embodiment A.

An example of the laminate of the present invention can be manufactured by a method including, for example, the following Step 1 A to Step 3 A.
Step 1 A: a step of applying an adhesive composition onto a semiconductor substrate to form an adhesive coating layer
Step 2 A: a step of applying a release agent composition onto a support substrate to form a release agent layer
Step 3 A: a step of heating the adhesive coating layer in a state where the adhesive coating layer and the release agent layer are in contact with each other to form an adhesive layer.

The coating method for the adhesive composition is not particularly limited, but is usually a spin coating method. Note that a method for separately forming a coating film by a spin coating method or the like, forming a sheet-like coating film, and sticking the sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified, but the heating temperature is usually 80 to 150°C, and the heating time is usually 30 seconds to 5 minutes.

When the adhesive composition contains a solvent, the applied adhesive composition is usually heated.

The film thickness of an adhesive coating layer obtained by applying an adhesive composition and heating the adhesive composition, if necessary, is usually about 5 to 500 µm, and finally, is appropriately determined to fall within the above-described range of the thickness of the adhesive layer.

The coating method for the release agent composition is not particularly limited, but is usually a spin coating method.

The heating temperature of the applied release agent composition varies depending on the type and amount of the release agent component contained in the release agent composition, the desired thickness of the release agent layer, and the like, and thus cannot be generally specified, but from the viewpoint of achieving a suitable release agent layer with good reproducibility, the heating temperature is 80°C or more and 300°C or less, and the heating time is appropriately determined usually in the range of 10 seconds to 10 minutes depending on the heating temperature. The heating temperature is preferably 100°C or higher and 280°C or lower, and more preferably 150°C or higher and 250°C or lower. The heating time is preferably 30 seconds or more and 8 minutes or less, and more preferably 1 minute or more and 5 minutes or less.

The heating can be performed using a hot plate, an oven, or the like.

The film thickness of the release agent layer obtained by applying the release agent composition and heating the release agent composition, if necessary, is usually about 5 nm to 100 µm.

In the present invention, the laminate of the present invention can be obtained by combining such coating layers to be in contact with each other, bringing the two layers into close contact with each other by applying a load in the thickness direction of the semiconductor substrate and the support substrate while performing heat treatment or decompression treatment or both thereof, and then performing post-heat treatment. Note that which treatment condition of heat treatment, decompression treatment, and combination use of both is adopted is appropriately determined in consideration of various circumstances such as the type of the adhesive composition, the specific composition of the release agent composition, the compatibility of films obtained from both compositions, the film thickness, and the required adhesive strength.

The heat treatment is appropriately determined from the range of usually 20 to 150°C from the viewpoint of removing the solvent from the composition, from the viewpoint of softening the adhesive coating layer to achieve suitable bonding with the release agent layer, and the like. In particular, from the viewpoint of suppressing or avoiding excessive curing and unnecessary alteration of the adhesive component (A), the heating temperature is preferably 130°C or lower, and more preferably 90°C or lower, and the heating time is appropriately determined depending on the heating temperature and the type of the adhesive. However, from the viewpoint of reliably exhibiting suitable adhesion, the heating time is usually 30 seconds or longer, and preferably 1 minute or longer. From the viewpoint of suppressing alteration of the adhesive layer and other members, the heating time is usually 10 minutes or shorter, preferably 5 minutes or shorter.

In the decompression treatment, the adhesive coating layer and the release agent layer in contact with each other may be exposed to an atmospheric pressure of 10 to 10,000 Pa. The time for the decompression treatment is usually 1 to 30 minutes.

From the viewpoint of obtaining a laminate in which the substrate can be satisfactorily separated with good reproducibility, the two layers in contact with each other are bonded to each other preferably by decompression treatment, and more preferably by combined use of heat treatment and decompression treatment.

The load in the thickness direction of the semiconductor substrate and the support substrate is not particularly limited as long as the load does not adversely affect the semiconductor substrate, the support substrate, and the two layers therebetween, and can bring them into close contact with each other, but is usually within the range of 10 to 1,000 N.

The temperature of the post-heating is preferably 120°C or higher from the viewpoint of achieving a sufficient curing rate and the like, and is preferably 260°C or lower from the viewpoint of preventing alteration of the substrate and each layer, and the like.

The post-heating time is usually 1 minute or more, and preferably 5 minutes or more from the viewpoint of achieving suitable bonding of the substrate and the layer constituting the laminate, and is usually 180 minutes or less, and preferably 120 minutes or less from the viewpoint of suppressing or avoiding an adverse effect on each layer due to excessive heating, and the like.

Heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the viewpoint of achieving suitable release with good reproducibility.

Note that one object of the post-heat treatment is to achieve an adhesive layer and a release agent layer which are more suitable self-standing films, particularly to suitably achieve curing by a hydrosilylation reaction.

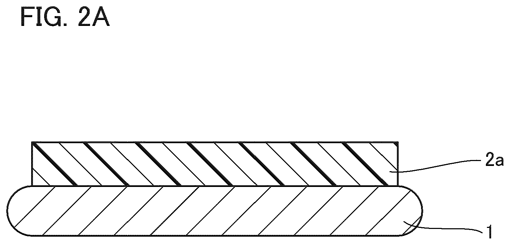

Hereinafter, an example of a method for manufacturing the laminate of Fig. 1 will be described with reference to Figs. 2A to 2C.

Figs. 2A to 2C are views for describing one aspect of manufacturing the laminate.

First, a laminate in which an adhesive coating layer 2a is formed on the semiconductor substrate 1 is prepared (Fig. 2A). This laminate can be obtained, for example, by applying the adhesive composition onto the semiconductor substrate 1, followed by heating.

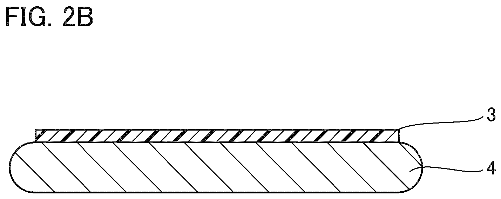

Separately, a laminate in which the release agent layer 3 is formed on the support substrate 4 is prepared (Fig. 2B). This laminate can be obtained, for example, by applying the release agent composition on the support substrate 4, followed by heating.

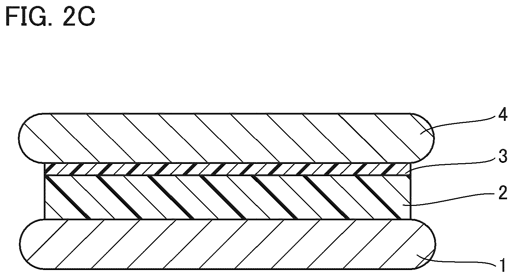

Next, the laminate shown in Fig. 2A and the laminate shown in Fig. 2B are bonded to each other such that the adhesive coating layer 2a and the release agent layer 3 are in contact with each other. Then, after a load is applied in the thickness direction between the semiconductor substrate 1 and the support substrate 4 under reduced pressure, a heating device (not shown, a hot plate) is disposed on the surface opposite to a surface of the semiconductor substrate 1 with which the adhesive coating layer 2a is in contact, and the adhesive coating layer 2a is heated and cured by the heating device to be converted into the adhesive layer 2 (Fig. 2C).

The laminate is obtained by the steps shown in Figs. 2A to 2C.

Note that, in Fig. 1, in the laminate, the semiconductor substrate 1, the adhesive layer 2, the release agent layer 3, and the support substrate 4 are stacked in this order, and thus the above-described manufacturing method has been exemplified. However, for example, when manufacturing a laminate in which the semiconductor substrate 1, the release agent layer 3, the adhesive layer 2, and the support substrate 4 are stacked in this order, the laminate can be manufactured by a method including: Step 1 A of coating a surface of the semiconductor substrate with the release agent composition and, if necessary, heating the release agent composition to form the release agent layer; Step 2 A of coating a surface of the support substrate with the release agent composition and, if necessary, heating the release agent composition to form the adhesive coating layer; and Step 3 A of bringing the release agent layer of the semiconductor substrate and the adhesive coating layer of the support substrate into close contact with each other by applying a load in the thickness direction of the semiconductor substrate and the support substrate while performing at least one of heat treatment and decompression treatment, and then performing post-heat treatment to form the laminate.

Note that as long as the effect of the present invention is not impaired, application and heating of each composition may be sequentially performed on any one of the substrates.

### <Second Embodiment A>

The laminate having an electronic device layer is used for processing of the electronic device layer. While the electronic device layer is being processed, the electronic device layer is adhered to the support substrate. After processing the electronic device layer, the release agent layer is irradiated with light, and then the electronic device layer is separated from the support substrate.

### <<Electronic Device Layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of an electronic component. The electronic device is not particularly limited, and can be one in which various mechanical structures and circuits are formed on the surface of a semiconductor substrate. The electronic device is preferably a composite of a member made of metal or a semiconductor and a resin that seals or insulates the member. The electronic device may be one in which a rewiring layer, which will be described later, and/or a semiconductor element or other elements are sealed or insulated with a sealing material or an insulating material, and has a single-layer or multi-layer structure.

### <<Support Substrate>>

As the support substrate, those similar to those described in the section of <<Support Substrate>> above of <First embodiment A> above are exemplified.

### <<Release Agent Layer>>

The release agent layer is formed using the release agent composition for light irradiation release of the present invention described above.

The detailed description of the release agent layer is as described in the section of <<Release Agent Layer>> above of <First Embodiment A> above.

### <<Adhesive Layer>>

The adhesive layer is formed using the adhesive composition described above.

The detailed description of the adhesive layer is as described in the section of <<Adhesive Layer>> above of <First Embodiment A> above.

Hereinafter, an example of the configuration of the laminate of the second embodiment A will be described with reference to the drawings.

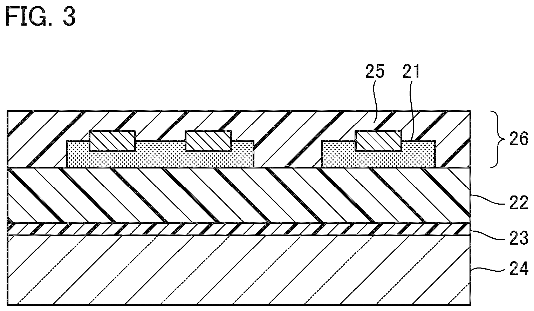

Fig. 3 shows a schematic cross-sectional view of an example of the laminate of the second embodiment **A.**

The laminate of Fig. 3 includes a support substrate 24, a release agent layer 23, an adhesive layer 22, and an electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 and the release agent layer 23 are provided between the electronic device layer 26 and the support substrate 24. The adhesive layer 22 is in contact with the electronic device layer 26. The release agent layer 23 is in contact with the adhesive layer 22 and the support substrate 24.

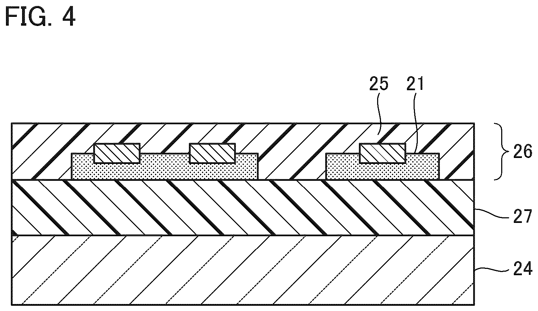

In addition, another example of the configuration of the laminate of the second embodiment A is shown in Fig. 4.

When the release agent layer according to the present invention is a release agent layer having adhesive performance having both the release function and the adhesive function, the laminate may be formed not in a twolayer structure of the release agent layer and the adhesive layer but in a one-layer structure of the release agent layer having adhesive performance.

Fig. 4 shows a schematic cross-sectional view of another example of the laminate.

The laminate of Fig. 4 includes the support substrate 24, a release agent layer 27 having adhesive performance, and the electronic device layer 26 in this order.

The release agent layer 27 having adhesive performance is provided between the support substrate 24 and the electronic device layer 26. The release agent layer 27 having adhesive performance can be prepared by mixing components of a release agent composition that forms a release agent with components of an adhesive composition that forms an adhesive layer.

### <<Method for Manufacturing One Example of Laminate in Second Embodiment A>>

A method for manufacturing a laminate will be described below, using an example of the laminate shown in Fig. 3 among the laminates in the second embodiment A.

The laminate of the present invention can be manufactured, for example, by a method including the following Step 1 A to Step 5 A.
Step 1 A: a step of coating a surface of the support substrate with the release agent composition to form a release agent coating layer (if necessary, further heating is performed to form a release agent layer)
Step 2 A: a step of coating a surface of the release agent coating layer or the release agent layer with the adhesive composition to form an adhesive coating layer (if necessary, further heating is performed to form an adhesive layer)
Step 3 A: a step of placing a semiconductor chip substrate on the adhesive coating layer or the adhesive layer, and bonding the semiconductor chip substrate to the adhesive coating layer or the adhesive layer while performing at least one of heat treatment and decompression treatment
Step 4 A: a step of curing the adhesive coating layer by post-heat treatment to form an adhesive layer
Step 5 A: a step of sealing the semiconductor chip substrate fixed onto the adhesive layer using a sealing resin

To describe Step 3 A in more detail, for example, there is the following step (iA) of the embodiment A.

(iA) The semiconductor chip substrate is placed on the adhesive coating layer or the adhesive layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesive layer.

Note that Step 4 A may be performed after the semiconductor chip substrate in Step 3 A is bonded to the adhesive coating layer, or may be performed in combination with Step 3 A. For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together, and the adhesive layer and the semiconductor chip substrate may be bonded to each other.

In addition, Step 4 A may be performed before Step 3 A, the semiconductor chip substrate may be placed on the adhesive layer, and while a load is applied in the thickness direction of the semiconductor chip substrate and the support substrate, the adhesive layer and the semiconductor chip substrate may be bonded to each other.

The coating method, the heating temperature of the applied release agent composition or adhesive composition, the heating means, and the like are as described in <<Method for Manufacturing One Example of Laminate in First Embodiment A>> above of <First Embodiment A> above.

Hereinafter, the procedure of the method for manufacturing the laminate of the second embodiment A will be described in more detail with reference to the drawings. In this manufacturing method, the laminate shown in Fig. 3 is manufactured.

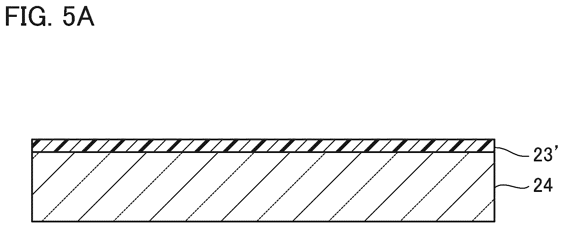

As shown in Fig. 5A, a release agent coating layer 23' made of the release agent composition is formed on the support substrate 24. At that time, the release agent coating layer 23' may be heated to form a release agent layer 23.

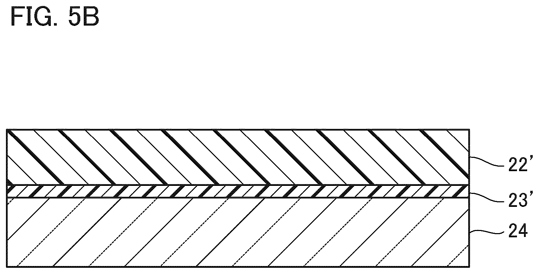

Next, as shown in Fig. 5B, an adhesive coating layer 22' made of the adhesive composition is formed on the release agent coating layer 23' or the release agent layer 23. At that time, the adhesive coating layer 22' may be heated to form the adhesive layer 22.

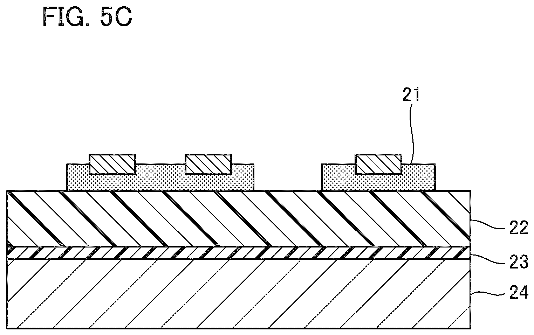

Next, as shown in Fig. 5C, the semiconductor chip substrate 21 is placed on the adhesive layer 22 or the adhesive coating layer 22', and while at least one of the heat treatment and the decompression treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.

Note that when the adhesive coating layer 22' is subjected to the post-heat treatment, the release agent coating layer 23' may also be subjected to the post-heat treatment to form the release agent layer 23.

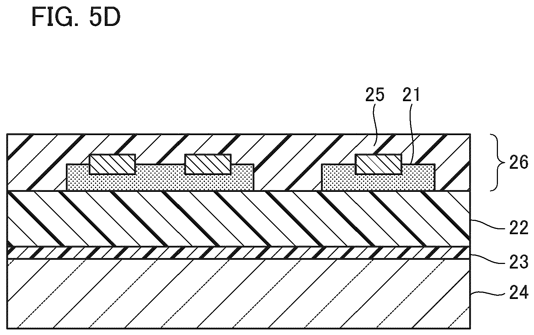

Next, as shown in Fig. 5D, the semiconductor chip substrate 21 fixed onto the adhesive layer 22 is sealed using the sealing resin 25. In Fig. 5D, the plurality of semiconductor chip substrates 21 temporarily adhered onto the support substrate 24 via the adhesive layer 22 is sealed with the sealing resin 25. The electronic device layer 26, which includes the semiconductor chip substrate 21 and the sealing resin 25 between the semiconductor chip substrates 21, is formed on the adhesive layer 22, and as described above, the electronic device layer 26 is a base material layer in which a plurality of semiconductor chip substrates are embedded in the sealing resin.

### <<<Sealing Step>>>

The semiconductor chip substrate 21 is sealed using a sealing material.

As the sealing material for sealing the semiconductor chip substrate 21, a member capable of insulating or sealing a member made of metal or a semiconductor is used.

In the present invention, for example, a resin composition (sealing resin) is used as the sealing material. The type of the sealing resin is not particularly limited as long as the sealing resin can seal and/or insulate metal or a semiconductor, but for example, an epoxy-based resin or a silicone-based resin is preferably used.

The sealing material may contain, in addition to the resin component, other components such as a filler. Examples of the filler include spherical silica particles.

In the sealing step, for example, the sealing resin heated to 130 to 170°C is supplied onto the adhesive layer 22 to cover the semiconductor chip substrate 21 while maintaining a high viscosity state, and is compressionmolded to form a layer including the sealing resin 25 on the adhesive layer 22. At this time, the temperature condition is, for example, 130 to 170°C. In addition, the pressure applied to the semiconductor chip substrate 21 is, for example, 50 to 500 N/cm².

### (Method for Manufacturing Processed Semiconductor Substrate or Electronic Device Layer <Embodiment A>)

When the embodiment A of the laminate according to the present invention is used, a method for manufacturing a processed semiconductor substrate or a method for manufacturing a processed electronic device layer can be provided.

In the "method for manufacturing a processed semiconductor substrate", the laminate described in the section of <First Embodiment A> above of the (Laminate) above is used. In addition, in the "method for manufacturing a processed electronic device layer", the laminate described in the section of <Second Embodiment A> above of the (Laminate) above is used.

The "method for manufacturing a processed semiconductor substrate" will be described in <Third Embodiment A> below, and the "method for manufacturing a processed electronic device layer" will be described in <Fourth Embodiment A> below.

### <Third Embodiment A>

The method for manufacturing a processed semiconductor substrate of the present invention includes the following Step 5A A and the following Step 6A A. The method for manufacturing the processed electronic device layer may further include the following Step 7A **A.**

Here, Step 5A A is a step of processing the semiconductor substrate in the laminate described in the section of <First Embodiment A> above.

In addition, Step 6A A is a step A of separating the semiconductor substrate processed in Step 5A A and the support substrate from each other.

In addition, the Step 7A A is a step of cleaning the processed semiconductor substrate after Step 6A **A.**

The processing performed on the semiconductor substrate in Step 5A A is, for example, processing on the side opposite to the circuit surface of the wafer, and includes thinning of the wafer by polishing the back surface of the wafer. Thereafter, for example, a through silicon via (TSV) or the like is formed, and then the thinned wafer is released from the support substrate to form a laminate of wafers which are three-dimensionally mounted. In addition, for example, before and after that, a wafer back surface electrode and the like are also formed. Heat of approximately 250 to 350°C is applied to thinning of a wafer and a TSV process in a state of being adhered to the support substrate. The laminate of the present invention usually includes the adhesive layer to provide heat resistance to the load.

The processing performed on the semiconductor substrate in Step 5A A may be a step of dicing the semiconductor substrate.

Note that the processing is not limited to the above-described processing, and includes, for example, implementation of a process of mounting a semiconductor component in a case where the semiconductor component is temporarily adhered to the support substrate in order to support a base material for mounting the semiconductor component.

In Step 6A A, examples of the method for separating (releasing) the semiconductor substrate and the support substrate include, but are not limited to, a method for mechanical release using a tool having a sharp portion, a releasing method for separation between the support and the semiconductor wafer, and the like after the irradiation with light to the release agent layer.

By irradiating the release agent layer with light from the support substrate side, the release agent layer is altered (for example, the release agent layer is separated or decomposed) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesive layer, the thickness of the adhesive layer, the thickness of the release agent layer, the intensity of light to be emitted, and the like, but those skilled in the art can appropriately set conditions without requiring an excessive test. For such circumstances, according to the method for manufacturing a processed semiconductor substrate of the present invention, for example, in a case where the support substrate of the laminate to be used is light-transmissive, it is possible to shorten the irradiation time with light when release is performed by irradiation with light from the support substrate side, and as a result, not only improvement in throughput can be expected, but also physical stress and the like required for release can be avoided, and the semiconductor substrate and the support substrate can be easily and efficiently separated from each other only by irradiation with light.

The dose of light required for release is usually 50 to 3,000 mJ/cm². The irradiation time is appropriately determined depending on the wavelength and the irradiation amount.

The wavelength of the light used for release is preferably, for example, a wavelength of 250 to 600 nm, more preferably a wavelength of 250 to 370 nm as described above. A more suitable wavelength is 308 nm, 343 nm, 355 nm, 365 nm, or 532 nm. The irradiation amount of light required for release is an irradiation amount that can cause suitable alteration, for example, decomposition of the Novolac resin.

The light used for release may be laser light or nonlaser light emitted from a light source such as an ultraviolet lamp.

The substrate can be cleaned by spraying a cleaning agent composition onto the surface of at least one of the separated semiconductor substrate and the support substrate, or immersing the separated semiconductor substrate or the support substrate in a cleaning agent composition.

In addition, the surface of the processed semiconductor substrate or the like may be cleaned using a removal tape or the like.

As an example of cleaning the substrate, Step 7A A of cleaning the processed semiconductor substrate may be performed after Step 6A **A.**

Examples of the cleaning agent composition to be used for cleaning include the following.

The cleaning agent composition usually contains a salt and a solvent.

A suitable example of the cleaning agent composition includes a cleaning agent composition containing a quaternary ammonium salt and a solvent.

The quaternary ammonium salt is composed of a quaternary ammonium cation and an anion, and is not particularly limited as long as the quaternary ammonium salt is used for this type of application.

Such quaternary ammonium cations typically include tetra (hydrocarbon) ammonium cations. On the other hand, examples of an anion paired therewith include, but are not limited to, a hydroxide ion (OH⁻); a halogen ion such as a fluorine ion (F⁻), a chlorine ion (Cl⁻), a bromine ion (Br⁻), and an iodine ion (I⁻); a tetrafluoroborate ion (BF₄⁻); or a hexafluorophosphate ion (PF₆⁻).

The quaternary ammonium salt is preferably a halogencontaining quaternary ammonium salt, and more preferably a fluorine-containing quaternary ammonium salt.

In the quaternary ammonium salt, the halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride contains tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, the quaternary ammonium salts such as tetra(hydrocarbon)ammonium fluoride may be used alone or in combination of two or more thereof.

The amount of the quaternary ammonium salt is not particularly limited as long as the quaternary ammonium salt dissolves in the solvent contained in the cleaning agent composition, but is usually 0.1 to 30% by mass with respect to the cleaning agent composition.

The solvent contained in the cleaning agent composition is not particularly limited as long as the solvent is used for this type of application and dissolves a salt such as a quaternary ammonium salt, but from the viewpoint of obtaining a cleaning agent composition having excellent cleanability with good reproducibility, from the viewpoint of obtaining a cleaning agent composition having excellent uniformity by dissolving a salt such as a quaternary ammonium salt satisfactorily, and the like, the cleaning agent composition preferably contains one or more amide-based solvents.

Suitable examples of the amide-based solvents include an acid amide derivative represented by Formula (Z).

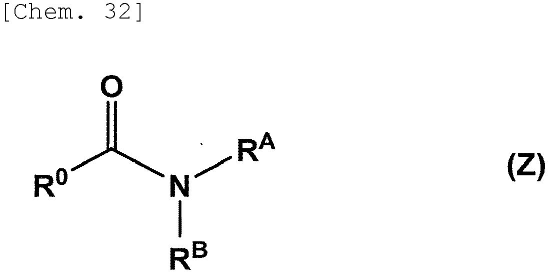

In the formula, R⁰ represents an ethyl group, a propyl group or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, R^{A} and R^{B} are preferably a methyl group or an ethyl group, more preferably a methyl group or an ethyl group, and still more preferably a methyl group.

Examples of the acid amide derivative represented by Formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, or N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by Formula (Z) may be synthesized by a substitution reaction between a corresponding carboxylic acid ester and an amine, or a commercially available product may be used.

Another example of the preferred amide-based solvents includes a lactam compound represented by Formula (Y).

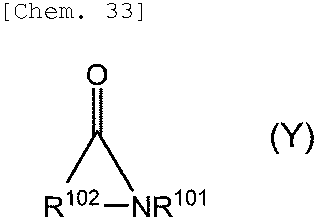

In Formula (Y), R¹⁰¹ represents a hydrogen atom or an alkyl group having 1 to 6 carbon atoms, and R¹⁰² represents an alkylene group having 1 to 6 carbon atoms. Specific examples of the alkyl group having 1 to 6 carbon atoms include a methyl group, an ethyl group, an n-propyl group, and an n-butyl group, and specific examples of the alkylene group having 1 to 6 carbon atoms include, but are not limited to, a methylene group, an ethylene group, a trimethylene group, a tetramethylene group, a pentamethylene group, and a hexamethylene group.

Specific examples of the lactam compound represented by Formula (Y) may include an α-lactam compound, a β-lactam compound, a γ-lactam compound, and a δ-lactam compound, and these compounds can be used alone or in combination of two or more thereof.

In a preferred aspect, the lactam compound represented by Formula (Y) contains 1-alkyl-2 pyrrolidone (N-alkyl-γ-butyrolactam), in a more preferred aspect, N-methylpyrrolidone (NMP) or N-ethylpyrrolidone (NEP), and in a still more preferred aspect, N-methylpyrrolidone (NMP).

The cleaning agent composition may contain one or more other organic solvents different from the above-described amide compound.

Such other organic solvents are used for this type of application, and are not particularly limited as long as the other organic solvents are organic solvents compatible with the above-described amide compound.

Examples of other preferred solvents include alkylene glycol dialkyl ethers, aromatic hydrocarbon compounds, and cyclic structure-containing ether compounds, but are not limited thereto.

The amount of the other organic solvent different from the above-described amide compound is usually appropriately determined to be 95% by mass or less in the solvent contained in the cleaning agent composition as long as the quaternary ammonium salt contained in the cleaning agent composition is not precipitated or separated, and is uniformly mixed with the above-described amide compound.

In addition, the cleaning agent composition may contain water as the solvent, but usually, only an organic solvent is intended to be used as the solvent from the viewpoint of avoiding corrosion of the substrate and the like. In this case, it is not denied that hydrated water of the salt or trace amounts of water contained in the organic solvent is contained in the cleaning agent composition. The water content of the cleaning agent composition is usually 5% by mass or less.

The constituent elements and method elements related to the above-described steps of the embodiment A of the method for manufacturing a processed semiconductor substrate of the present invention may be variously changed without departing from the gist of the present invention.

The embodiment A of the method for manufacturing a processed semiconductor substrate of the present invention may include steps other than the above-described steps.

In the releasing method of the present invention, when the semiconductor substrate or the support substrate of the laminate of the present invention is light-transmissive, the semiconductor substrate and the support substrate of the laminate are separated from each other by irradiating the release agent layer with light from the semiconductor substrate side or the support substrate side.

In an example of the laminate of the present invention, since the semiconductor substrate and the support substrate are temporarily adhered to each other by the adhesive layer and the release agent layer to be suitably releasable, for example, when the support substrate is light-transmissive, the semiconductor substrate and the support substrate can be easily separated from each other by irradiating the release agent layer with light from the support substrate side of the laminate. Usually, release is performed after the semiconductor substrate of the laminate is processed.

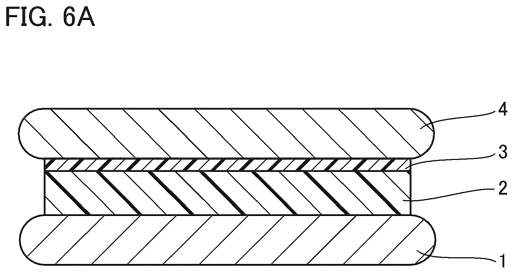

An example of the third embodiment A will be described with reference to Figs. 6A to 6D. This example is an example of manufacturing a thinned semiconductor substrate.

First, a laminate is prepared (Fig. 6A). This laminate is the same laminate as the laminate shown in Figs. 1 and 2C.

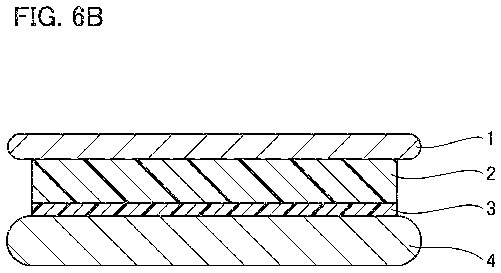

Next, the surface of the semiconductor substrate 1 opposite to a surface in contact with the adhesive layer 2 is polished using a polishing apparatus (not shown) to thin the semiconductor substrate 1 (Fig. 6B). Note that a through electrode may be formed on the thinned semiconductor substrate 1.

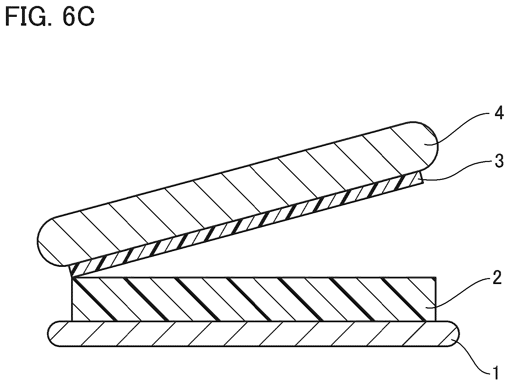

Next, after the release agent layer 3 is irradiated with light from the support substrate 4 side, the thinned semiconductor substrate 1 and the support substrate 4 are separated from each other using a releasing device (not shown) (Fig. 6C).

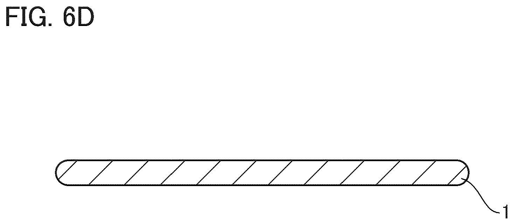

Then, the thinned semiconductor substrate 1 is obtained (Fig. 6D).

Here, residues of the adhesive layer 2 and the release agent layer 3 may remain on the thinned semiconductor substrate 1. Accordingly, it is preferable to clean the thinned semiconductor substrate 1 using the cleaning agent composition to remove the residues of the adhesive layer 2 and the release agent layer 3 from the semiconductor substrate 1.

### <Fourth Embodiment A>

The method for manufacturing a processed electronic device layer of the present invention includes the following Step 5B A and the following Step 6B A. The method for manufacturing a processed electronic device layer may further include the following Step 7B A.

Here, Step 5B A is a step of processing the electronic device layer in the laminate described in the section of <Second Embodiment A> above.

In addition, Step 6B A is a step of separating the electronic device layer processed in Step 5B A from the support substrate.

In addition, Step 7B A is a step of cleaning the processed electronic device layer after Step 6B A.

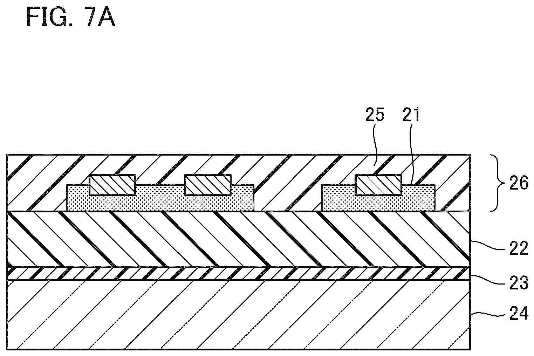

Hereinafter, a specific example of the fourth embodiment A will be described with reference to Figs. 7A to 7F.

Examples of the processing performed on the electronic device layer in Step 5B A include a grinding step and a wiring layer forming step.

### <<Grinding Step>>

The grinding step is a step of grinding the resin part of the layer of the sealing resin 25 in the electronic device layer 26 such that a part of the semiconductor chip substrate 21 is exposed.

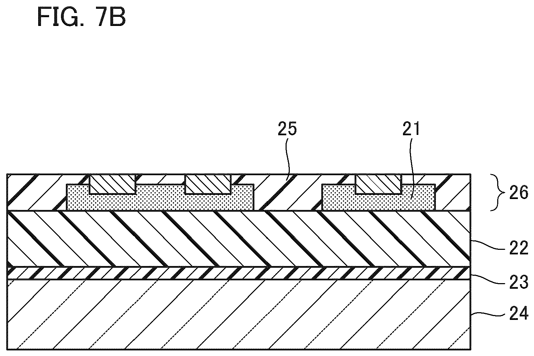

For example, as shown in Fig. 7B, the sealing resin part is ground by grinding the layer of the sealing resin 25 of the laminate shown in Fig. 7A until the layer has a thickness substantially equal to that of the semiconductor chip substrate 21. Note that the laminate shown in Fig. 7A is the same laminate as the laminate shown in Figs. 3 and 5D.

### <<Wiring Layer Forming Step>>

The wiring layer forming step is a step of forming a wiring layer on the exposed semiconductor chip substrate 21 after the grinding step.

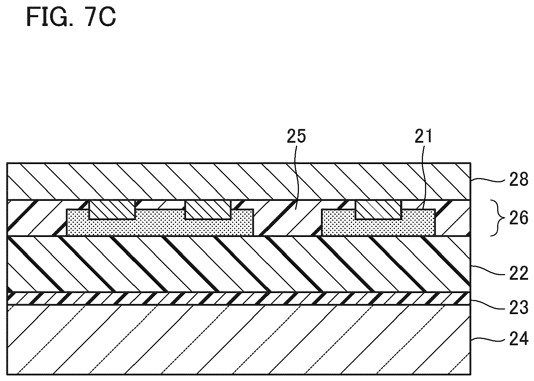

In Fig. 7C, a wiring layer 28 is formed on the electronic device layer 26 including a layer of the semiconductor chip substrate 21 and the sealing resin 25.

The wiring layer 28 is also called a redistribution layer (RDL), is a thin-film wiring body constituting wiring connected to a substrate, and may have a single-layer or multi-layer structure. The wiring layer may be, but is not limited to, one in which wiring is formed of a conductor (for example, metals such as aluminum, copper, titanium, nickel, gold, and silver, and alloys such as a silver-tin alloy) between dielectrics (for example, photosensitive resin such as silicon oxide (SiOₓ) and photosensitive epoxy) .

Examples of the method for forming the wiring layer 28 include the following methods.

First, a dielectric layer of silicon oxide (SiOₓ), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the wiring, for example, known semiconductor process techniques such as lithography processing such as photolithography (registry lithography) or etching processing can be used. Examples of such lithography processing include lithography processing using a positive resist material and lithography processing using a negative resist material.

In the method for manufacturing a laminate according to the fourth embodiment A, a bump can be further formed or an element can be mounted on the wiring layer 28. The element can be mounted on the wiring layer 28 using, for example, a chip mounter or the like.

The laminate according to the fourth embodiment A may be a laminate prepared in a process based on a fan-out type technology in which a terminal provided on a semiconductor chip substrate is mounted on a wiring layer extending outside a chip area.

In Step 6B A, examples of the method for separating (releasing) the electronic device layer and the support substrate include, but are not limited to, a method for mechanical releasing using a tool having a sharp portion, a releasing method for separation between the support and the electronic device layer, and the like after the irradiation with light to the release agent layer.

By irradiating the release agent layer with light from the support substrate side, the release agent layer is altered (for example, the release agent layer is separated or decomposed) as described above, and thereafter, for example, one of the substrates is pulled up, and the electronic device layer and the support substrate can be easily separated from each other.

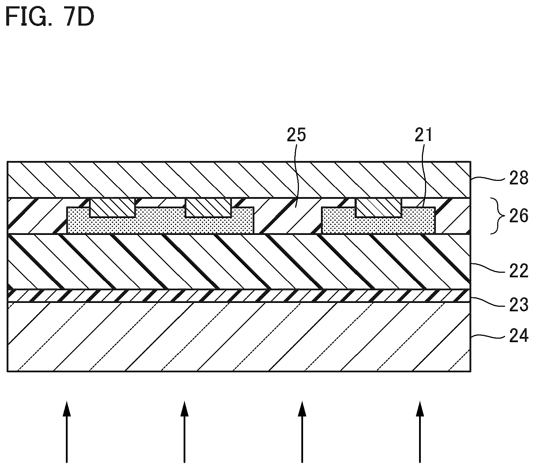

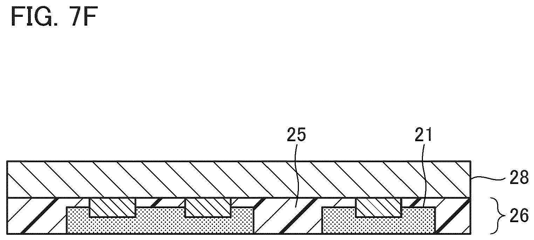

Figs. 7D to 7E are schematic cross-sectional views for describing a separation method for the laminate, and Fig. 7F is a schematic cross-sectional view for describing a cleaning method after separation of the laminate. One embodiment of the method for manufacturing a semiconductor package (electronic component) can be described with reference to Figs. 7D to 7F.

As shown in Fig. 7D, the step of separating the laminate is a step of separating the electronic device layer 26 and the support substrate 24 from each other by irradiating the release agent layer 23 with light (arrow) through the support substrate 24 to alter the release agent layer 23.

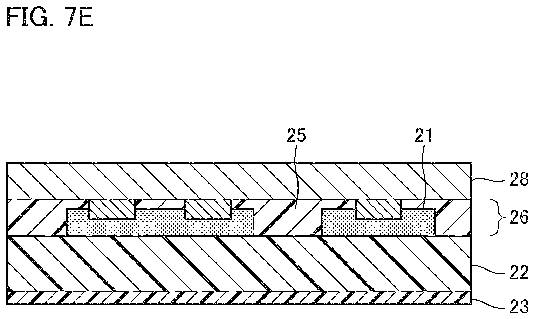

After irradiating the release agent layer 23 with light (arrow) to alter the release agent layer 23, the support substrate 24 is separated from the electronic device layer 26 as shown in Fig. 7E.

The irradiation conditions, irradiation methods, and the like of irradiation of the adhesive layer with light are as described in the section of <Third Embodiment A> above.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 7E, the adhesive layer 22 and the release agent layer 23 are attached to the electronic device layer 26 after the separation step, but the adhesive layer 22 and the release agent layer 23 can be removed by decomposing the adhesive layer 22 and the release agent layer 23 using a cleaning agent composition such as acid or alkali. By removing the release agent layer and the adhesive layer, a processed electronic device layer (electronic component) as shown in Fig. 7F can be suitably obtained.

The constituent elements and method elements related to the above-described steps of the method for manufacturing a processed electronic device layer of the present invention may be variously changed without departing from the gist of the present invention.

The embodiment A of the method for manufacturing a processed electronic device layer of the present invention may include steps other than the above-described steps.

In the embodiment A of the laminate of the present invention, since the electronic device layer and the support substrate are temporarily adhered to each other by the adhesive layer to be suitably releasable, for example, when the support substrate is light-transmissive, the electronic device layer and the support substrate can be easily separated from each other by irradiating the release agent layer with light from the support substrate side of the laminate. Usually, release is performed after the electronic device layer of the laminate is processed.

### (Laminate <Embodiment B>)

Embodiment B of the laminate according to the present invention includes a semiconductor substrate or an electronic device layer, a support substrate, and an adhesive layer for light irradiation release.

The support substrate is light-transmissive.

The adhesive for light irradiation release is provided between the semiconductor substrate or the electronic device layer and the support substrate.

The embodiment B of the laminate is used for release of the semiconductor substrate or the electronic device layer from the support substrate after the adhesive layer absorbs light emitted from the support substrate side.

The adhesive layer for light irradiation release is a layer formed from the adhesive composition for light irradiation release of the present invention described above.

In the embodiment B of the laminate, by using the adhesive layer formed from the adhesive composition for light irradiation release of the present invention, excellent releasability is obtained even without having a release agent layer.

The embodiment B of the laminate of the present invention is used for temporary adhesion for processing the semiconductor substrate or the electronic device layer, and can be suitably used for processing such as thinning of the semiconductor substrate or the electronic device layer.

While the semiconductor substrate is subjected to processing such as thinning, the semiconductor substrate is supported by the support substrate. On the other hand, after the processing of the semiconductor substrate, the adhesive layer is irradiated with light, and then, the support substrate and the semiconductor substrate are separated from each other. Due to the Novolac resin contained in the adhesive composition for light irradiation release of the present invention, in the adhesive layer formed from the adhesive composition, the Novolac resin absorbs light (for example, laser light) to alter (for example, separates or decomposes) the adhesive layer. As a result, after the adhesive layer is irradiated with light, the semiconductor substrate is easily released from the support substrate.

In addition, while the electronic device layer is subjected to processing such as thinning, the electronic device layer is supported by the support substrate. Meanwhile, after the processing of the electronic device layer, the adhesive layer is irradiated with light, and thereafter, the support substrate and the electronic device layer are separated from each other.

With the adhesive layer according to the present invention, the semiconductor substrate or the electronic device layer and the support substrate are easily released after irradiation with light. Furthermore, the residue of the adhesive layer remaining on the semiconductor substrate, the electronic device layer, or the support substrate after the semiconductor substrate or the electronic device layer and the support substrate are released can be removed with, for example, a cleaning agent composition for cleaning the semiconductor substrate or the like.

Since the adhesive layer of the laminate of the present invention is formed of a single layer, the laminate can be easily manufactured and is excellent in productivity.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable alteration, for example, decomposition of the Novolac resin.

The light used for release may be laser light or non-laser light emitted from a light source such as an ultraviolet lamp.

Hereinafter, a case where the laminate includes a semiconductor substrate and a case where the laminate includes an electronic device layer will be described in detail separately.

The case where the laminate includes a semiconductor substrate will be described in the following <First Embodiment B>, and the case where the laminate includes an electronic device layer will be described in the following <Second Embodiment B>.

### <First Embodiment B>

The laminate having a semiconductor substrate is used for processing the semiconductor substrate. While the semiconductor substrate is processed, the semiconductor substrate is adhered to the support substrate. After the semiconductor substrate is processed, the semiconductor substrate is separated from the support substrate after the adhesive layer is irradiated with light.

Examples of the semiconductor substrate include the semiconductor substrate described in <First embodiment A>.

Examples of the support substrate include the support substrate described in <First Embodiment A>.

### <<Adhesive Layer>>

The adhesive layer is a layer formed of an adhesive composition.

The adhesive layer is provided between the support substrate and the semiconductor substrate.

The adhesive layer may be in contact with the support substrate or may be in contact with the semiconductor substrate.

The adhesive layer is formed using the adhesive composition for light irradiation release of the present invention described above.

The adhesive composition of the present invention can be suitably used for forming an adhesive layer of a laminate including a semiconductor substrate, a support substrate, and an adhesive layer provided between the semiconductor substrate and the support substrate. The laminate is used for releasing the semiconductor substrate and the support substrate after the adhesive layer absorbs light emitted from the support substrate side.

One of the characteristics of the adhesive layer obtained from the adhesive composition of the present invention is that the semiconductor substrate and the support substrate can be easily released after irradiation with light.

It is considered that the Novolac resin reacts with the siloxane backbone-containing epoxy resin when the adhesive layer is formed from the adhesive composition.

The thickness of the adhesive layer is not particularly limited, and is usually 1 to 500 µm, and is preferably 1.5 µm or more, more preferably 2 µm or more, and still more preferably 3 µm or more from the viewpoint of maintaining the film strength, and is preferably 500 µm or less, more preferably 200 µm or less, still more preferably 100 µm or less, and further preferably 50 µm or less from the viewpoint of avoiding non-uniformity caused by a thick film.

The thickness of the adhesive layer can be measured by using, for example, an optical or contact type film thickness meter.

The method for forming the adhesive layer from the adhesive composition will be described in detail in the description of <<Method for Manufacturing One Example of Laminate in First Embodiment B>> described below.

Hereinafter, an example of the configuration of the laminate of the first embodiment B will be described with reference to the drawings.

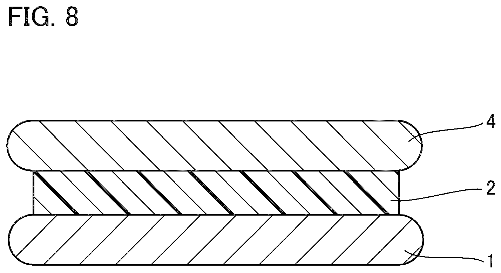

The laminate of Fig. 8 includes the semiconductor substrate 1, the adhesive layer 2, and the support substrate 4 in this order.

The adhesive layer 2 is provided between the semiconductor substrate 1 and the support substrate 4. The adhesive layer 2 is in contact with the semiconductor substrate 1 and the support substrate 4.

### <<Method for Manufacturing One Example of Laminate in First Embodiment B>>

A method for manufacturing a laminate will be described below, using an example of the laminate shown in Fig. 8 among the laminates in the first embodiment B.

An example of the laminate of the present invention can be manufactured by a method including, for example, the following Step 1 B to Step 2 B.
Step 1 B: a step of applying an adhesive composition onto a semiconductor substrate to form an adhesive coating layer
Step 2 B: a step of heating the adhesive coating layer to form an adhesive layer

The coating method for the adhesive composition is not particularly limited, but is usually a spin coating method. Note that a method for separately forming a coating film by a spin coating method or the like, forming a sheet-like coating film, and sticking the sheet-like coating film as an adhesive coating layer can be adopted.

The heating temperature of the applied adhesive composition varies depending on the type and amount of the adhesive component contained in the adhesive composition, the boiling point of the solvent to be used, the desired thickness of the adhesive layer, and the like, and thus cannot be generally specified, but from the viewpoint of achieving a suitable adhesive layer with good reproducibility, the heating temperature is 80°C or more and 300°C or less, and the heating time is appropriately determined usually in the range of 10 seconds to 10 minutes depending on the heating temperature. The heating temperature is preferably 100°C or higher and 280°C or lower, and more preferably 150°C or higher and 250°C or lower. The heating time is preferably 30 seconds or more and 8 minutes or less, and more preferably 1 minute or more and 5 minutes or less.

Heating can be performed using a hot plate, an oven, or the like.

Usually, the applied adhesive composition is heated.

The film thickness of an adhesive coating layer obtained by applying an adhesive composition and heating the adhesive composition, if necessary, is usually about 1 to 500 µm, and finally, is appropriately determined to fall within the above-described range of the thickness of the adhesive layer.

In the present invention, the laminate of the present invention can be obtained by applying a load in the thickness direction of the semiconductor substrate and the support substrate while performing heat treatment or decompression treatment or both thereof, and then performing post-heat treatment. Note that the treatment conditions to be adopted, whether heat treatment, decompression treatment, or a combination of both, are appropriately determined taking into consideration various factors such as the type of adhesive composition, the film thickness, and the desired adhesive strength.

The heat treatment is appropriately determined from the range of usually 20 to 160°C from the viewpoint of removing the solvent from the composition. In particular, from the viewpoint of suppressing or avoiding excessive curing and unnecessary alteration of the adhesive component (A), the heating temperature is preferably 150°C or lower, and more preferably 130°C or lower, and the heating time is appropriately determined depending on the heating temperature and the type of the adhesive. However, from the viewpoint of reliably exhibiting suitable adhesion, the heating time is usually 30 seconds or longer, preferably 1 minute or longer. From the viewpoint of suppressing alteration of the adhesive layer and other members, the heating time is usually 10 minutes or shorter, preferably 5 minutes or shorter.

In the decompression treatment, the adhesive coating layer and the release agent layer in contact with each other may be exposed to an atmospheric pressure of 10 to 10,000 Pa. The time for the decompression treatment is usually 1 to 30 minutes.

The load in the thickness direction of the semiconductor substrate and the support substrate is not particularly limited as long as the load does not adversely affect the semiconductor substrate, the support substrate, and the layers therebetween, and can bring them into close contact with each other, but is usually within the range of 10 to 50,000 N.

The temperature of the post-heating is preferably 120°C or higher from the viewpoint of achieving a sufficient curing rate and the like, and is preferably 260°C or lower from the viewpoint of preventing alteration of the substrate and each layer, and the like.

The post-heating time is usually 1 minute or more, and preferably 5 minutes or more from the viewpoint of achieving suitable bonding of the substrate and the layer constituting the laminate, and is usually 180 minutes or less, preferably 120 minutes or less from the viewpoint of suppressing or avoiding an adverse effect on each layer due to excessive heating, and the like.

The heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the viewpoint of achieving suitable release with good reproducibility.

One object of the post-heating treatment is to realize an adhesive layer which is a more suitable self-standing film.

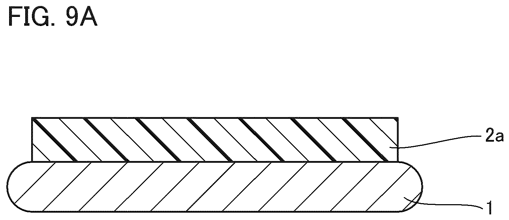

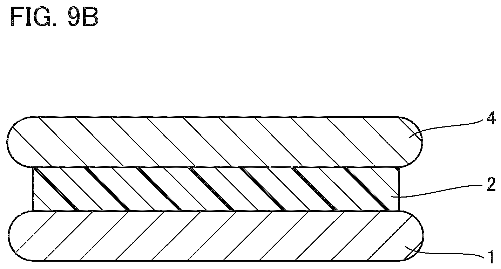

Hereinafter, an example of a method for manufacturing the laminate of Fig. 8 will be described with reference to Figs. 9A and 9B.

Figs. 9A and 9B are views for describing one aspect of manufacturing the laminate.

First, a laminate in which an adhesive coating layer 2a is formed on the semiconductor substrate 1 is prepared (Fig. 9A). This laminate can be obtained, for example, by applying the adhesive composition onto the semiconductor substrate 1, followed by heating.

Next, the laminate shown in Fig. 9A and the support substrate 4 are bonded to each other such that the adhesive coating layer 2a and the support substrate 4 are in contact with each other. Then, after a load is applied in the thickness direction between the semiconductor substrate 1 and the support substrate 4 under reduced pressure, a heating device (not shown; a hot plate) is disposed on the surface opposite to a surface of the semiconductor substrate 1 with which the adhesive coating layer 2a is in contact, and the adhesive coating layer 2a is heated and cured by the heating device to be converted into the adhesive layer 2 (Fig. 9B).

The laminate shown in Fig. 8 is obtained by the steps shown in Figs. 9A and 9B.

Note that as long as the effect of the present invention is not impaired, application and heating of the adhesive composition may be sequentially performed on any one of the substrates.

### <Second Embodiment B>

The laminate having an electronic device layer is used for processing of the electronic device layer. While the electronic device layer is being processed, the electronic device layer is adhered to the support substrate. After the electronic device layer is processed, the electronic device layer is separated from the support substrate after the adhesive layer is irradiated with light.

### <<Electronic Device Layer>>

As the electronic device layer, those similar to those described in the section of <<Electronic Device Layer>> above of <Second embodiment Embodiment A> above are exemplified.

### <<Support Substrate>>

As the support substrate, those similar to those described in the section of <<Support Substrate>> above of <First Embodiment A> above are exemplified.

### <<Adhesive Layer>>

The adhesive layer is formed using the adhesive composition for light irradiation release of the present invention described above.

The detailed description of the adhesive layer is as described in the section of <<Adhesive Layer>> above of <First Embodiment B> above.

Hereinafter, an example of the configuration of the laminate of the second embodiment B will be described with reference to the drawings.

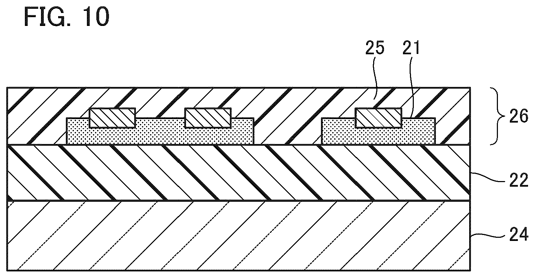

Fig. 10 shows a schematic cross-sectional view of an example of the laminate of the second embodiment B.

The laminate in Fig. 10 includes the support substrate 24, the adhesive layer 22, and the electronic device layer 26 in this order.

The electronic device layer 26 includes the plurality of semiconductor chip substrates 21 and the sealing resin 25 which is a sealing material disposed between the semiconductor chip substrates 21.

The adhesive layer 22 is provided between the electronic device layer 26 and the support substrate 24. The adhesive layer 22 is in contact with the electronic device layer 26 and the support substrate 24.

### <<Method for Manufacturing One Example of Laminate in Second Embodiment B>>

A method for manufacturing a laminate will be described below, using an example of the laminate shown in Fig. 10 among the laminates in the second embodiment B.

The laminate of the present invention can be manufactured, for example, by a method including the following Step 1 B to Step 4 B.
Step 1 B: a step of coating a surface of the support substrate with the adhesive composition to form an adhesive coating layer (if necessary, further heating is performed to form an adhesive layer)
Step 2 B: a step of placing a semiconductor chip substrate on the adhesive coating layer or the adhesive layer, and bonding the semiconductor chip substrate to the adhesive coating layer or the adhesive layer while performing at least one of heat treatment and decompression treatment
Step 3 B: a step of curing the adhesive coating layer by post-heat treatment to form an adhesive layer
Step 4 B: a step of sealing the semiconductor chip substrate fixed onto the adhesive layer using a sealing resin

To describe Step 2 B in more detail, for example, there is the following step (iB) of the embodiment.

(iB) The semiconductor chip substrate is placed on the adhesive coating layer or the adhesive layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesive layer.

Note that Step 3 B may be performed after the semiconductor chip substrate in Step 2 B is bonded to the adhesive coating layer, or may be performed in combination with Step 2 B. For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together, and the adhesive layer and the semiconductor chip substrate may be bonded to each other.

In addition, Step 3 B may be performed before Step 2 B, the semiconductor chip substrate may be placed on the adhesive layer, and while a load is applied in the thickness direction of the semiconductor chip substrate and the support substrate, the adhesive layer and the semiconductor chip substrate may be bonded to each other.

The coating method, the heating temperature of the applied adhesive composition, the heating means, and the like are as described in <<Method for Manufacturing One Example of Laminate in First Embodiment B>> above of <First Embodiment B> above.

Hereinafter, the procedure of the method for manufacturing the laminate of the second embodiment B will be described in more detail with reference to the drawings. In this manufacturing method, the laminate shown in Fig. 10 is manufactured.

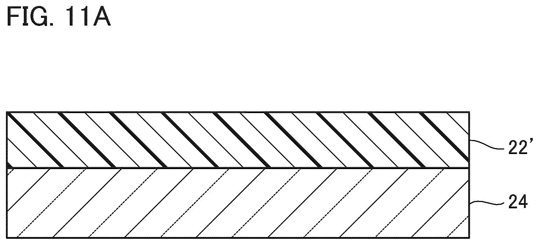

As shown in Fig. 11A, the adhesive coating layer 22' made of the adhesive composition is formed on the support substrate 24. At that time, the adhesive coating layer 22' may be heated to form the adhesive layer 22.

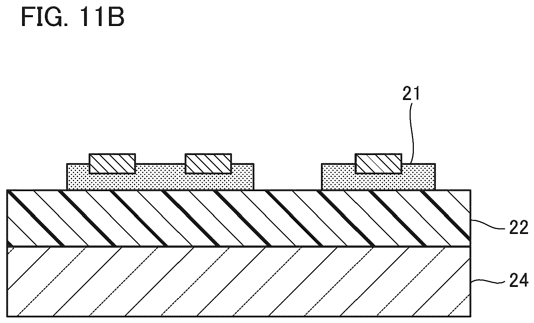

Next, as shown in Fig. 11B, the semiconductor chip substrate 21 is placed on the adhesive layer 22 or the adhesive coating layer 22', and while at least one of the heat treatment and the decompression treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.

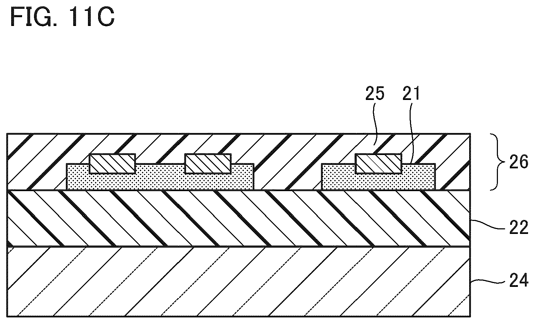

Next, as shown in Fig. 11C, the semiconductor chip substrate 21 fixed onto the adhesive layer 22 is sealed using the sealing resin 25. In Fig. 11C, the plurality of semiconductor chip substrates 21 temporarily adhered onto the support substrate 24 via the adhesive layer 22 is sealed with the sealing resin 25. The adhesive layer 26, which includes the semiconductor chip substrate 21 and the sealing resin 25 disposed between the semiconductor chip substrates 21, is formed on the adhesion layer 22, and as described above, the electronic device layer 26 is a base material layer in which a plurality of semiconductor chip substrates are embedded in the sealing resin.

### <<<Sealing Step>>>

The semiconductor chip substrate 21 is sealed using a sealing material.

As the sealing material for sealing the semiconductor chip substrate 21, a member capable of insulating or sealing a member made of metal or a semiconductor is used.

In the present invention, for example, a resin composition (sealing resin) is used as the sealing material. The type of the sealing resin is not particularly limited as long as the sealing resin can seal and/or insulate metal or a semiconductor, but for example, an epoxy-based resin or a silicone-based resin is preferably used.

The sealing material may contain, in addition to the resin component, other components such as a filler. Examples of the filler include spherical silica particles.

In the sealing step, for example, the sealing resin heated to 130 to 170°C is supplied onto the adhesive layer 22 to cover the semiconductor chip substrate 21 while maintaining a high viscosity state, and is compression-molded to form a layer including the sealing resin 25 on the adhesive layer 22. At this time, the temperature condition is, for example, 130 to 170°C. In addition, the pressure applied to the semiconductor chip substrate 21 is, for example, 50 to 500 N/cm².

### (Method for Manufacturing Processed Semiconductor Substrate or Electronic Device Layer)

When the laminate according to the present invention is used, a method for manufacturing a processed semiconductor substrate or a method for manufacturing a processed electronic device layer can be provided.

In the "method for manufacturing a processed semiconductor substrate", the laminate described in the section of <First Embodiment> above of the (Laminate) above is used. In addition, in the "method for manufacturing a processed electronic device layer", the laminate described in the section of <Second Embodiment B> above of the (Laminate) above is used.

The "method for manufacturing a processed semiconductor substrate" will be described in <Third Embodiment B> below, and the "method for manufacturing a processed electronic device layer" will be described in <Fourth Embodiment A> below.

### <Third Embodiment B>

The method for manufacturing a processed semiconductor substrate of the present invention includes the following Step 5A B and the following Step 6A B. The method for manufacturing the processed electronic device layer may further include the following Step 7A B.

Here, Step 5A B is a step B of processing the semiconductor substrate in the laminate described in the section of <First Embodiment B> above.

In addition, Step 6A is a step of separating the semiconductor substrate processed in Step 5A B and the support substrate from each other.

In addition, the Step 7A B is a step of cleaning the processed semiconductor substrate after Step 6A B.

The processing performed on the semiconductor substrate in Step 5A B is, for example, processing on the side opposite to the circuit surface of the wafer, and includes thinning of the wafer by polishing the back surface of the wafer. Thereafter, for example, a through silicon via (TSV) or the like is formed, and then the thinned wafer is released from the support substrate to form a laminate of wafers which are three-dimensionally mounted. In addition, for example, before and after that, a wafer back surface electrode and the like are also formed. Heat of approximately 250 to 350°C is applied to thinning of a wafer and a TSV process in a state of being adhered to the support substrate. The laminate of the present invention usually includes the adhesive layer to provide heat resistance to the load.

The processing performed on the semiconductor substrate in the 5A step B may be a step of dicing the semiconductor substrate.

Note that the processing is not limited to the above-described processing, and includes, for example, implementation of a process of mounting a semiconductor component in a case where the semiconductor component is temporarily adhered to the support substrate in order to support a base material for mounting the semiconductor component.

In Step 6A B, examples of the method for separating (releasing) the semiconductor substrate and the support substrate include, but are not limited to, a method for mechanical release using a tool having a sharp portion, a releasing method for separation between the support and the semiconductor wafer, and the like after the irradiation with light to the adhesive layer.

The irradiation of the adhesive layer with light from the support substrate side causes alteration of the adhesive layer (for example, separation or decomposition of the adhesive layer) as described above, and can easily separate the semiconductor substrate and the support substrate by, for example, pulling up one of the substrates thereafter.

The irradiation of the adhesive layer with light does not necessarily have to be performed on the entire region of the adhesive layer. Even when a region irradiated with light and a region not irradiated with light are mixed, the semiconductor substrate and the support substrate can be separated from each other by a slight external force such as pulling up of the support substrate, for example, as long as the releasing ability is sufficiently improved as the entire adhesive layer. The ratio and positional relationship between the region irradiated with light and the region not irradiated with light vary depending on the type and specific composition of the adhesive to be used, the thickness of the adhesive layer, the intensity of the light to be emitted, and the like, but those skilled in the art can appropriately set conditions without requiring an excessive test. For such circumstances, according to the method for manufacturing a processed semiconductor substrate of the present invention, for example, in a case where the support substrate of the laminate to be used is light-transmissive, it is possible to shorten the irradiation time with light when release is performed by irradiation with light from the support substrate side, and as a result, not only improvement in throughput can be expected, but also physical stress and the like required for release can be avoided, and the semiconductor substrate and the support substrate can be easily and efficiently separated from each other only by irradiation with light.

The dose of light required for release is usually 50 to 3,000 mJ/cm². The irradiation time is appropriately determined depending on the wavelength and the irradiation amount.

The wavelength of the light used for release is preferably, for example, a wavelength of 250 to 600 nm, more preferably a wavelength of 250 to 370 nm as described above. A more suitable wavelength is 308 nm, 343 nm, 355 nm, 365 nm, or 532 nm. The irradiation amount of light required for release is an irradiation amount that can cause suitable alteration, for example, decomposition of the Novolac resin.

The light used for release may be laser light or non-laser light emitted from a light source such as an ultraviolet lamp.

The substrate can be cleaned by spraying a cleaning agent composition onto the surface of at least one of the separated semiconductor substrate and the support substrate, or immersing the separated semiconductor substrate or the support substrate in a cleaning agent composition.

In addition, the surface of the processed semiconductor substrate or the like may be cleaned using a removal tape or the like.

As an example of cleaning the substrate, Step 7A of cleaning the processed semiconductor substrate may be performed after Step 6A B.

Examples of the cleaning agent composition used for cleaning include those described in <Third Embodiment A> above.

The constituent elements and method elements related to the above-described steps of the embodiment B of the method for manufacturing a processed semiconductor substrate of the present invention may be variously changed without departing from the gist of the present invention.

The embodiment B of the method for manufacturing a processed semiconductor substrate of the present invention may include steps other than the above-described steps.

In the releasing method of the present invention, when the semiconductor substrate or the support substrate of the laminate of the present invention is light-transmissive, the semiconductor substrate and the support substrate of the laminate are separated from each other by irradiating the adhesive layer with light from the semiconductor substrate side or the support substrate side.

In an example of the laminate of the present invention, since the semiconductor substrate and the support substrate are temporarily adhered to each other by the adhesive layer to be suitably releasable, for example, when the support substrate is light-transmissive, the semiconductor substrate and the support substrate can be easily separated from each other by irradiating the adhesive layer with light from the support substrate side of the laminate. Usually, release is performed after the semiconductor substrate of the laminate is processed.

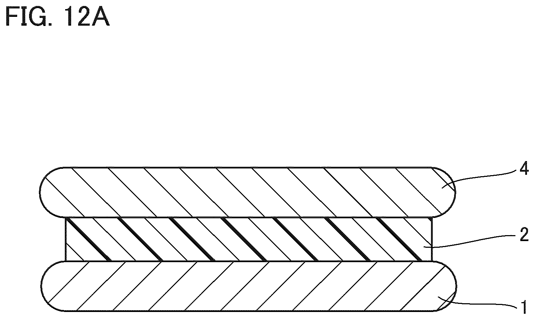

An example of the third embodiment B will be described with reference to Figs. 12A to 12D. This example is an example of manufacturing a thinned semiconductor substrate.

First, a laminate is prepared (Fig. 12A). This laminate is the same laminate as the laminate shown in Figs. 8 and 9B.

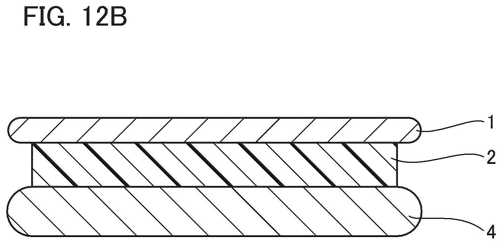

Next, the surface of the semiconductor substrate 1 opposite to a surface in contact with the adhesive layer 2 is polished using a polishing apparatus (not shown) to thin the semiconductor substrate 1 (Fig. 12B). Note that a through electrode may be formed on the thinned semiconductor substrate 1.

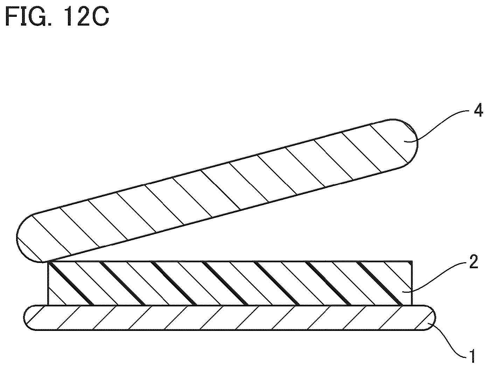

Next, after the adhesive layer 2 is irradiated with light from the support substrate 4 side, the thinned semiconductor substrate 1 and the support substrate 4 are separated from each other using a releasing device (not shown) (Fig. 12C).

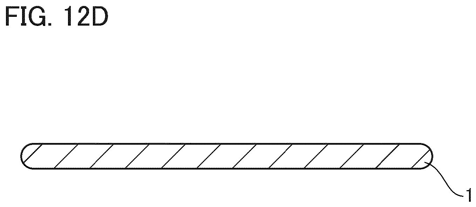

Then, the thinned semiconductor substrate 1 is obtained (Fig. 12D).

Here, residues of the adhesive layer 2 may remain on the thinned semiconductor substrate 1. Accordingly, it is preferable to clean the thinned semiconductor substrate 1 using the cleaning agent composition to remove the residues of the adhesive layer 2 from the semiconductor substrate 1.

### <Fourth Embodiment B>

The method for manufacturing a processed electronic device layer of the present invention includes the following Step 5B B and the following Step 6B B. The method for manufacturing a processed electronic device layer may further include the following Step 7B B.

Here, Step 5B B is a step B of processing the electronic device layer in the laminate described in the section of <Second Embodiment B> above.

In addition, Step 6B B is a step of separating the electronic device layer processed in Step 5B B from the support substrate.

In addition, Step 7B B is a step of cleaning the processed electronic device layer after Step 6B B.

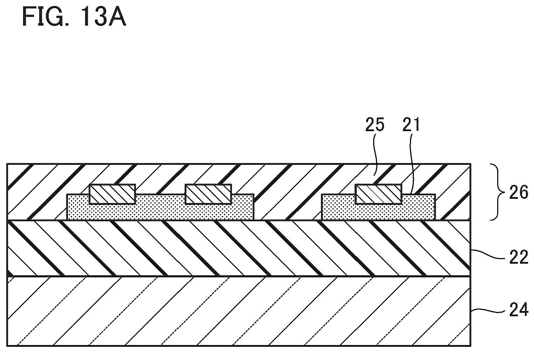

Hereinafter, a specific example of the fourth embodiment B will be described with reference to Figs. 13A to 13F.

Examples of the processing performed on the electronic device layer in Step 5B B include a grinding step and a wiring layer forming step.

### <<Grinding Step>>

The grinding step is a step of grinding the resin part of the layer of the sealing resin 25 in the electronic device layer 26 such that a part of the semiconductor chip substrate 21 is exposed.

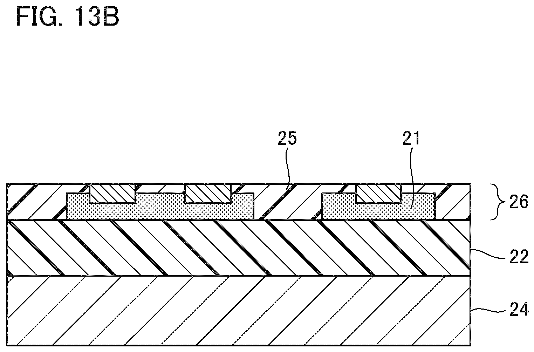

For example, as shown in Fig. 13B, the sealing resin part is ground by grinding the layer of the sealing resin 25 of the laminate shown in Fig. 13A until the layer has a thickness substantially equal to that of the semiconductor chip substrate 21. Note that the laminate shown in Fig. 13A is the same laminate as the laminate shown in Figs. 10 and 11C.

### <<Wiring Layer Forming Step>>

The wiring layer forming step is a step of forming a wiring layer on the exposed semiconductor chip substrate 21 after the grinding step.

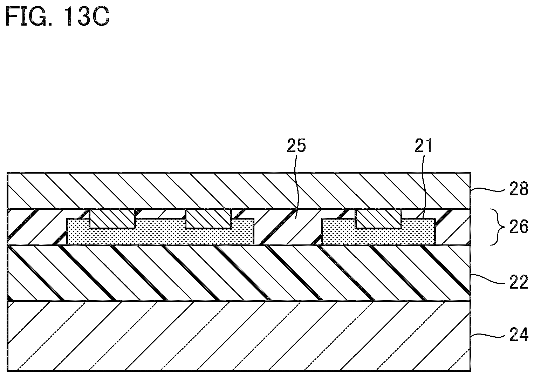

In Fig. 13C, a wiring layer 28 is formed on the electronic device layer 26 including a layer of the semiconductor chip substrate 21 and the sealing resin 25.

The wiring layer 28 is also called a redistribution layer (RDL), is a thin-film wiring body constituting wiring connected to a substrate, and may have a single-layer or multi-layer structure. The wiring layer 28 may be, but is not limited to, one in which wiring is formed of a conductor (for example, metals such as aluminum, copper, titanium, nickel, gold, and silver, and alloys such as a silver-tin alloy) between dielectrics (for example, photosensitive resin such as silicon oxide (SiOₓ) and photosensitive epoxy).

Examples of the method for forming the wiring layer 28 include the method described in <<Wiring Layer Forming Step>> of <Fourth Embodiment A> above.

In the method for manufacturing a laminate according to a fourth embodiment B, a bump can be further formed or an element can be mounted on the wiring layer 28. The element can be mounted on the wiring layer 28 using, for example, a chip mounter or the like.

The laminate according to the fourth embodiment B may be a laminate prepared in a process based on a fan-out type technology in which a terminal provided on a semiconductor chip substrate is mounted on a wiring layer extending outside a chip area.

In Step 6B B, examples of the method for separating (releasing) the electronic device layer and the support substrate include, but are not limited to, a method for mechanical releasing using a tool having a sharp portion, a releasing method for separation between the support and the electronic device layer, and the like after the irradiation with light to the adhesive layer.

The irradiation of the adhesive layer with light from the support substrate side causes alteration of the adhesive layer (for example, separation or decomposition of the adhesive layer) as described above, and can easily separate the electronic device layer and the support substrate by, for example, pulling up one of the substrates thereafter.

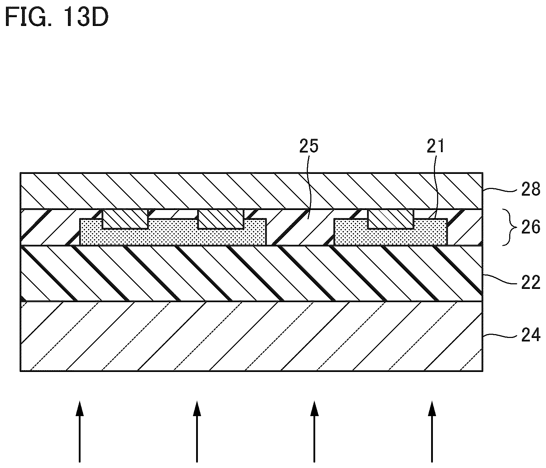

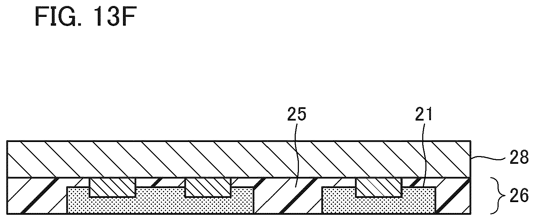

Figs. 13D to 13E are schematic cross-sectional views for describing a separation method for the laminate, and Fig. 13F is a schematic cross-sectional view for describing a cleaning method after separation of the laminate. One embodiment of the method for manufacturing a semiconductor package (electronic component) can be described with reference to Figs. 13D to 13F.

As shown in Fig. 13D, the step of separating the laminate is a step of separating the electronic device layer 26 and the support substrate 24 by irradiating the adhesive layer 22 with light (arrow) through the support substrate 24 to alter the adhesive layer 22.

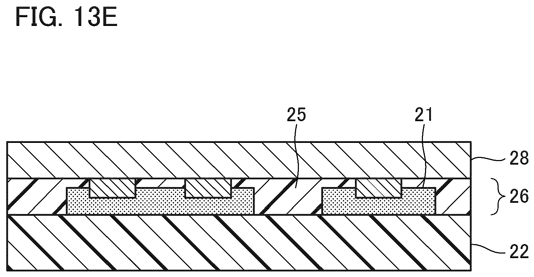

After the adhesive layer 22 is irradiated with light (arrow) to alter the adhesive layer 22, the support substrate 24 is separated from the electronic device layer 26 as shown in Fig. 13E.

The irradiation conditions, irradiation methods, and the like of irradiation of the adhesive layer 22 with light are as described in the section of <Third Embodiment B> above.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 13E, the adhesive layer 22 adheres to the electronic device layer 26 after the separation step, but the adhesive layer 22 can be removed by decomposing the adhesive layer 22 using a cleaning agent composition such as an acid or an alkali. By removing the adhesive layer, a processed electronic device layer (electronic component) as shown in Fig. 13F can be suitably obtained.

The constituent elements and method elements related to the above-described steps of the method for manufacturing a processed electronic device layer of the present invention may be variously changed without departing from the gist of the present invention.

The embodiment B of the method for manufacturing a processed electronic device layer of the present invention may include steps other than the above-described steps.

In the embodiment B of the laminate of the present invention, since the electronic device layer and the support substrate are temporarily adhered to each other by the adhesive layer to be suitably releasable, for example, when the support substrate is light-transmissive, the electronic device layer and the support substrate can be easily separated from each other by irradiating the adhesive layer with light from the support substrate side of the laminate. Usually, release is performed after the electronic device layers of the laminate are processed.

### Examples

Hereinafter, the present invention will be more specifically described with reference to examples, but the present invention is not limited to the following examples. Note that the apparatus used is as follows.

### (First Example)

Hereinafter, examples of the release agent composition of the present invention will be described as a first example.

### [Apparatus]

(1) Stirrer: planetary centrifugal mixer ARE-500 manufactured by Thinky Corporation
(2) Vacuum bonding apparatus: XBS300 manufactured by SÜSS MicroTec SE
(3) Dicing machine: SS30 manufactured by Tokyo Seimitsu Co., Ltd.
(4) Optical film thickness meter (film thickness measurement): F-50 manufactured by Filmetrics Corporation
(5) Laser irradiation apparatus: Lambda SX manufactured by Coherent, Inc.

### [A1] Preparation of Adhesive Composition

### [Preparation Example A1]

In a 600 mL stirring vessel dedicated to the stirrer were put 80 g of an MQ resin (manufactured by Wacker Chemie GmbH) containing a polysiloxane and a vinyl group, 2.52 g of SiH group-containing linear polydimethylsiloxane (manufactured by Wacker Chemie GmbH) having a viscosity of 100 mPa·s, 5.89 g of SiH group-containing linear polydimethylsiloxane (manufactured by Wacker Chemie GmbH) having a viscosity of 70 mPa·s, and 0.22 g of 1-ethynyl-1-cyclohexanol (manufactured by Wacker Chemie GmbH), followed by stirring with the stirrer for 5 minutes to obtain a mixture (I).

0.147 g of a platinum catalyst (manufactured by Wacker Chemie GmbH) and 5.81 g of vinyl group-containing linear polydimethylsiloxane (manufactured by Wacker Chemie GmbH) having a viscosity of 1,000 mPa·s were stirred with the stirrer for 5 minutes to obtain a mixture (II).

3.96 g of the mixture (II) was added to the mixture (I), and the obtained mixture was stirred with a stirrer for 5 minutes to form a mixture (III).

Finally, the obtained mixture (III) was filtered through a nylon filter 300 mesh to obtain an adhesive composition. The viscosity of the adhesive composition measured with a viscometer was 10,000 mPa·s.

### [A2] Preparation of Cleaning Agent Composition

### [Preparation Example A2]

5 g of tetrabutylammonium fluoride trihydrate (manufactured by KANTO CHEMICAL CO., INC.) was mixed with 95 g of N-methyl-2 pyrrolidone, and the mixture was well stirred to obtain a cleaning agent composition.

### [A3] Synthesis of Novolac Resin

### [Synthesis Example A1]

A flask was charged with 10.0 g of 2,2'-dihydroxybiphenyl, 4.19 g of 1-naphthalenaldehyde, 6.24 g of 1-pyrenecarboxaldehyde, 77 g of methanesulfonic acid, and 49.48 g of propylene glycol monomethyl ether acetate as a solvent, and reflux stirring was carried out overnight under a nitrogen atmosphere. The obtained reaction mixture was allowed to cool, then diluted by adding 96 g of tetrahydrofuran, and the obtained diluted solution was added dropwise to methanol to obtain a precipitate. The obtained precipitate was recovered by filtration, and the filtrate was cleaned with methanol, and dried at 60°C under reduced pressure to obtain the Novolac resin. As a result of measurement by the following method, the weight average molecular weight of the Novolac resin as a polymer was 5,300.

The weight average molecular weight was measured using a GPC apparatus (EcoSEC, HLC-8220GPC manufactured by Tosoh Corporation) and a GPC column (Shodex KF-803L, KF-802, and KF-801 manufactured by Showa Denko K.K., used in this order), at a column temperature of 40°C, using tetrahydrofuran as an eluent (elution solvent), at a flow rate of 1.00 mL/min, and using polystyrene (manufactured by Sigma-Aldrich) as a standard sample.

The obtained Novolac resin has the following repeating units.

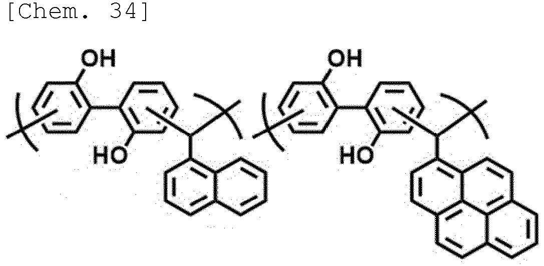

### [Synthesis Example A2]

A flask was charged with 10.0 g of carbazole, 7.69 g of terephthalaldehydic acid, 0.74 g of methanesulfonic acid, and 42.99 g of propylene glycol monomethyl ether acetate as a solvent, which were heated and stirred overnight at 120°C in a nitrogen atmosphere. The obtained reaction mixture was allowed to cool, then diluted by adding 96 g of tetrahydrofuran, and the obtained diluted solution was added dropwise to methanol to obtain a precipitate. The obtained precipitate was recovered by filtration, and the filtrate was cleaned with methanol, and dried at 60°C under reduced pressure to obtain the Novolac resin. As a result of measurement by the following method, the weight average molecular weight of the Novolac resin as a polymer was 9,300.

The weight average molecular weight was measured using a GPC apparatus (EcoSEC, HLC-8220GPC manufactured by Tosoh Corporation) and a GPC column (Shodex KF-803L, KF-802, and KF-801 manufactured by Showa Denko K.K., used in this order), at a column temperature of 40°C, using tetrahydrofuran as an eluent (elution solvent), at a flow rate of 1.00 mL/min, and using polystyrene (manufactured by Sigma-Aldrich) as a standard sample.

The obtained Novolac resin has the following repeating units.

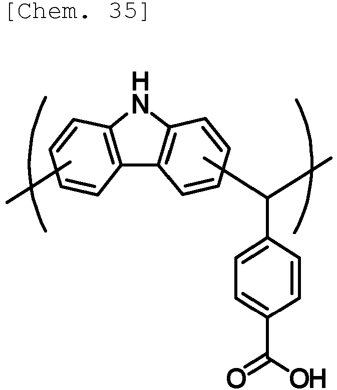

### [Synthesis Example A3]

A flask was charged with 7.4 g of tertiary butoxystyrene, 7.38 g of 4-amyloxybenzaldehyde, and 10.0 g of propylene glycol monomethyl ether as a solvent, and the mixture was stirred. After stirring, 10.0 g of N,N'-diphenyl-1,4-phenylenediamine, 1.1 g of methanesulfonic acid, and 31.1 g of propylene glycol monomethyl ether as a solvent were added and heated and stirred at 110°C overnight in a nitrogen atmosphere. Propylene glycol monomethyl ether acetate and pure water were added to the reaction solution, and the mixture was stirred. Thereafter, liquid separation treatment was performed, and the organic layer was recovered and concentrated to obtain a Novolac resin. As a result of measurement by the following method, the weight average molecular weight of the Novolac resin as a polymer was 1,200.

The weight average molecular weight was measured using a GPC apparatus (EcoSEC, HLC-8220GPC manufactured by Tosoh Corporation) and a GPC column (Shodex KF-803L, KF-802, and KF-801 manufactured by Showa Denko K.K., used in this order), at a column temperature of 40°C, using tetrahydrofuran as an eluent (elution solvent), at a flow rate of 1.00 mL/min, and using polystyrene (manufactured by Sigma-Aldrich) as a standard sample.

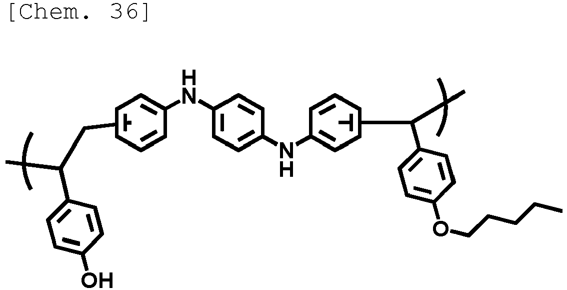

### [A4] Preparation of Release Agent Composition

### [Preparation Example A3]

3.4 g of the Novolac resin obtained in Synthesis Example A1, 0.4 g of epoxy-modified silicone KF-105 (manufactured by Shin-Etsu Chemical Co., Ltd.), and 0.4 g of epoxy-modified silicone KF-1005 (manufactured by Shin-Etsu Chemical Co., Ltd.) as a crosslinking agent were dissolved in 46.0 g of propylene glycol monomethyl ether acetate as a solvent, and the obtained solution was filtered using a polyethylene microfilter having a pore size of 0.2 µm to obtain a release agent composition 1.

### [Preparation Example A4]

2.7 g of the Novolac resin obtained in Synthesis Example A2, and 0.8 g of epoxy-modified silicone KF-1005 (manufactured by Shin-Etsu Chemical Co., Ltd.) as a crosslinking agent were dissolved in 46.0 g of propylene glycol monomethyl ether acetate as a solvent, and the obtained solution was filtered using a polyethylene microfilter having a pore size of 0.2 µm to obtain a release agent composition 2.

### [Preparation Example A5]

3.3 g of the Novolac resin obtained in Synthesis Example A1, and 0.7 g of epoxy-modified silicone EP-3400L (manufactured by ADEKA Corporation) as a crosslinking agent were dissolved in 46.0 g of propylene glycol monomethyl ether acetate as a solvent, and the obtained solution was filtered using a polyethylene microfilter having a pore size of 0.2 µm to obtain a release agent composition 3.

### [Preparation Example A6]

3.7 g of the Novolac resin obtained in Synthesis Example A1, and 0.4 g of epoxy-modified silicone KR-470 (manufactured by Shin-Etsu Chemical Co., Ltd.) as a crosslinking agent were dissolved in 46.0 g of propylene glycol monomethyl ether acetate as a solvent, and the obtained solution was filtered using a polyethylene microfilter having a pore size of 0.2 µm to obtain a release agent composition 4.

### [Preparation Example A7]

2.9 g of the Novolac resin obtained in Synthesis Example A2 and 0.6 g of epoxy-modified silicone KR-470 (manufactured by Shin-Etsu Chemical Co., Ltd.) as a crosslinking agent were dissolved in 46.0 g of propylene glycol monomethyl ether acetate as a solvent, and the obtained solution was filtered using a polyethylene microfilter having a pore size of 0.2 µm to obtain a release agent composition 5.

### [Preparation Example A8]

2.9 g of the Novolac resin obtained in Synthesis Example A2, and 0.6 g of epoxy-modified silicone EP-3400L (manufactured by ADEKA Corporation) as a crosslinking agent were dissolved in 23.3 g of propylene glycol monomethyl ether acetate and 23.3 g of propylene glycol monomethyl ether were used as solvents, and the obtained solution was filtered using a polyethylene microfilter having a pore size of 0.2 µm to obtain a release agent composition 6.

### [Preparation Example A9]

3.3 g of the Novolac resin obtained in Synthesis Example A2 and 0.7 g of 1,3-bis[2-(7-oxabicyclo[4.1.0]heptane-3-yl)ethyl]-1,1,3,3-tetramethyldisiloxane as a crosslinking agent were dissolved in 23.3 g of propylene glycol monomethyl ether acetate and 23.3 g of propylene glycol monomethyl ether as solvents, and the obtained solution was filtered using a polyethylene microfilter having a pore size of 0.2 µm to obtain a release agent composition 7.

### [Preparation Example A10]

3.3 g of the Novolac resin obtained in Synthesis Example A1, 0.3 g of epoxy-modified silicone KF-105 (manufactured by Shin-Etsu Chemical Co., Ltd.), 0.3 g of epoxy-modified silicone KF-1005 (manufactured by Shin-Etsu Chemical Co., Ltd.) as a crosslinking agent, and 0.03 g of 2-phenyl-1-benzyl-1H-imidazole as a curing catalyst were dissolved in 46.0 g of propylene glycol monomethyl ether acetate as a solvent, and the obtained solution was filtered using a polyethylene microfilter having a pore size of 0.2 µm to obtain a release agent composition 8.

### [Preparation Example A11]

3.6 g of the Novolac resin obtained in Synthesis Example A1, 0.4 g of epoxy-modified silicone KR-470 (manufactured by Shin-Etsu Chemical Co., Ltd.) as a crosslinking agent, and 0.04 g of 2-phenyl-1-benzyl-1H-imidazole as a curing catalyst were dissolved in 46.0 g of propylene glycol monomethyl ether acetate as a solvent, and the obtained solution was filtered using a polyethylene microfilter having a pore size of 0.2 µm to obtain a release agent composition 9.

### [Preparation Example A12]

3.6 g of the Novolac resin obtained in Synthesis Example A1, 0.4 g of epoxy-modified silicone KR-470 (manufactured by Shin-Etsu Chemical Co., Ltd.) as a crosslinking agent, and 0.04 g of tetrabutylammonium fluoride trihydrate as a curing catalyst were dissolved in 23.3 g of propylene glycol monomethyl ether acetate and 23.3 g of propylene glycol monomethyl ether were used as solvents, and the obtained solution was filtered using a polyethylene microfilter having a pore size of 0.2 µm to obtain a release agent composition 10.

### [Preparation Example A13]

2.7 g of the Novolac resin obtained in Synthesis Example A3, and 0.3 g of epoxy-modified silicone KF-1005 (manufactured by Shin-Etsu Chemical Co., Ltd.) as a crosslinking agent were dissolved in 27.0 g of propylene glycol monomethyl ether acetate as a solvent, and the obtained solution was filtered using a polyethylene microfilter having a pore size of 0.2 µm to obtain a release agent composition 11.

### [Comparative Preparation Example A1]

4.0 g of the Novolac resin obtained in Synthesis Example A1 was dissolved in 46.0 g of propylene glycol monomethyl ether acetate as a solvent, and the obtained solution was filtered using a polyethylene microfilter having a pore size of 0.2 µm to obtain a release agent composition 12.

### [Comparative Preparation Example A2]

3.6 g of the Novolac resin obtained in Synthesis Example A1, and 0.4 g of phenylmethylsilicone KF-54 (manufactured by Shin-Etsu Chemical Co., Ltd.) as a crosslinking agent were dissolved in 46.0 g of propylene glycol monomethyl ether acetate as a solvent, and the obtained solution was filtered using a polyethylene microfilter having a pore size of 0.2 µm to obtain a release agent composition 13.

The structures of the crosslinking agents used in the first example and the second example are shown below.

### Epoxy-modified silicone KF-105 (manufactured by Shin-Etsu Chemical Co., Ltd.)

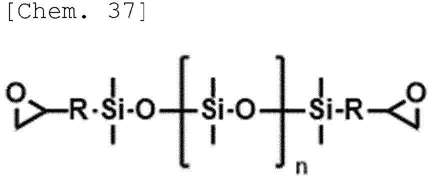

### Epoxy-modified silicone KF-1005 (manufactured by Shin-Etsu Chemical Co., Ltd.)

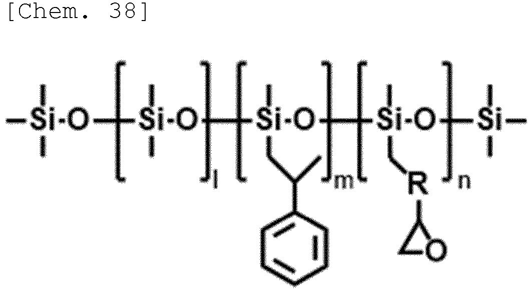

### Epoxy-modified silicone EP-3400L (manufactured by ADEKA Corporation)

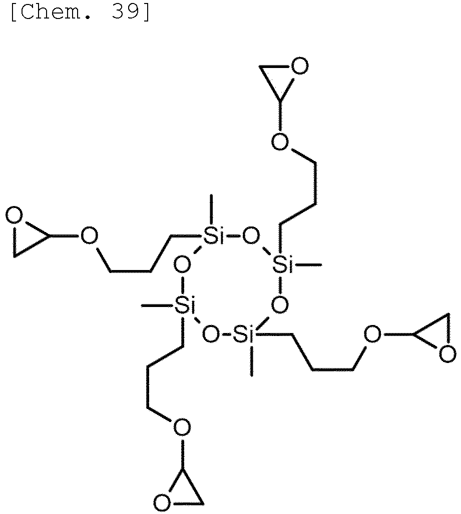

### Epoxy-modified silicone KR-470 (manufactured by Shin-Etsu Chemical Co., Ltd.)

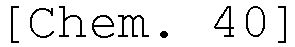

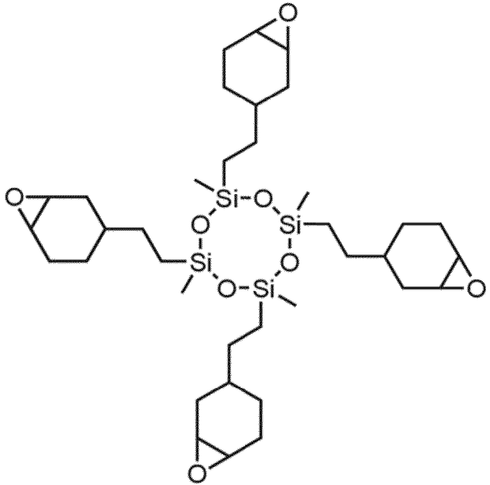

### 1,3-bis[2-(7-oxabicyclo[4.1.0]heptane-3-yl)ethyl]-1,1,3,3-tetramethyldisiloxane

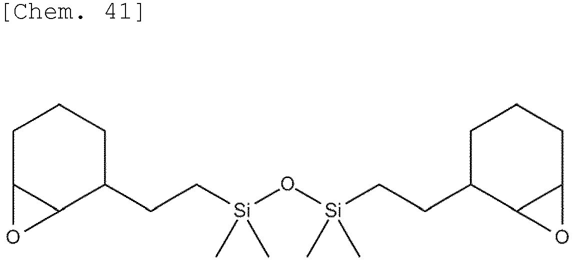

### [A5] Confirmation of Film Removability

### [Example A1-1]

The release agent composition 1 obtained in Preparation Example A3 was spin-coated on a 4 inch bare silicon wafer with a final film thickness of 200 nm, and heated at 250°C for 5 minutes to form a film on the bare silicon wafer. The substrates on which the films were formed were prepared as many as necessary for evaluation.

### [Examples A1-2 to A1-5]

A film was formed on a bare silicon wafer in the same manner as in Example A1 except that the release agent compositions 2 to 5 obtained in Preparation Examples A4 to A7, respectively, were used instead of the release agent composition 1 obtained in Preparation Example A3.

### [Example A1-6]

The release agent composition 6 obtained in Preparation Example A8 was spin-coated on a 4 inch bare silicon wafer with a final film thickness of 200 nm, and heated at 230°C for 30 minutes to form a film on the bare silicon wafer.

### [Example A1-7]

The release agent composition 7 obtained in Preparation Example A9 was spin-coated on a 4 inch bare silicon wafer with a final film thickness of 200 nm, and heated at 250°C for 30 minutes to form a film on the bare silicon wafer.

### [Examples A1-8 to A1-10]

A film was formed on a bare silicon wafer in the same manner as in Example A1 except that the release agent compositions 8 to 10 obtained in Preparation Examples A10 to A12, respectively, were used instead of the release agent composition 1 obtained in Preparation Example A3.

### [Example A1-11]

The release agent composition 11 obtained in Preparation Example A13 was spin-coated on a 4 inch bare silicon wafer with a final film thickness of 300 nm, and heated at 230°C for 5 minutes to form a film on the substrate. The substrates on which the films were formed were prepared as many as necessary.

### [Comparative Examples A1-1 and A1-2]

The release agent compositions 12 and 13 obtained in Comparative Preparation Examples A1 and A2 were respectively spin coated onto a 4 inch bare silicon wafer with a final film thickness of 200 nm and heated at 250°C for 30 minutes to form a film on the bare silicon wafer.

The film thickness of each film obtained in Examples A1-1 to A1-11 and Comparative Examples A1-1 to A1-2 was measured (film thickness before immersion). Then, each film, together with the substrate, was immersed in 7 mL of the cleaning agent composition obtained in Preparation Example A2 for 5 minutes and dried with an air gun, and then the film thickness of each film was measured again (film thickness after immersion). In addition, except that OK73 thinner (composition: 70% propylene glycol monomethyl ether, 30% propylene glycol monomethyl ether acetate) (manufactured by TOKYO OHKA KOGYO CO., LTD.) was used instead of the cleaning agent composition, the same procedure was carried out, and the film thickness was measured. The residual film ratio (%) by immersion was calculated by the following formula. Residual film rate (%) = [film thickness after immersion (nm)/film thickness before immersion (nm)] × 100

The results are shown in Table 1-1 to Table 1-2.

**[Table 1-1]**

| | Example A1-1 | Example A1-2 | Example A1-3 | Example A1-4 | Example A1-5 | Example A1-6 |
|---|---|---|---|---|---|---|
| Release agent composition | 1 | 2 | 3 | 4 | 5 | 6 |
| Cleaning agent composition | 0% | 0% | 0% | 0% | 0% | 0% |
| OK73 thinner | > 80% | > 80% | > 80% | > 80% | > 80% | > 80% |

**[Table 1-2]**

| | Example A1-7 | Example A1-8 | Example A1-9 | Example A1-10 | Example A1-11 | Comparative Example A1-1 | Comparative Example A1-2 |
|---|---|---|---|---|---|---|---|
| Release agent composition | 7 | 8 | 9 | 10 | 11 | 12 | 13 |
| Cleaning agent composition | 0% | 0% | 0% | 0% | 0% | > 80% | > 80% |
| OK73 thinner | > 80% | > 80% | > 80% | > 80% | > 80% | > 80% | > 80% |

### [A6] Manufacturing of Laminate

### [Example A2-1]

The release agent composition 1 obtained in Preparation Example A3 was spin coated on a 300 mm glass wafer (EAGLE-XG, manufactured by Corning Incorporated, thickness: 700 µm) as a substrate on the carrier side, and fired on a hot plate at 250°C for 5 minutes to form a release agent coating layer on the glass wafer as a support substrate such that the film thickness in the finally obtained laminate was 200 nm.

The adhesive composition 1 obtained in Preparation Example A1 was spin coated on a silicon wafer on the device wafer side to form an adhesive coating layer such that the film thickness in the finally obtained laminate was 60 µm.

Then, using a bonding apparatus, the device wafer on which the adhesive coating layer was formed and the support substrate on the carrier side on which the release agent coating layer was formed were bonded to each other to sandwich the adhesive coating layer and the release agent application layer, and then a post-heating treatment at 200°C for 10 minutes was performed to prepare a laminate. In addition, bonding was performed at a temperature of 23°C and a degree of vacuum of 1,500 Pa. Note that laminates were manufactured as many as necessary.

### <Evaluation of Releasability and Cleanability>

A silicon wafer of the obtained laminate was stuck to a dicing tape (DU-300 manufactured by Nitto Denko Corporation) and fixed. A silicon wafer of the laminate fixed with a dicing tape was divided into 4 × 4 cm chips using a dicing machine (manufactured by Tokyo Seimitsu Co., Ltd.) .

Using a laser irradiation device, the release layer was irradiated with a laser having a wavelength of 308 nm at 200 mJ/cm² from the glass wafer side of the diced laminate, and the lowest irradiation amount at which release occurred was defined as the optimum irradiation amount. Then, the entire surface of the release layer was irradiated with a laser having a wavelength of 308 nm at an optimum irradiation amount from the glass wafer side of the diced laminate, and the support substrate was manually lifted to confirm whether or not the release was possible. The case where the film was released was determined as "possible", and the case where the film was not released was determined as "not possible". The results are shown in Table 2-1.

In addition, the diced glass wafer after release was immersed in the cleaning agent composition prepared in Preparation Example A2 for 5 minutes, and the removability (cleanability) of the release agent layer was examined. The glass surface was observed using an optical microscope, and the case where no residue after laser irradiation was observed was determined as "possible", and the case where a residue was observed was determined as "not possible". The results are shown in Table 2-1.

### [Examples A2-2 to A2-5]

A laminate was manufactured in the same manner as in Example A2-1, except that the release agent compositions 2 to 5 obtained in Preparation Example A4 to A7 were used instead of the release agent composition 1 obtained in Preparation Example A3.

Evaluation was performed in the same manner as in Example A2-1. The results are shown in Table 2-1.

### [Example A2-6]

A laminate was manufactured in the same manner as in Example A2-1, except that the release agent composition 6 obtained in Preparation Example A8 was used instead of the release agent composition 1 obtained in Preparation Example A3, and the firing condition after application of the release agent composition was changed to 230°C for 30 minutes.

Evaluation was performed in the same manner as in Example A2-1. The results are shown in Table 2-1.

### [Example A2-7]

A laminate was manufactured in the same manner as in Example A2-1, except that the release agent composition 7 obtained in Preparation Example A9 was used instead of the release agent composition 1 obtained in Preparation Example A3, and the firing condition after application of the release agent composition was changed to 250°C for 30 minutes.

Evaluation was performed in the same manner as in Example A2-1. The results are shown in Table 2-2.

### [Examples A2-8 to A2-10]

A laminate was manufactured in the same manner as in Example A2-1, except that the release agent compositions 8 to 10 obtained in Preparation Example A10 to A12 were used instead of the release agent composition 1 obtained in Preparation Example A3.

Evaluation was performed in the same manner as in Example A2-1. The results are shown in Table 2-2.

### [Example A2-11]

A laminate was manufactured in the same manner as in Example A2-1, except that the release agent composition 11 obtained in Preparation Example A13 was used instead of the release agent composition 1 obtained in Preparation Example A3, and the firing conditions after application of the release agent composition were changed to 230°C and 5 minutes.

Evaluation was performed in the same manner as in Example A2-1. The results are shown in Table 2-2.

### [Comparative Examples A2-1 and A2-2]

A laminate was manufactured in the same manner as in Example A2-1, except that the release agent compositions 12 and 13 obtained in Comparative Preparation Examples A1 and A2 were respectively used instead of the release agent composition 1 obtained in Preparation Example A3, and the firing conditions after application of the release agent composition were changed to 250°C and 30 minutes.

Evaluation was performed in the same manner as in Example A2-1. The results are shown in Table 2-2.

**[Table 2-1]**

| | Example A1-1 | Example A1-2 | Example A1-3 | Example A1-4 | Example A1-5 | Example A1-6 |
|---|---|---|---|---|---|---|
| Release agent composition | 1 | 2 | 3 | 4 | 5 | 6 |
| Possibility of release | Possible | Possible | Possible | Possible | Possible | Possible |
| Possibility of cleaning | Possible | Possible | Possible | Possible | Possible | Possible |

**[Table 2-2]**

| | Example A1-7 | Example A1-8 | Example A1-9 | Example A1-10 | Example A1-11 | Comparative Example A1-1 | Comparative Example A1-2 |
|---|---|---|---|---|---|---|---|
| Release agent composition | 7 | 8 | 9 | 10 | 11 | 12 | 13 |
| Possibility of release | Possible | Possible | Possible | Possible | Possible | Possible | Possible |
| Possibility of cleaning | Possible | Possible | Possible | Possible | Possible | Not possible | Not possible |

### (Second Example)

Hereinafter, examples of the adhesive composition of the present invention will be described as a second example.

### [Apparatus]

(1) Vacuum bonding apparatus: XBS300 manufactured by SÜSS MicroTec SE
(2) Inert gas oven: INL-60NI manufactured by Koyo Thermo Systems Co., Ltd.
(3) Laser irradiation apparatus: Lambda SX manufactured by Coherent, Inc.
(4) Dicing machine: SS30 manufactured by Tokyo Seimitsu Co., Ltd.

### [B1] Preparation of Cleaning Agent Composition

### [Preparation Example B1]

5 g of tetrabutylammonium fluoride trihydrate (manufactured by KANTO CHEMICAL CO., INC.) was mixed with 95 g of N-methyl-2 pyrrolidone, and the mixture was well stirred to obtain a cleaning agent composition.

### [B2] Synthesis of Novolac Resin

### [Synthesis Example B1]

A flask was charged with 7.4 g of tertiary butoxystyrene, 7.38 g of 4-amyloxybenzaldehyde, and 10.0 g of propylene glycol monomethyl ether as a solvent, and the mixture was stirred. After stirring, 10.0 g of N,N'-diphenyl-1,4-phenylenediamine, 1.1 g of methanesulfonic acid, and 31.1 g of propylene glycol monomethyl ether as a solvent were added and heated and stirred at 110°C overnight in a nitrogen atmosphere to obtain a reaction solution. Propylene glycol monomethyl ether acetate and pure water were added to the reaction solution, and the mixture was stirred. Thereafter, liquid separation treatment was performed, and the organic layer was recovered and concentrated to obtain a Novolac resin. As a result of measurement by the following method, the weight average molecular weight of the Novolac resin as a polymer was 1,200.

The weight average molecular weight was measured using a GPC apparatus (EcoSEC, HLC-8220GPC manufactured by Tosoh Corporation) and a GPC column (Shodex KF-803L, KF-802, and KF-801 manufactured by Showa Denko K.K., used in this order), at a column temperature of 40°C, using tetrahydrofuran as an eluent (elution solvent), at a flow rate of 1.00 mL/min, and using polystyrene (manufactured by Sigma-Aldrich) as a standard sample.

The obtained Novolac resin has the following repeating units.

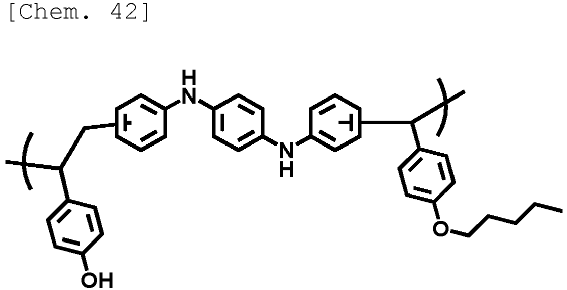

### [Synthesis Example B2]

A flask was charged with 4.2 g of diphenylamine, 7.4 g of 3-hydroxydiphenylamine, 10.4 g of 2-ethylhexylaldehyde, 0.2 g of methanesulfonic acid, and 22.3 g of propylene glycol monomethyl ether acetate as a solvent, and the mixture was heated and stirred at 120°C for 1 hour under a nitrogen atmosphere to obtain a reaction solution. Methanol was added to the reaction solution to dilute. The diluted solution was reprecipitated, and the solvent was distilled off to obtain a Novolac resin. As a result of measurement by the following method, the weight average molecular weight of the Novolac resin as a polymer was 12,000.

The weight average molecular weight was measured using a GPC apparatus (EcoSEC, HLC-8220GPC manufactured by Tosoh Corporation) and a GPC column (Shodex KF-803L, KF-802, and KF-801 manufactured by Showa Denko K.K., used in this order), at a column temperature of 40°C, using tetrahydrofuran as an eluent (elution solvent), at a flow rate of 1.00 mL/min, and using polystyrene (manufactured by Sigma-Aldrich) as a standard sample.

The obtained Novolac resin has the following repeating units.

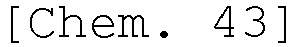

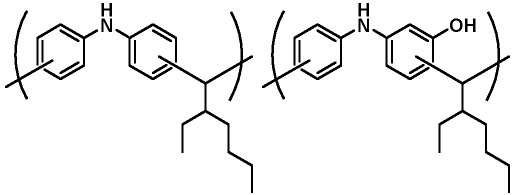

### [B3] Preparation of Adhesive Composition

### [Preparation Example B2]

11.5 g of the Novolac resin obtained in Synthesis Example B1, and 3.5 g of epoxy-modified silicone EP-3400L (manufactured by ADEKA Corporation) as a crosslinking agent were dissolved in 15.0 g of propylene glycol monomethyl ether acetate as a solvent, and the obtained solution was filtered using a polyethylene microfilter having a pore size of 0.2 µm to obtain an adhesive composition 1.

### [Preparation Example B3]

11.5 g of the Novolac resin obtained in Synthesis Example B1, and 3.5 g of epoxy-modified silicone KF-1005 (manufactured by Shin-Etsu Chemical Co., Ltd.) as a crosslinking agent were dissolved in 15.0 g of propylene glycol monomethyl ether acetate as a solvent, and the obtained solution was filtered using a polyethylene microfilter having a pore size of 0.2 µm to obtain an adhesive composition 2.

### [Preparation Example B4]

11.5 g of the Novolac resin obtained in Synthesis Example B1 and 3.5 g of 1,3-bis[2-(7-oxabicyclo[4.1.0]heptane-3-yl)ethyl]-1,1,3,3-tetramethyldisiloxane as a crosslinking agent were dissolved in 15.0 g of propylene glycol monomethyl ether acetate as a solvent, and the obtained solution was filtered using a polyethylene microfilter having a pore size of 0.2 µm to obtain an adhesive composition 3.

### [Preparation Example B5]

11.5 g of the Novolac resin obtained in Synthesis Example B2 and 3.5 g of 1,3-bis[2-(7-oxabicyclo[4.1.0]heptane-3-yl)ethyl]-1,1,3,3-tetramethyldisiloxane as a crosslinking agent were dissolved in 15.0 g of propylene glycol monomethyl ether acetate as a solvent, and the obtained solution was filtered using a polyethylene microfilter having a pore size of 0.2 µm to obtain an adhesive composition 4.

### [Preparation Example B6]

11.5 g of the Novolac resin obtained in Synthesis Example B2, and 3.5 g of epoxy-modified silicone KF-005 (manufactured by Shin-Etsu Chemical Co., Ltd.) as a crosslinking agent were dissolved in 15.0 g of propylene glycol monomethyl ether acetate as a solvent, and the obtained solution was filtered using a polyethylene microfilter having a pore size of 0.2 µm to obtain an adhesive composition 5.

### [Comparative Preparation Example B1]

A 600 mL vessel dedicated to a planetary centrifugal mixer was charged with 80 g of an MQ resin (manufactured by Wacker Chemie GmbH) containing a polysiloxane backbone and a vinyl group, 2.52 g of SiH group-containing linear polydimethylsiloxane (manufactured by Wacker Chemie GmbH) having a viscosity of 100 mPa·s, 5.89 g of SiH group-containing linear polydimethylsiloxane (manufactured by Wacker Chemie GmbH) having a viscosity of 70 mPa·s, and 0.22 g of 1-ethynyl-1-cyclohexanol (manufactured by Wacker Chemie GmbH), followed by stirring with the stirrer for 5 minutes to obtain a mixture (I).

0.147 g of a platinum catalyst (manufactured by Wacker Chemie GmbH) and 5.81 g of vinyl group-containing linear polydimethylsiloxane (manufactured by Wacker Chemie GmbH) having a viscosity of 1,000 mPa·s were stirred with the stirrer for 5 minutes to obtain a mixture (II).

3.96 g of the mixture (II) was added to the total amount of the mixture (I), and the obtained mixture was stirred with a stirrer for 5 minutes to form a mixture (III). Finally, the obtained mixture (III) was filtered through a nylon filter 300 mesh to obtain an adhesive composition 6.

### [B4] Bonding Test

### [Example B1-1]

The adhesive composition 1 obtained in Preparation Example B2 was spin-coated on a 12 inch bare silicon wafer such that the film thickness in the finally obtained laminate was 3 µm to form an adhesive coating layer. Then, using a vacuum bonding apparatus, the device wafer on which the adhesive coating layer was formed and a 12 inch glass wafer (manufactured by Corning Incorporated, thickness: 700 µm) as a support substrate on the carrier side were bonded to sandwich the adhesive coating layer, and then a heating treatment was performed at 250°C for 5 minutes to prepare a laminate. In addition, bonding was performed at a temperature of 23°C and a degree of vacuum of 1,000 Pa. Laminates were prepared as many as necessary for evaluation.

### [Examples B1-2 to B1-5]

A laminate was prepared in the same manner as in Example B1-1, except that the adhesive compositions B2 to B5 obtained in Preparation Examples B3 to B6 was used instead of the adhesive composition 1 obtained in Preparation Example B2. In Examples B1-4 and B1-5, spin coating was performed such that the film thickness in the finally obtained laminate was 15 µm to form an adhesive coating layer, and evaluation was performed.

### [Comparative Example B1-1]

The adhesive composition 6 obtained in Comparative Preparation Example B1 was spin-coated on a 12 inch bare silicon wafer such that the film thickness in the finally obtained laminate was 3 µm to form an adhesive coating layer. Then, a laminate was prepared in the same manner as in Example B1-1 using a vacuum bonding apparatus.

The appearance of the laminates prepared in Examples B1-1 to B1-5 and Comparative Example B1-1 was visually observed to confirm whether voids or delamination occurred. When no void or delamination occurred, it was determined that the bonding of the laminate was good. The results are shown in Table 3.

**[Table 3]**

| | Example B1-1 | Example B1-2 | Example B1-3 | Example B1-4 | Example B1-5 | Comparative Example B1-1 |
|---|---|---|---|---|---|---|
| Adhesive composition | 1 | 2 | 3 | 4 | 5 | 6 |
| Void | None | None | None | None | None | None |
| Delamination | None | None | None | None | None | None |

### [B5] Heat Resistance Test

### [Example B2-1]

The laminate prepared in Example B1-1 was placed in an inert gas oven and subjected to a heat treatment at 260°C for 12 hours.

### [Examples B2-2 to B2-5]

The laminates prepared in Examples B1-2 to B1-5 were placed in an inert gas oven and subjected to a heat treatment under the same conditions as in Example B2-1.

### [Comparative Example B2-1]

The laminate prepared in Comparative Example B1-1 was placed in an inert gas oven and subjected to a heat treatment under the same conditions as in Example B2-1.

The appearance of the laminates subjected to the heat treatment in Examples B2-1 to B2-5 and Comparative Example B2-1 was visually observed to confirm whether voids or delamination occurred, and the heat resistance was evaluated. When no void or delamination occurred, it was determined that the heat resistance was good. The results are shown in Table 4.

**[Table 4]**

| | Example B2-1 | Example B2-2 | Example B2-3 | Example B2-4 | Example B2-5 | Comparative Example B2-1 |
|---|---|---|---|---|---|---|
| Adhesive composition | 1 | 2 | 3 | 4 | 5 | 6 |
| Void | None | None | None | None | None | None |
| Delamination | None | None | None | None | None | None |

### [B6] Evaluation of Releasability

### [Example B3-1]

For the laminate subjected to the post-heat treatment in Example B2-1, using a laser irradiation device, the adhesive layer was irradiated with a laser having a wavelength of 308 nm at 200 mJ/cm² from the glass wafer side, and the lowest irradiation amount at which release occurred was defined as the optimum irradiation amount. Then, the entire surface of the adhesive layer was irradiated with a laser having a wavelength of 308 nm at an optimum irradiation amount from the glass wafer side of the laminate, and the support substrate was manually lifted to confirm whether or not the release was possible. The case where the film was released was determined as "possible", and the case where the film was not released was determined as "not possible". The results are shown in Table 5.

### [Examples B3-2 to B3-5]

Evaluation was performed in the same manner as in Example B3-1 except that the laminates subjected to the post-heat treatment in Examples B2-2 to B2-5 were used. The results are shown in Table 5.

### [Comparative Example B3-1]

Evaluation was performed in the same manner as in Example B3-1 except that the laminates subjected to the post-heat treatment in Comparative Example B2-1 were used. The results are shown in Table 5.

**[Table 5]**

| | Example B3-1 | Example B3-2 | Example B3-3 | Example B3-4 | Example B3-5 | Comparative Example B3-1 |
|---|---|---|---|---|---|---|
| Adhesive composition | 1 | 2 | 3 | 4 | 5 | 6 |
| Possibility of release | Possible | Possible | Possible | Possible | Possible | Not possible |

### [B7] Evaluation of Cleanability

### [Example B4-1]

The 12 inch bare silicon wafer obtained in Example B3-1 was attached to a dicing tape (DU-300 manufactured by Nitto Denko Corporation) and fixed. The silicon wafer fixed with a dicing tape was cut into 4 × 4 cm using a dicing machine to be diced. The diced silicon wafer was immersed in 7 mL of the cleaning agent composition prepared in Preparation Example B1 for 5 minutes and dried with an air gun, and then the removability (cleanability) of the adhesive layer was examined. The silicon wafer was observed using an optical microscope, and the case where no residue after laser irradiation was observed was determined as "possible", and the case where a residue was observed was determined as "not possible". The results are shown in Table 6.

### [Examples B4-2 to B4-5]

Evaluation was performed in the same manner as in Example B4-1 except that the 12 inch bare silicon wafer obtained in Examples B3-2 to B3-5 was used. The results are shown in Table 6. In Comparative Example B3-1, since the adhesive layer could not be released, this evaluation was not performed.

**[Table 6]**

| | Example B4-1 | Example B4-2 | Example B4-3 | Example B4-4 | Example B4-5 |
|---|---|---|---|---|---|
| Adhesive composition | 1 | 2 | 3 | 4 | 5 |
| Possibility of cleaning | Possible | Possible | Possible | Possible | Possible |

### Reference Signs List

- 1: Semiconductor substrate
- 2: Adhesive layer
- 2a: Adhesive coating layer
- 3: Release agent layer
- 4: Support substrate
- 21: Semiconductor chip substrate
- 22: Adhesive layer
- 22': Adhesive coating layer
- 23: Release agent layer
- 24: Support substrate
- 25: Sealing resin
- 26: Electronic device layer
- 27: Release agent layer having adhesive performance
- 28: Wiring layer

## Claims

1. A release agent composition for light irradiation release or an adhesive composition for light irradiation release, comprising:
a Novolac resin having at least one of a hydroxy group directly bonded to an aromatic ring and a carboxy group directly bonded to an aromatic ring;
a siloxane backbone-containing epoxy resin; and
a solvent.

2. The release agent composition or the adhesive composition according to claim 1, wherein the Novolac resin contains at least one of a structural unit represented by Formula (C1-1) below, a structural unit represented by Formula (1-2) below, and a structural unit represented by Formula (C1-3) below, 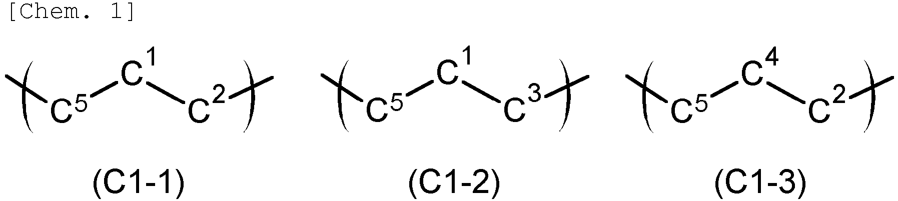
in the formula, C¹ represents a group derived from an aromatic compound containing a nitrogen atom,
C² represents a group containing a tertiary carbon atom or a quaternary carbon atom having at least one selected from the group consisting of a secondary carbon atom, a quaternary carbon atom, and an aromatic ring in a side chain, or represents a methylene group,
C³ represents a group derived from an aliphatic polycyclic compound,
C⁴ represents a group derived from phenol, a group derived from bisphenol, a group derived from naphthol, a group derived from biphenyl, or a group derived from biphenol,
C⁵ represents a single bond or a group having a structure derived from styrene,
in Formula (C1-1), at least one of C¹, C², and C⁵ has at least one of a hydroxy group directly bonded to an aromatic ring and a carboxy group directly bonded to an aromatic ring,
in Formula (C1-2), at least one of C¹, C³, and C⁵ has at least one of a hydroxy group directly bonded to an aromatic ring and a carboxy group directly bonded to an aromatic ring, and
in Formula (C1-3), at least one of C², C⁴, and C⁵ has at least one of a hydroxy group directly bonded to an aromatic ring and a carboxy group directly bonded to an aromatic ring.

3. The release agent composition or the adhesive composition according to claim 2, wherein the Novolac resin contains, as the structural unit represented by the Formula (C1-1), at least one of a structural unit represented by Formula (C1-1-1) below and a structural unit represented by Formula (C1-1-2) below, 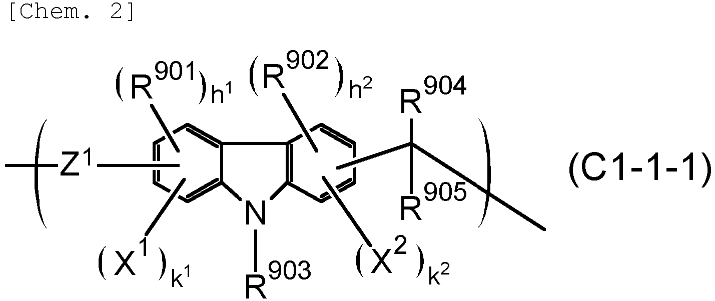 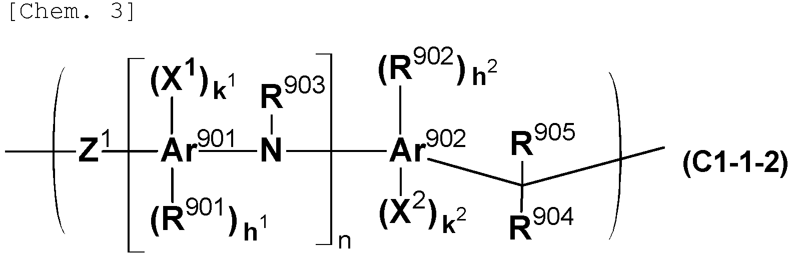
in Formulas (C1-1-1) and (C1-1-2), R⁹⁰¹ and R⁹⁰² represent a substituent substituted with a ring, and each independently represent a halogen atom, a nitro group, a cyano group, an amino group, an optionally substituted alkyl group, an optionally substituted alkenyl group, or an optionally substituted aryl group,
R⁹⁰³ represents a hydrogen atom, an optionally substituted alkyl group, an optionally substituted alkenyl group, or an optionally substituted aryl group,
R⁹⁰⁴ represents a hydrogen atom, an optionally substituted aryl group, or an optionally substituted heteroaryl group,
R⁹⁰⁵ represents an optionally substituted alkyl group, an optionally substituted aryl group, or an optionally substituted heteroaryl group,
the group of R⁹⁰⁴ and the group of R⁹⁰⁵ may be bonded to each other to form a divalent group,
Ar⁹⁰¹ and Ar⁹⁰² each independently represent an aromatic ring,
X¹ and X² each independently represent a hydroxy group or a carboxy group,
Z¹ represents a single bond or a group having a structure derived from styrene,
h¹ and h² each independently represent an integer of 0 to 3,
k¹ and k² each independently represent an integer of 0 to 3,
the sum of h¹ and k¹ is 3 or less, and the sum of h² and k² is 3 or less,
n represents an integer of 1 or 2, and
here, the structural unit represented by Formula (C1-1-1) and the structural unit represented by Formula (C1-1-2) each independently have at least one of a hydroxy group directly bonded to an aromatic ring and a carboxy group directly bonded to an aromatic ring.

4. The release agent composition or the adhesive composition according to claim 2, wherein the Novolac resin contains a structural unit represented by Formula (C1-3-1) below as the structural unit represented by the Formula (C1-3), 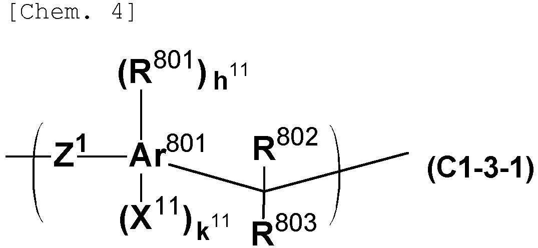
in Formula (C1-3-1), R⁸⁰¹ represents a substituent substituted with a ring, and each independently represents a halogen atom, a nitro group, a cyano group, an amino group, an optionally substituted alkyl group, an optionally substituted alkenyl group, or an optionally substituted aryl group,
R⁸⁰² represents a hydrogen atom, an optionally substituted aryl group, or an optionally substituted heteroaryl group,
R⁸⁰³ represents a hydrogen atom, an optionally substituted alkyl group, an optionally substituted aryl group, or an optionally substituted heteroaryl group,
the group of R⁸⁰² and the group of R⁸⁰³ may be bonded to each other to form a divalent group,
Ar⁸⁰¹ represents a benzene ring, a naphthalene ring, or a biphenyl structure,
X¹¹ represents a hydroxy group or a carboxy group,
Z¹ represents a single bond or a group having a structure derived from styrene,
h¹¹ each independently represents an integer of 0 to 4,
k¹¹ each independently represents an integer of 0 to 4,
when Ar⁸⁰¹ is a benzene ring, the sum of h¹¹ and k¹¹ is 4 or less, when Ar⁸⁰¹ is a naphthalene ring, the sum of h¹¹ and k¹¹ is 6 or less, and when Ar⁸⁰¹ has a biphenyl structure, the sum of h¹¹ and k¹¹ is 8 or less, and
here, the structural unit represented by Formula (C1-3-1) has at least one of a hydroxy group directly bonded to an aromatic ring and a carboxy group directly bonded to an aromatic ring.

5. The release agent composition or the adhesive composition according to claim 1, wherein the siloxane backbone-containing epoxy resin has a structure represented by Formula (A) below, 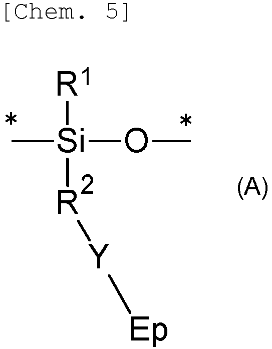 in Formula (A), R¹ represents a substituted or unsubstituted alkyl group, a substituted or unsubstituted alkenyl group, or a substituted or unsubstituted aryl group, R² represents an alkylene group having 1 to 10 carbon atoms, Y represents a single bond or -O-, Ep represents a group represented by Formula (A-1) or (A-2) below, and * represents a bond, and 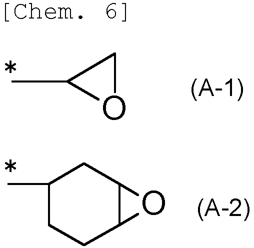 in Formula (A-1) and Formula (A-2), * represents a bond.

6. The release agent composition or the adhesive composition according to claim 1, wherein the siloxane backbone-containing epoxy resin is represented by any one of Formulas (SE1) to (SE3) below, 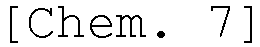 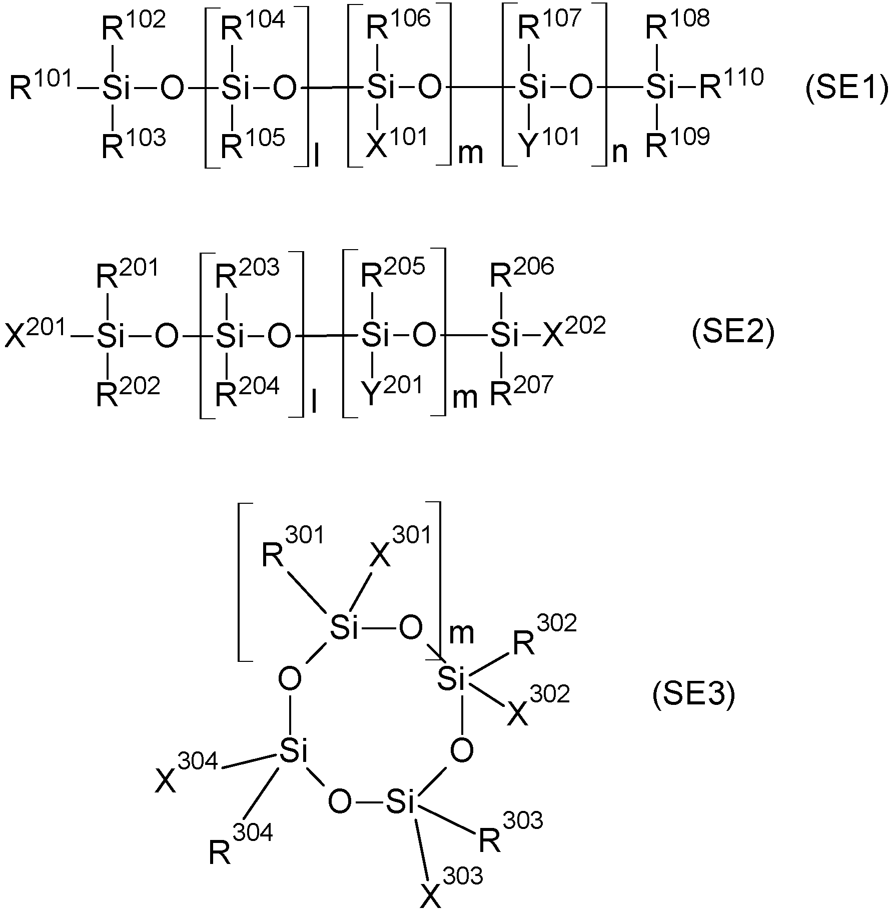
in Formula (SE1), R¹⁰¹ to R¹¹⁰ each independently represent a substituted or unsubstituted alkyl group, a substituted or unsubstituted alkenyl group, or a substituted or unsubstituted aryl group, X¹⁰¹ represents a group represented by Formula (EA) below, Y¹⁰¹ represents a hydrogen atom, a hydroxy group, or a monovalent group having 1 to 30 carbon atoms (here, Y¹⁰¹ is different from X¹⁰¹), l represents 0 or an integer of 1 or more, m represents an integer of 1 or more, and n represents 0 or an integer of 1 or more,
in Formula (SE2), R²⁰¹ to R²⁰⁷ each independently represent a substituted or unsubstituted alkyl group, a substituted or unsubstituted alkenyl group, or a substituted or unsubstituted aryl group, X²⁰¹ and X²⁰² each independently represent a group represented by Formula (EA) below, Y²⁰¹ represents a hydrogen atom, a hydroxy group, or a monovalent group having 1 to 30 carbon atoms, l represents 0 or an integer of 1 or more, and m represents 0 or an integer of 1 or more,
in Formula (SE3), R³⁰¹ to R³⁰⁴ each independently represent a substituted or unsubstituted alkyl group, a substituted or unsubstituted alkenyl group, or a substituted or unsubstituted aryl group, X³⁰¹ to X³⁰⁴ each independently represent a group represented by Formula (EA) below, and m represents an integer of 1 to 3, 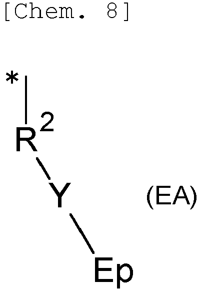
in Formula (EA), R² represents an alkylene group having 1 to 10 carbon atoms, Y represents a single bond or -O-, Ep represents a group represented by Formula (A-1) or (A-2) below, and * represents a bond, and 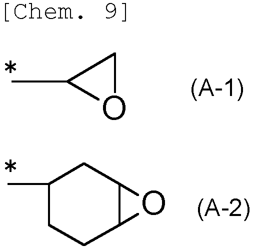
in Formula (A-1) and Formula (A-2), * represents a bond.

7. The release agent composition or the adhesive composition according to claim 1, wherein a content of the siloxane backbone-containing epoxy resin is 5% by mass to 40% by mass with respect to the Novolac resin.

8. A laminate comprising:
a semiconductor substrate or an electronic device layer;
a light-transmissive support substrate; and
a release agent layer provided between the semiconductor substrate or the electronic device layer and the support substrate, wherein
the release agent layer is a release agent layer formed from the release agent composition according to any one of claims 1 to 7.

9. The laminate according to claim 8, comprising an adhesive layer provided between the semiconductor substrate or the electronic device layer and the support substrate.

10. A method for manufacturing a processed semiconductor substrate or electronic device layer, the method comprising:
Step 5A of processing the semiconductor substrate of the laminate according to claim 8, or Step 5B of processing the electronic device layer of the laminate according to claim 8; and
Step 6A of separating the semiconductor substrate processed in the Step 5A and the support substrate from each other, or Step 6B of separating the electronic device layer processed in the Step 5B and the support substrate from each other.

11. The method for manufacturing the processed semiconductor substrate or electronic device layer according to claim 10, wherein the Step 6A or the Step 6B includes a step of irradiating the laminate with a laser from the support substrate side.

12. A laminate comprising:
a semiconductor substrate or an electronic device layer;
a light-transmissive support substrate; and
an adhesive layer provided between the semiconductor substrate or the electronic device layer and the support substrate, wherein
the adhesive layer is an adhesive layer formed from the adhesive composition according to any one of claims 1 to 7.

13. A method for manufacturing a processed semiconductor substrate or electronic device layer, the method comprising:
Step 5A of processing the semiconductor substrate of the laminate according to claim 12, or Step 5B of processing the electronic device layer of the laminate according to claim 12; and
Step 6A of separating the semiconductor substrate processed in the Step 5A and the support substrate from each other, or Step 6B of separating the electronic device layer processed in the Step 5B and the support substrate from each other.

14. The method for manufacturing the processed semiconductor substrate or electronic device layer according to claim 13, wherein the Step 6A or the Step 6B includes a step of irradiating the laminate with a laser from the support substrate side.
